# EUROPEAN PATENT SPECIFICATION

(11) **EP 4 395 499 B1**
(45) Date of publication and mention of the grant of the patent: **09.12.2026**
(21) Application number: 23218966.2
(22) Date of filing: 21.12.2023
(51) Int. Cl.: H10K 50/12, H10K 50/13, H10K 85/30

(54) **LIGHT-EMITTING DEVICE AND ELECTRONIC APPARATUS INCLUDING THE SAME**
LICHTEMITTIERENDE VORRICHTUNG UND ELEKTRONISCHE VORRICHTUNG DAMIT
DISPOSITIF ÉLECTROLUMINESCENT ET APPAREIL ÉLECTRONIQUE LE COMPRENANT

(30) Priority: 29.12.2022 KR 20220189755
(43) Date of publication of application: 03.07.2024
(73) Proprietor: Samsung Display Co., Ltd., Yongin-si, Gyeonggi-do 17113 (KR)
(72) Inventor: LEE, Sunghun, 16678 Suwon-si (KR); KIM, Taekjung, 16678 Suwon-si (KR); KIM, Hyungjun, 16678 Suwon-si (KR); LEE, Banglin, 16678 Suwon-si (KR); ISHIHARA, Shingo, 16678 Suwon-si (KR); LEE, Yong Joo, 16678 Suwon-si (KR); KOISHIKAWA, Yasushi, 16678 Suwon-si (KR); HONG, Youngki, 16678 Suwon-si (KR)
(74) Representative: Elkington and Fife LLP

(56) References cited:
- EP-A1- 4 203 661
- US-A1- 2013 277 654

## Description

### FIELD OF THE INVENTION

One or more embodiments relate to a light-emitting device and an electronic apparatus including the same.

### BACKGROUND OF THE INVENTION

Organic light-emitting devices are self-emissive devices that may have improved characteristics in terms of viewing angles, response time, luminance, driving voltage, and response speed, and provide full-color images. An organic light-emitting device includes an anode, a cathode, and an organic layer arranged between the anode and the cathode, wherein the organic layer includes an emission layer. A hole transport region may be arranged between the anode and the emission layer, and an electron transport region may be arranged between the emission layer and the cathode. Holes provided from the anode move toward the emission layer through the hole transport region, and electrons provided from the cathode move toward the emission layer through the electron transport region. The holes and the electrons recombine in the emission layer to produce excitons. The excitons may transition from an excited state to a ground state resulting in light emission. US 2013/277654 A1 discloses an organic light-emitting device comprising two light emission layers comprising different hosts and dopants.

### SUMMARY OF THE INVENTION

One or more embodiments include a light-emitting device having improved low gradation image quality characteristics and lateral luminance, and at the same time, having excellent characteristics in terms of luminescence efficiency, lifespan, and/or roll-off ratio, and an electronic apparatus including the same.

Additional aspects will be set forth in part in the description which follows and, in part, will be apparent from the description, or may be learned by practice of the presented embodiments of the disclosure.

According to one or more embodiments, a light-emitting device includes
a first electrode, a second electrode facing the first electrode, and an interlayer arranged between the first electrode and the second electrode,
wherein the interlayer includes a first emission layer and a second emission layer,
the first emission layer includes a first host and a first dopant capable of emitting a first light having a first photoluminescence spectrum,
the first host includes m1 hosts, where m1 is an integer of 1 or more, and when m1 is 2 or more, the two or more hosts present in the first emission layer are each different from the other,
the second emission layer includes a second host and a second dopant capable of emitting second light having a second photoluminescence spectrum,
the second host includes m2 hosts, where m2 is an integer of 1 or more, and when m2 is 2 or more, the two or more hosts present in the second emission layer are each different from the other,
the first dopant includes a first transition metal, and the second dopant includes a second transition metal,
wherein the first dopant and the second dopant are different from each other, and Expression 1 and Expression 2 are satisfied. $PDM \left(D1\right) < PDM \left(D2\right)$ Expression 1 $PDM \left(H1\right) > PDM \left(H2\right)$ Expression 2

In Expressions 1 and 2,
PDM(D1) is a permanent dipole moment of the first dopant and has a unit of debye,
PDM(D2) is a permanent dipole moment of the second dopant and has a unit of debye,
PDM(H1) is ${\sum }_{x = 1}^{m 1} PDM \left(Hx\right) ⋅ W \left(Hx\right)$ which is a permanent dipole moment average value of the m1 hosts present in the first host, and has a unit of debye, wherein i) x is a variable of 1 to m1, ii) PDM(Hx) is a permanent dipole moment of an x^{th} host in the first emission layer and has a unit of debye, and iii) W(Hx) is a weight fraction of the x^{th} host relative to a total weight of the first host, and is calculated as (a weight of the x^{th} host in the first emission layer / a total weight of the first host),
PDM(H2) is ${\sum }_{y = 1}^{m 2} PDM \left(Hy\right) ⋅ W \left(Hy\right)$ which is a permanent dipole moment average value of the m2 hosts present in the second host, and has a unit of debye, wherein i) y is a variable of 1 to m2, ii) PDM(Hy) is a permanent dipole moment of an y^{th} host in the second emission layer and has a unit of debye, and iii) W(Hy) is a weight fraction of the y^{th} host relative to a total weight of the second host, and is calculated as (a weight of the y^{th} host in the second emission layer / a total weight of the second host), and
each of PDM(D1), PDM(D2), PDM(Hx), and PDM(Hy) is calculated based on density functional theory (DFT).

According to one or more embodiments, there is provided an electronic apparatus including the light-emitting device.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a schematic view of a light-emitting device according to an embodiment;
FIG. 2 is a schematic view of a light-emitting device according to another embodiment;
FIG. 3 shows a graph of x color coordinates versus luminescence efficiency of each of OLED 1 to OLED 4; and
FIG. 4 shows a graph of time versus luminance of each of OLED 1 to OLED 4.

### DETAILED DESCRIPTION OF THE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects.

As used herein, the singular forms "a," "an," and "the" are intended to include the plural forms, including "at least one," unless the content clearly indicates otherwise. "At least one" is not to be construed as limiting "a" or "an." "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

It will be understood that when an element is referred to as being "on" another element, it can be directly on the other element or intervening elements may be present therebetween. In contrast, when an element is referred to as being "directly on" another element, there are no intervening elements present.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ±10% or ±5% of the stated value.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

A light-emitting device according to an embodiment of the disclosure may include a first electrode, a second electrode facing the first electrode, and an interlayer arranged between the first electrode and the second electrode. The interlayer may include a first emission layer and a second emission layer.

The first emission layer and the second emission layer may be stacked from the first electrode in the order of the first emission layer and the second emission layer or in the order of the second emission layer and the first emission layer.

A surface of the first emission layer and a surface of the second emission layer may be in direct contact with each other. Alternatively, another layer may be additionally arranged between the first emission layer and the second emission layer.

The first emission layer may include a first host and a first dopant capable of emitting a first light having a first photoluminescence spectrum. In this regard, the first host may include m1 hosts, and m1 is an integer of 1 or more. When m1 is 2 or more, the two or more hosts in the first emission layer are each different from the other. For example, when m1 is 2 or more, the first host in the first emission layer is a mixture of different hosts.

A weight of the first host in the first emission layer is greater than a weight of the first dopant. For example, a weight of the first host in the first emission layer may be 60 weight percent (wt%) to 99 wt%, 70 wt% to 97 wt%, or 80 wt% to 96 wt%, based on 100 wt% of the first emission layer.

The second emission layer may include a second host and a second dopant capable of emitting a second light having a second photoluminescence spectrum. In this regard, the second host may include m2 hosts, and m2 may be an integer of 1 or more. When m2 is 2 or more, two or more hosts in the second emission layer are each different from the other. For example, when m2 is 2 or more, the second host in the second emission layer may be a mixture of different hosts.

A weight of the second host in the second emission layer is greater than a weight of the second dopant. For example, a weight of the second host in the second emission layer may be 60 wt% to 99 wt%, 70 wt% to 97 wt%, or 80 wt% to 96 wt%, based on 100 wt% of the second emission layer.

For example, m1 and m2 may each independently be 1, 2, 3, or 4.

In an embodiment, m1 and m2 may each independently be 1 or 2.

When m1 is 2, a weight ratio of two different hosts present in the first emission layer may be 1:9 to 9:1, 2:8 to 8:2, 3:7 to 7:3, or 4:6 to 6:4. Meanwhile, when m2 is 2, a weight ratio of two different hosts present in the second emission layer may be 1:9 to 9:1, 2:8 to 8:2, 3:7 to 7:3, or 4:6 to 6:4. When the weight ratio is satisfied, movement or the transport of holes and electrons in the first emission layer and the second emission layer may be more efficient.

The first dopant may include a first transition metal, and the second dopant may include a second transition metal. For example, the first dopant may be a first transition metal-containing organometallic compound, and the second dopant may be a second transition metal-containing organometallic compound.

The first transition metal and the second transition metal may each independently be iridium, platinum, osmium, rhenium, gold, or palladium.

For example, the first dopant and the second dopant may be different from each other.

In an embodiment, the first transition metal and the second transition metal may be different from each other.

In an embodiment, one of the first transition metal or the second transition metal may be iridium, and the other may be platinum.

In an embodiment, the first transition metal and the second transition metal may be the same, though the first dopant and the second dopant are different from each other.

The light-emitting device may satisfy Expression 1 and Expression 2: $PDM \left(D1\right) < PDM \left(D2\right)$ Expression 1 $PDM \left(H1\right) > PDM \left(H2\right)$ Expression 2 wherein, in Expression 1,
PDM(D1) is a permanent dipole moment of the first dopant and has a unit of debye.
PDM(D2) is a permanent dipole moment of the second dopant and has a unit of debye.
PDM(H1) in Expression 2 is ${\sum }_{x = 1}^{m 1} PDM \left(Hx\right) ⋅ W \left(Hx\right)$ which is a permanent dipole moment average value of the m1 hosts present in the first host, and has a unit of debye. In this regard, i) x is a variable of 1 to m1, ii) PDM(Hx) is a permanent dipole moment of an x^{th} host in the first emission layer and has a unit of debye, and iii) W(Hx) is a weight fraction of the x^{th} host relative to a total weight of the first host, and may be calculated as (a weight of the x^{th} host in the first emission layer / a total weight of the first host).

For example, in the emission layer, when m1 is 1, the first host in the first emission layer includes one Host A, and PDM(H1) is equal to a permanent dipole moment value of Host A.

As another example, in the emission layer, when m1 is 2, the first host in the first emission layer includes two different hosts (for example, a mixture of the two different hosts). For example, in the emission layer, when m1 is 2 and the first host in the first emission layer includes Host A and Host B, which are different from each other, PDM(H1) may be calculated as PDM(Host A)·W(Host A) + PDM(Host B)·W(Host B), that is, "(permanent dipole moment of Host A x weight fraction of Host A) + (permanent dipole moment of Host B x weight fraction of Host B)". In this regard, when the first host includes Host A and Host B in a weight ratio of 7:3, PDM(H1) may be calculated as "PDM(Host A) x 0.7 + PDM(Host B) x 0.3".

In Expression 2, PDM(H2) is ${\sum }_{y = 1}^{m 2} PDM \left(Hy\right) ⋅ W \left(Hy\right)$ which is a permanent dipole moment average value of the m2 hosts present in the second host, and has a unit of debye, wherein i) y is a variable of 1 to m2, ii) PDM(Hy) is a permanent dipole moment of an y^{th} host in the second emission layer and has a unit of debye, and iii) W(Hy) is a weight fraction of the y^{th} host relative to a total weight of the second host, and may be calculated as (a weight of the y^{th} host in the second emission layer / a total weight of the second host).

PDM(H2) is the same as described in connection with PDM(H1).

Each of PDM(D1), PDM(D2), PDM(Hx), and PDM(Hy) is calculated based on the density functional theory (DFT). Any various programs may be used for quantum mechanical calculation based on the DFT, and for example, a Gaussian 16 program may be used.

### |A| indicates an absolute value of "A".

In an embodiment, |PDM(D1) - PDM(D2)| of the light-emitting device may be about 1.0 debye to about 9.0 debye, about 3.0 debye to about 6.0 debye, about 3.5 debye to about 6.0 debye, about 4.0 debye to about 6.0 debye, about 3.5 debye to about 5.5 debye, about 4.0 debye to about 5.5 debye, about 3.5 debye to about 5.0 debye, about 4.0 debye to about 5.0 debye, about 3.5 debye to about 4.5 debye, or about 4.0 debye to about 4.5 debye.

In an embodiment, PDM(D1) may be about 0.1 debye to about 4 debye, about 0.5 debye to about 4.0 debye, about 1.0 debye to about 4.0 debye, about 1.5 debye to about 4.0 debye, about 0.5 debye to about 3.5 debye, about 1.0 debye to about 3.5 debye, about 1.5 debye to about 3.5 debye, about 0.5 debye to about 3.0 debye, about 1.0 debye to about 3.0 debye, about 1.5 debye to about 3.0 debye, about 0.5 debye to about 2.5 debye, about 1.0 debye to about 2.5 debye, about 1.5 debye to about 2.5 debye, about 0.5 debye to about 2.0 debye, about 1.0 debye to about 2.0 debye, or about 1.5 debye to about 2.0 debye.

In an embodiment, PDM(D2) may be about 3.0 debye to about 10.0 debye, about 4.0 debye to about 9.0 debye, about 4.5 debye to about 9.0 debye, about 5.0 debye to about 9.0 debye, about 5.5 debye to about 9.0 debye, about 4.0 debye to about 8.5 debye, about 4.5 debye to about 8.5 debye, about 5.0 debye to about 8.5 debye, about 5.5 debye to about 8.5 debye, about 4.0 debye to about 8.0 debye, about 4.5 debye to about 8.0 debye, about 5.0 debye to about 8.0 debye, about 5.5 debye to about 8.0 debye, about 4.0 debye to about 7.5 debye, about 4.5 debye to about 7.5 debye, about 5.0 debye to about 7.5 debye, about 5.5 debye to about 7.5 debye, about 4.0 debye to about 7.0 debye, about 4.5 debye to about 7.0 debye, about 5.0 debye to about 7.0 debye, about 5.5 debye to about 7.0 debye, about 4.0 debye to about 6.5 debye, about 4.5 debye to about 6.5 debye, about 5.0 debye to about 6.5 debye, or about 5.5 debye to about 6.5 debye.

In an embodiment, |PDM(H1) - PDM(H2)| of the light-emitting device may be about 0.01 debye to about 3.99 debye, about 0.01 debye to about 3.50 debye, about 0.01 debye to about 3.00 debye, about 0.01 debye to about 2.50 debye, about 0.01 debye to about 2.00 debye, about 0.01 debye to about 1.50 debye, about 0.05 debye to about 3.99 debye, about 0.05 debye to about 3.50 debye, about 0.05 debye to about 3.00 debye, about 0.05 debye to about 2.50 debye, about 0.05 debye to about 2.00 debye, about 0.05 debye to about 1.50 debye, about 0.1 debye to about 3.99 debye, about 0.1 debye to about 3.50 debye, about 0.1 debye to about 3.00 debye, about 0.1 debye to about 2.50 debye, about 0.1 debye to about 2.00 debye, or about 0.1 debye to about 1.50 debye.

In an embodiment, PDM(H1) may be about 0.5 debye to about 4.0 debye, about 0.5 debye to about 3.5 debye, about 0.5 debye to about 3.0 debye, about 0.5 debye to about 2.5 debye, about 0.5 debye to about 2.0 debye, about 1.0 debye to about 4.0 debye, about 1.0 debye to about 3.5 debye, about 1.0 debye to about 3.0 debye, about 1.0 debye to about 2.5 debye, or about 1.0 debye to about 2.0 debye.

In an embodiment, PDM(H2) may be about 0.01 debye to about 3.00 debye, about 0.01 debye to about 2.50 debye, about 0.01 debye to about 2.00 debye, about 0.01 debye to about 1.50 debye, about 0.1 debye to about 3.00 debye, about 0.1 debye to about 2.50 debye, about 0.1 debye to about 2.00 debye, about 0.1 debye to about 1.50 debye, about 1.0 debye to about 3.00 debye, about 1.0 debye to about 2.50 debye, about 1.0 debye to about 2.00 debye, or about 1.0 debye to about 1.50 debye.

In an embodiment, the light-emitting device may further satisfy Expression 3: $FWHM \left(D1\right) > DWHM \left(D2\right)$ Expression 3 wherein, in Expression 3,
FWHM(D1) is a full width at half maximum of the first photoluminescence spectrum of the first dopant and has a unit of nanometers (nm),
FWHM(D2) is a full width at half maximum of the second photoluminescence spectrum of the second dopant and has a unit of nm,
the first photoluminescence spectrum is evaluated relative to a first film including the first dopant, and
the second photoluminescence spectrum is evaluated relative to a second film including the second dopant.

In the present specification, the "first film" is a film including the first dopant, and the "second film" is a film including the second dopant. The first film and the second film may be manufactured using various methods, such as a vacuum deposition method, a coating method, and a heating method. The first film and the second film may further include other compounds, for example, a host described in the present specification, in addition to the first dopant and the second dopant. For example, a method of evaluating FWHM(D1) and FWHM(D2) is described with reference to the following Evaluation Example.

In an embodiment, |FWHM(D1) - FWHM(D2)| of the light-emitting device may be 50 nm or less, about 0.1 nm to about 50 nm, about 0.1 nm to about 45 nm, about 0.1 nm to about 40 nm, about 1 nm to about 50 nm, about 1 nm to about 45 nm, about 1 nm to about 40 nm, about 5 nm to about 50 nm, about 5 nm to about 45 nm, about 5 nm to about 40 nm, about 10 nm to about 50 nm, about 10 nm to about 45 nm, or about 10 nm to about 40 nm.

In an embodiment, FWHM(D1) may be about 30 nm to about 100 nm, about 30 nm to about 90 nm, about 30 nm to about 80 nm, about 30 nm to about 70 nm, about 40 nm to about 100 nm, about 40 nm to about 90 nm, about 40 nm to about 80 nm, about 40 nm to about 70 nm, about 50 nm to about 100 nm, about 50 nm to about 90 nm, about 50 nm to about 80 nm, or about 50 nm to about 70 nm.

In an embodiment, FWHM(D2) may be about 10 nm to about 60 nm, about 10 nm to about 50 nm, about 10 nm to about 40 nm, about 15 nm to about 60 nm, about 15 nm to about 50 nm, about 15 nm to about 40 nm, about 20 nm to about 60 nm, about 20 nm to about 50 nm, about 20 nm to about 40 nm, about 25 nm to about 60 nm, about 25 nm to about 50 nm, or about 25 nm to about 40 nm.

Meanwhile, the light-emitting device may further satisfy Expression 4: ${D}_{st} \left(D1\right) < {D}_{st} \left(D2\right)$ Expression 4 wherein, in Expression 4,
Dₛₜ(D1) is |S₁(D1) - T₁(D1)|,
Dₛₜ(D2) is |S₁(D2) - T₁(D2)|,
S₁(D1) is singlet energy of the first dopant and has a unit of eV,
T₁(D1) is triplet energy of the first dopant and has a unit of eV,
S₁(D2) is singlet energy of the second dopant and has a unit of eV,
T₁(D2) is triplet energy of the second dopant and has a unit of eV, and each of S₁(D1), T₁(D1), S₁(D2), and T₁(D2) is calculated based on the DFT.

In an embodiment, |Dₛₜ(D1) - Dₛₜ(D2)| may be about 0.1 eV to about 0.5 eV, about 0.1 eV to about 0.4 eV, about 0.1 eV to about 0.3 eV, about 0.2 eV to about 0.5 eV, about 0.2 eV to about 0.4 eV, or about 0.2 eV to about 0.3 eV.

In an embodiment, Dₛₜ(D1) may be about 0.05 eV to about 0.30 eV, about 0.05 eV to about 0.25 eV, about 0.05 eV to about 0.20 eV, about 0.05 eV to about 0.15 eV, about 0.10 eV to about 0.30 eV, about 0.10 eV to about 0.25 eV, about 0.10 eV to about 0.20 eV, or about 0.10 eV to about 0.15 eV.

In an embodiment, Dₛₜ(D2) may be about 0.2 eV to about 0.6 eV, about 0.2 eV to about 0.5 eV, about 0.2 eV to about 0.4 eV, about 0.3 eV to about 0.6 eV, about 0.3 eV to about 0.5 eV, or about 0.3 eV to about 0.4 eV.

|λmax(1) - λmax(2)| of the light-emitting device may be 0 nm to about 30 nm. In this regard, λmax(1) is a maximum emission peak wavelength of the first photoluminescence spectrum and has a unit of nm, and λmax(2) is a maximum emission peak wavelength of the second photoluminescence spectrum and has a unit of nm.

In an embodiment, |λmax(1) - λmax(2)| may be 0 nm to about 25 nm, about 0.5 nm to about 25 nm, about 1 nm to about 25 nm, 0 nm to about 20 nm, about 0.5 nm to about 20 nm, about 1 nm to about 20 nm, 0 nm to about 15 nm, about 0.5 nm to about 15 nm, about 1 nm to about 15 nm, 0 nm to about 10 nm, 0 nm to about 8 nm, 0 nm to about 6 nm, 0 nm to about 4 nm, 0 nm to about 2 nm, about 0.5 nm to about 10 nm, about 0.5 nm to about 8 nm, about 0.5 nm to about 6 nm, about 0.5 nm to about 4 nm, about 0.5 nm to about 2 nm, about 1 nm to about 10 nm, about 1 nm to about 8 nm, about 1 nm to about 6 nm, about 1 nm to about 4 nm, or about 1 nm to about 2 nm.

In an embodiment, each of λmax(1) and λmax(2) may be about 510 nm to about 540 nm, about 510 nm to about 535 nm, about 510 nm to about 530 nm, about 515 nm to about 540 nm, about 515 nm to about 535 nm, about 515 nm to about 530 nm, about 520 nm to about 540 nm, about 520 nm to about 535 nm, or about 520 nm to about 530 nm.

In an embodiment, each of λmax(1) and λmax(2) may be about 540 nm to about 570 nm, about 540 nm to about 565 nm, about 540 nm to about 560 nm, about 540 nm to about 555 nm, about 545 nm to about 570 nm, about 545 nm to about 565 nm, about 545 nm to about 560 nm, about 545 nm to about 555 nm, about 550 nm to about 570 nm, about 550 nm to about 565 nm, about 550 nm to about 560 nm, or about 550 nm to about 555 nm.

In an embodiment, λmax(1) may be about 510 nm to about 540 nm, about 510 nm to about 535 nm, about 510 nm to about 530 nm, about 515 nm to about 540 nm, about 515 nm to about 535 nm, about 515 nm to about 530 nm, about 520 nm to about 540 nm, about 520 nm to about 535 nm, or about 520 nm to about 530 nm, and λmax(2) may be 540 nm to about 570 nm, about 540 nm to about 565 nm, about 540 nm to about 560 nm, about 540 nm to about 555 nm, about 545 nm to about 570 nm, about 545 nm to about 565 nm, about 545 nm to about 560 nm, about 545 nm to about 555 nm, about 550 nm to about 570 nm, about 550 nm to about 565 nm, about 550 nm to about 560 nm, or about 550 nm to about 555 nm.

In an embodiment, λmax(1) may be about 540 nm to about 570 nm, about 540 nm to about 565 nm, about 540 nm to about 560 nm, about 540 nm to about 555 nm, about 545 nm to about 570 nm, about 545 nm to about 565 nm, about 545 nm to about 560 nm, about 545 nm to about 555 nm, about 550 nm to about 570 nm, about 550 nm to about 565 nm, about 550 nm to about 560 nm, or about 550 nm to about 555 nm, and λmax(2) may be about 510 nm to about 540 nm, about 510 nm to about 535 nm, about 510 nm to about 530 nm, about 515 nm to about 540 nm, about 515 nm to about 535 nm, about 515 nm to about 530 nm, about 520 nm to about 540 nm, about 520 nm to about 535 nm, or about 520 nm to about 530 nm.

In an embodiment, each of the first light and the second light may be yellow-green light, green light, or blue-green light.

In an embodiment, each of the first light and the second light may be green light.

In an embodiment, each of the first emission layer and the second emission layer may emit yellow-green light, green light, or blue-green light.

In an embodiment, each of the first emission layer and the second emission layer may emit green light.

In an embodiment, the light-emitting device may not emit white light.

The light-emitting device includes a first emission layer including a first dopant and a second emission layer including a second dopant, and the first dopant and the second dopant are different from each other. In other words, the light-emitting device includes the first and second dopants having different photoluminescence spectra. When the light-emitting device simultaneously satisfies Expression 1 and Expression 2, the relation symbol between the permanent dipole moments of the first and second dopants and the relation symbol between the permanent dipole moments of the first host in the first emission layer and the second host in the second emission layer become opposite to each other. By simultaneously satisfying Expression 1 and Expression 2, the light-emitting device may simultaneously have excellent characteristics in terms of luminescence efficiency, power efficiency, lifespan, roll-off ratio, and/or lateral luminance ratio, and excellent low-gradation emission characteristics, for example, a relatively small turn-on time and/or turn-off time when driving a pulse current at a low current density, and thus, may be a high-quality light-emitting device with overall excellent performance. The light-emitting device is to be adapted as a light-emitting device to be mounted on various consumer goods. In addition, by further satisfying Expression 3 and/or Expression 4, the luminescence efficiency, power efficiency, lifespan, roll-off ratio, lateral luminance ratio, and low-gradation emission characteristics of the light-emitting device may be further improved.

The above may be described in more detail in Evaluation Examples provided below.

In an embodiment, the first emission layer and the second emission layer may be in direct contact with each other.

The first emission layer of the light-emitting device may be arranged between the second emission layer and the second electrode. In other words, the first electrode, the second emission layer, the first emission layer, and the second electrode of the light-emitting device may be arranged in this stated order.

In an embodiment, the second emission layer of the light-emitting device may be arranged between the first emission layer and the second electrode. In other words, the first electrode, the first emission layer, the second emission layer, and the second electrode of the light-emitting device may be arranged in this stated order.

In an embodiment, the first transition metal may be platinum, and the second transition metal may be iridium.

In an embodiment, the first dopant may be an organometallic compound including a first transition metal (for example, iridium, platinum, or osmium) and at least one organic ligand bonded to the first transition metal. In an embodiment, the first light may be phosphorescent light.

In an embodiment, the second dopant may be an organometallic compound including a second transition metal (for example, iridium, platinum, or osmium) and at least one organic ligand bonded to the second transition metal. In an embodiment, the second light may be phosphorescent light.

The first dopant may include one first transition metal, and the second dopant may include one second transition metal.

Each of the first dopant and the second dopant may be electrically neutral.

In an embodiment, the first dopant may be a platinum-containing organometallic compound including platinum and a tetradentate ligand bonded to the platinum, and the second dopant may be an iridium-containing organometallic compound including iridium and a first ligand, a second ligand, and a third ligand, bonded to the iridium.

For example, the platinum-containing organometallic compound may be an organometallic compound including a chemical bond between carbon of the tetradentate ligand and the platinum.

In an embodiment, the platinum-containing organometallic compound may be an organometallic compound including a) a chemical bond (for example, a covalent bond) between carbon of the tetradentate ligand and the platinum and b) a chemical bond (for example, a covalent bond) between oxygen (O) of the tetradentate ligand and the platinum. The platinum-containing organometallic compound may be an organometallic compound that further includes a chemical bond (for example, a coordinate bond) between nitrogen of the tetradentate ligand and the platinum.

In an embodiment, the platinum-containing organometallic compound may be an organometallic compound including a) a chemical bond (for example, a covalent bond) between carbon of the tetradentate ligand and the platinum and b) a chemical bond (for example, a covalent bond) between sulfur (S) of the tetradentate ligand and the platinum. The platinum-containing organometallic compound may be an organometallic compound that further includes a chemical bond (for example, a coordinate bond) between nitrogen of the tetradentate ligand and the platinum.

In an embodiment, in the iridium-containing organometallic compound,
a) the first ligand, the second ligand, and the third ligand may be identical to each other,
b) the first ligand and the second ligand may be identical to each other, and the second ligand and the third ligand may be different from each other, or
c) the first ligand, the second ligand, and the third ligand may each be different from the other.

In an embodiment, each of the first ligand, the second ligand, and the third ligand may be:
a bidentate ligand bonded to iridium of the iridium-containing organometallic compound via two nitrogens;
a bidentate ligand bonded to iridium of the iridium-containing organometallic compound via nitrogen and carbon; or
a bidentate ligand bonded to iridium of the iridium-containing organometallic compound via two carbons.

In an embodiment, each of the first ligand, the second ligand, and the third ligand may be a bidentate ligand bonded to iridium of the iridium-containing organometallic compound via nitrogen and carbon.

In an embodiment, at least one of the first dopant and the second dopant may include deuterium, a fluoro group, Si, Ge, or any combination thereof.

In an embodiment, at least one of the first dopant and the second dopant may include deuterium.

For example, at least one of the first dopant and the second dopant may include deuterium, a fluoro group, a deuterated C₁-C₂₀ alkyl group, a fluorinated C₁-C₂₀ alkyl group, - Si(Q₃)(Q₄)(Q₅), -Ge(Q₃)(Q₄)(Q₅), or any combination thereof, and Q₃ to Q₅ may each independently be a C₁-C₂₀ alkyl group or a phenyl group.

In an embodiment, the iridium-containing organometallic compound may include a dibenzofuran group, a dibenzothiophene group, a dibenzoselenophene group, a dibenzosilole group, a dibenzogermole group, a naphthobenzofuran group, a naphthobenzothiophene group, a naphthobenzoselenophene group, a naphthobenzosilole group, a naphthobenzogermole group, a phenanthrobenzofuran group, a phenanthrobenzothiophene group, a phenanthrobenzoselenophene group, a phenanthrobenzosilole group, a phenanthrobenzogermole group, an azadibenzofuran group, an azadibenzothiophene group, an azadibenzoselenophene group, an azadibenzosilole group, an azadibenzogermole group, an azanaphthobenzofuran group, an azanaphthobenzothiophene group, an azanaphthobenzoselenophene group, an azanaphthobenzosilole group, an azanaphthobenzogermole group, an azaphenanthrobenzofuran group, an azaphenanthrobenzothiophene group, an azaphenanthrobenzoselenophene group, an azaphenanthrobenzosilole group, an azaphenanthrobenzogermole group, or any combination thereof, bonded to the iridium via carbon.

For example, the iridium-containing organometallic compound may include a dibenzofuran group, a dibenzothiophene group, a naphthobenzofuran group, a naphthobenzothiophene group, a phenanthrobenzofuran group, a phenanthrobenzothiophene group, an azadibenzofuran group, an azadibenzothiophene group, an azanaphthobenzofuran group, an azanaphthobenzothiophene group, an azaphenanthrobenzofuran group, an azaphenanthrobenzothiophene group, or any combination thereof, bonded to the iridium via carbon.

In an embodiment, the iridium-containing organometallic compound may include a benzimidazole group, a benzoxazole group, a benzthiazole group, a naphthoimidazole group, a naphthoxazole group, a naphthothiazole group, a phenanthroimidazole group, a phenanthroxazole group, a phenanthrothiazole group, a pyridoimidazole group, a pyridoxazole group, a pyridothiazole group, a pyridine group, a pyrimidine group, a pyrazine group, a pyridazine group, a quinoline group, an isoquinoline group, a furopyridine group, a benzofuropyridine group, a thienopyridine group, a benzothienopyridine group, or any combination thereof, bonded to the iridium via nitrogen.

For example, the iridium-containing organometallic compound may include a benzimidazole group, a naphthoimidazole group, a phenanthroimidazole group, a furopyridine group, a benzofuropyridine group, a thienopyridine group, a benzothienopyridine group, or any combination thereof, bonded to the iridium via nitrogen.

In an embodiment, the iridium-containing organometallic compound may include ring A₃ bonded to the iridium via nitrogen and ring A₄ bonded to the iridium via carbon, ring A₃ and ring A₄ are bonded together via a single bond, ring A₃ may be a benzimidazole group, a benzoxazole group, a benzthiazole group, a naphthoimidazole group, a naphthoxazole group, a naphthothiazole group, a phenanthroimidazole group, a phenanthroxazole group, a phenanthrothiazole group, a pyridoimidazole group, a pyridoxazole group, a pyridothiazole group, a pyridine group, a pyrimidine group, a pyrazine group, a pyridazine group, a quinoline group, an isoquinoline group, a furopyridine group, a benzofuropyridine group, a thienopyridine group, or a benzothienopyridine group, and ring A₄ may be a dibenzofuran group, a dibenzothiophene group, a naphthobenzofuran group, a naphthobenzothiophene group, a phenanthrobenzofuran group, a phenanthrobenzothiophene group, an azadibenzofuran group, an azadibenzothiophene group, an azanaphthobenzofuran group, an azanaphthobenzothiophene group, an azaphenanthrobenzofuran group, or an azaphenanthrobenzothiophene group.

In an embodiment, the first dopant and the second dopant may each independently be an organometallic compound represented by Formula 1 or an organometallic compound represented by Formula 2:

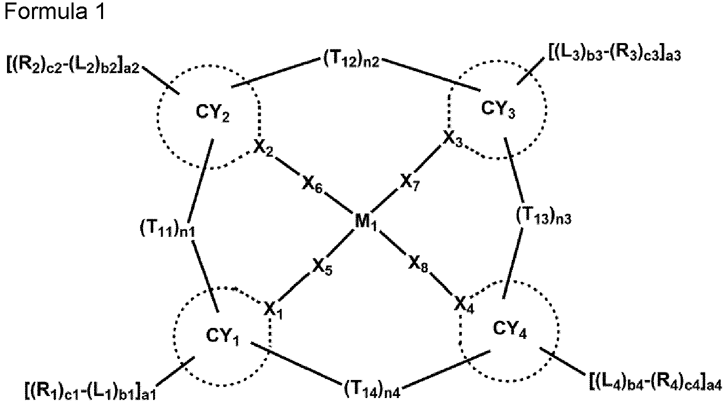

Formula 2 M₂(L₁₁)ₙ₁₁(L₁₂)ₙ₁₂(L₁₃)ₙ₁₃.

wherein, M₁ in Formula 1 is platinum (Pt), and M₂ in Formula 2 is iridium (Ir).

In Formula 2, L₁₁ may be a ligand represented by Formula 2-1, L₁₂ may be a ligand represented by Formula 2-2, and L₁₃ may be a ligand represented by Formula 2-1 or 2-2: 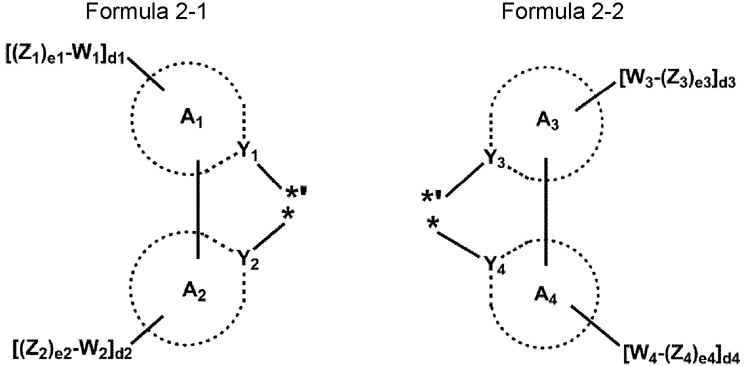
wherein Formulae 2-1 and 2-2 may respectively be the same as those described in the present specification.
L₁₁ and L₁₂ in Formula 2 may be different from each other.
n11 to n13 in Formula 2 indicate numbers of L₁₁ to L₁₃, respectively, and may each independently be 0, 1, 2, or 3, wherein n11 + n12 + n13 may be 3.

In an embodiment, in Formula 2, n11 may be 1, 2, or 3, and n12 and n13 may each independently be 0, 1, or 2.

In an embodiment, in Formula 2, n12 may be 1, 2, or 3, and n11 and n13 may each independently be 0, 1, or 2.

In an embodiment, n11 may be 1, n12 may be 2, and n13 may be 0.

In an embodiment, n11 may be 2, n12 may be 1, and n13 may be 0.

In an embodiment, n11 may be 3, and n12 and n13 may each be 0.

In an embodiment, n12 may be 3, and n11 and n13 may each be 0.

The organometallic compound represented by Formula 2 may be a heteroleptic complex or a homoleptic complex. For example, the organometallic compound represented by Formula 2 may be a heteroleptic complex.

X₁ to X₄ and Y₁ to Y₄ in Formulae 1, 2-1, and 2-2 may each independently be C or N.

For example, at least one of X₁ to X₄ in Formula 1 may be C.

In an embodiment, X₁ in Formula 1 may be C.

In an embodiment, in Formula 1, i) X₁ and X₃ may each be C, and X₂ and X₄ may each be N, or ii) X₁ and X₄ may each be C, and X₂ and X₃ may each be N.

In an embodiment, in Formulae 2-1 and 2-2, Y₁ and Y₃ may each be N, and Y₂ and Y₄ may each be C.

X₅ to X₈ in Formula 1 may each independently be a chemical bond, O, S, N(R'), C(R')(R"), or C(=O), wherein at least one of X₅ to X₈ may not be a chemical bond. R' and R" may respectively be the same as those described in the present specification.

In an embodiment, X₅ in Formula 1 may not be a chemical bond.

In an embodiment, X₅ in Formula 1 may be O or S.

In an embodiment, in Formula 1, X₅ may be O or S, and X₆ to X₈ may each be a chemical bond.

In Formula 1, two of a bond between X₅ or X₁ and M₁, a bond between X₆ or X₂ and M₁, a bond between X₇ or X₃ and M₁, and a bond between X₈ or X₄ and M₁ may each be a coordinate bond, and the other two bonds may each be a covalent bond.

For example, a bond between X₂ and M₁ in Formula 1 may be a coordinate bond.

In an embodiment, in Formula 1, a bond between X₅ or X₁ and M₁ and a bond between X₃ and M₁ may each be a coordinate bond, and a bond between X₂ and M₁ and a bond between X₄ and M₁ may each be a covalent bond.

In an embodiment, in Formula 1, a bond between X₅ or X₁ and M₁ and a bond between X₃ and M₁ may each be a covalent bond, and a bond between X₂ and M₁ and a bond between X₄ and M₁ may each be a coordinate bond.

Ring CY₁ to ring CY₄ and ring A₁ to ring A₄ in Formulae 1, 2-1, and 2-2 may each independently be a C₅-C₃₀ carbocyclic group or a C₁-C₃₀ heterocyclic group.

For example, each of ring CY₁, ring CY₃, and ring CY₄ in Formula 1 may not be a benzimidazole group.

For example, ring CY₁ to ring CY₄ and ring A₁ to ring A₄ in Formulae 1, 2-1, and 2-2 may each independently be i) a first ring, ii) a second ring, iii) a condensed ring in which two or more first rings are condensed with each other, iv) a condensed ring in which two or more second rings are condensed with each other, or v) a condensed ring in which one or more first rings are condensed with one or more second rings,
the first ring may be a cyclopentane group, a cyclopentene group, a furan group, a thiophene group, a pyrrole group, a silole group, a borole group, a phosphole group, a germole group, a selenophene group, an oxazole group, an oxadiazole group, an oxatriazole group, a thiazole group, a thiadiazole group, a thiatriazole group, a pyrazole group, an imidazole group, a triazole group, a tetrazole group, or an azasilole group, and
the second ring may be an adamantane group, a norbornane group, a norbornene group, a cyclohexane group, a cyclohexene group, a benzene group, a pyridine group, a pyrimidine group, a pyrazine group, a pyridazine group, or a triazine group.

As another example, ring CY₁ to ring CY₄ and ring A₁ to ring A₄ in Formulae 1, 2-1, and 2-2 may each independently be a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, a pyrrole group, a furan group, a thiophene group, a silole group, a borole group, a phosphole group, a germole group, a selenophene group, an indene group, an indole group, a benzofuran group, a benzothiophene group, a benzosilole group, a benzoborole group, a benzophosphole group, a benzogermole group, a benzoselenophene group, a fluorene group, a carbazole group, a dibenzofuran group, a dibenzothiophene group, a dibenzosilole group, a dibenzoborole group, a dibenzophosphole group, a dibenzogermole group, a dibenzoselenophene group, a benzofluorene group, a benzocarbazole group, a naphthobenzofuran group, a naphthobenzothiophene group, a naphthobenzosilole group, a naphthobenzoborole group, a naphthobenzophosphole group, a naphthobenzogermole group, a naphthobenzoselenophene group, a dibenzofluorene group, a dibenzocarbazole group, a dinaphthofuran group, a dinaphthothiophene group, a dinaphthosilole group, a dinaphthoborole group, a dinaphthophosphole group, a dinaphthogermole group, a dinaphthoselenophene group, an indenophenanthrene group, an indolophenanthrene group, a phenanthrobenzofuran group, a phenanthrobenzothiophene group, a phenanthrobenzosilole group, a phenanthrobenzoborole group, a phenanthrobenzophosphole group, a phenanthrobenzogermole group, a phenanthrobenzoselenophene group, a dibenzothiophene 5-oxide group, a 9H-fluoren-9-one group, a dibenzothiophene 5,5-dioxide group, an azaindene group, an azaindole group, an azabenzofuran group, an azabenzothiophene group, an azabenzosilole group, an azabenzoborole group, an azabenzophosphole group, an azabenzogermole group, an azabenzoselenophene group, an azafluorene group, an azacarbazole group, an azadibenzofuran group, an azadibenzothiophene group, an azadibenzosilole group, an azadibenzoborole group, an azadibenzophosphole group, an azadibenzogermole group, an azadibenzoselenophene group, an azabenzofluorene group, an azabenzocarbazole group, an azanaphthobenzofuran group, an azanaphthobenzothiophene group, an azanaphthobenzosilole group, an azanaphthobenzoborole group, an azanaphthobenzophosphole group, an azanaphthobenzogermole group, an azanaphthobenbenzoselenophene group, an azadibenzofluorene group, an azadibenzocarbazole group, an azadinaphthofuran group, an azadinaphthothiophene group, an azadinaphthosilole group, an azadinaphthoborole group, an azadinaphthophosphole group, an azadinaphthogermole group, an azadinaphthoselenophene group, an azaindenophenanthrene group, an azaindolophenanthrene group, an azaphenanthrobenzofuran group, an azaphenanthrobenzothiophene group, an azaphenanthrobenzosilole group, an azaphenanthrobenzoborole group, an azaphenanthrobenzophosphole group, an azaphenanthrobenzogermole group, an azaphenanthrobenzoselenophene group, an azadibenzothiophene 5-oxide group, an aza9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a benzoquinoline group, a benzoisoquinoline group, a benzoquinoxaline group, a benzoquinazoline group, a phenanthroline group, a phenanthridine group, a pyrrole group, a pyrazole group, an imidazole group, a triazole group, an oxazole group, an isoxazole group, a thiazole group, an isothiazole group, an oxadiazole group, a thiadiazole group, an azasilole group, an azaborole group, an azaphosphole group, an azagermole group, an azaselenophene group, a benzopyrrole group, a benzopyrazole group, a benz imidazole group, a benzoxazole group, a benzisoxazole group, a benzothiazole group, a benzisothiazole group, a benzoxadiazole group, a benzothiadiazole group, a pyridinopyrrole group, a pyridinopyrazole group, a pyridinoimidazole group, a pyridinoxazole group, a pyridinoisoxazole group, a pyridinothiazole group, a pyridinoisothiazole group, a pyridinooxadiazole group, a pyridinothiadiazole group, a pyrimidinopyrrole group, a pyrimidinopyrazole group, a pyrimidinoimidazole group, a pyrimidinoxazole group, a pyrimidinoisoxazole group, a pyrimidinothiazole group, a pyrimidinoisothiazole group, a pyrimidinooxadiazole group, a pyrimidinothiadiazole group, a naphthopyrrole group, a naphthopyrazole group, a naphthoimidazol group, a naphthoxazole group, a naphthoisoxazole group, a naphthothiazole group, a naphthoisothiazole group, a naphthooxadiazole group, a naphthothiadiazole group, a phenanthrenopyrrole group, a phenanthrenopyrazole group, a phenanthrenoimidazole group, a phenanthrenoxazole group, a phenanthrenoisoxazole group, a phenanthrenothiazole group, a phenanthrenoisothiazole group, a phenanthrenooxadiazole group, a phenanthrenothiadiazole group, a furo pyridine group, a benzofuropyridine group, a thienopyridine group, a benzothienopyridine group, a 5,6,7,8-tetrahydroisoquinoline group, a 5,6,7,8-tetrahydroquinoline group, an adamantane group, a norbornane group, a norbornene group, a benzene group condensed with a cyclohexane group, a benzene group condensed with a norbornane group, a pyridine group condensed with a cyclohexane group, or a pyridine group condensed with a norbornane group.

In an embodiment, ring CY₁ and ring CY₃ in Formula 1 may each independently be:
a benzene group, a naphthalene group, a phenanthrene group, a dibenzofuran group, a dibenzothiophene group, a dibenzoselenophene group, a carbazole group, a fluorene group, or a dibenzosilole group; or
a benzene group, a naphthalene group, a phenanthrene group, a dibenzofuran group, a dibenzothiophene group, a dibenzoselenophene group, a carbazole group, a fluorene group, or a dibenzosilole group, each condensed with a cyclohexane group, a cyclohexene group, a norbornane group, a piperidine group, or any combination thereof.

In an embodiment, ring CY₂ in Formula 1 may be:
an imidazole group, a benzimidazole group, a pyridine group, a pyrimidine group, a pyridazine group, a pyrazine group, a triazine group, a quinoline group, an isoquinoline group, a quinoxaline group, or a quinazoline group; or
an imidazole group, a benzimidazole group, a pyridine group, a pyrimidine group, a pyridazine group, a pyrazine group, a triazine group, a quinoline group, an isoquinoline group, a quinoxaline group, or a quinazoline group, each condensed with a cyclohexane group, a cyclohexene group, a norbornane group, a benzene group, a pyridine group, a pyrimidine group, or any combination thereof.

In an embodiment, ring CY₄ in Formula 1 may be:
a pyridine group, a pyrimidine group, a pyridazine group, a pyrazine group, a triazine group, a quinoline group, an isoquinoline group, a quinoxaline group, a quinazoline group, an azadibenzofuran group, an azadibenzothiophene group, an azadibenzoselenophene group, an azacarbazole group, an azafluorene group, or an azadibenzosilole group; or
a pyridine group, a pyrimidine group, a pyridazine group, a pyrazine group, a triazine group, a quinoline group, an isoquinoline group, a quinoxaline group, a quinazoline group, an azadibenzofuran group, an azadibenzothiophene group, an azadibenzoselenophene group, an azacarbazole group, an azafluorene group, or an azadibenzosilole group, each condensed with a cyclohexane group, a cyclohexene group, a norbornane group, a benzene group, a pyridine group, a pyrimidine group, or any combination thereof.

Ring A₁ and ring A₃ in Formulae 2-1 and 2-2 may be different from each other.

In an embodiment, a Y₁-containing monocyclic group in ring A₁, a Y₂-containing monocyclic group in ring A₂, and a Y₄-containing monocyclic group in ring A₄ may each be a 6-membered ring.

In an embodiment, a Y₃-containing monocyclic group in ring A₃ may be a 6-membered ring.

In an embodiment, a Y₃-containing monocyclic group in ring A₃ may be a 5-membered ring.

In an embodiment, a Y₁-containing monocyclic group in ring A₁ may be a 6-membered ring, and a Y₃-containing monocyclic group in ring A₃ may be a 5-membered ring.

In an embodiment, ring A₁ and ring A₃ in Formulae 2-1 and 2-2 may each independently be i) Group A, ii) a polycyclic group in which two or more of Group A are condensed with each other, or iii) a polycyclic group in which one or more of Group A and one or more of Group B are condensed with each other,
Group A may be a pyridine group, a pyrimidine group, a pyridazine group, a pyrazine group, or a triazine group, and
Group B may be a cyclohexane group, a cyclohexene group, a norbornane group, a benzene group, a furan group, a thiophene group, a selenophene group, a pyrrole group, a cyclopentadiene group, or silole group.

In an embodiment, in Formula 2-2, ring A₃ may be i) Group C, ii) a polycyclic group in which two or more of Group C are condensed with each other, or iii) a polycyclic group in which one or more of Group C and one or more of Group D are condensed with each other,
Group C may be a pyrrole group, a pyrazole group, an imidazole group, a triazole group, an oxazole group, an isoxazole group, a thiazole group, or an isothiazole group, and
Group D may be a cyclohexane group, a cyclohexene group, a norbornane group, a benzene group, a furan group, a thiophene group, a selenophene group, a cyclopentadiene group, a silole group, a pyridine group, a pyrimidine group, a pyridazine group, a pyrazine group, or a triazine group.

In an embodiment, ring A₁ in Formula 2-1 may be:
a pyridine group, a pyrimidine group, a pyridazine group, or a pyrazine group; or
a pyridine group, a pyrimidine group, a pyridazine group, or a pyrazine group, each condensed with a cyclohexane group, a norbornane group, a benzene group, or any combination thereof.

In an embodiment, ring A₃ in Formula 2-2 may be:
a pyridine group, a pyrimidine group, a pyridazine group, or a pyrazine group;
a pyridine group, a pyrimidine group, a pyridazine group, or a pyrazine group, each condensed with a cyclohexane group, a norbornane group, a benzene group, or any combination thereof; or
an imidazole group, a benzimidazole group, a naphthoimidazole group, a phenanthrenoimidazole group, a pyridoimidazole group, an oxazole group, a benzoxazole group, a naphthoxazole group, a phenanthrenoxazole group, a pyridoxazole group, a thiazole group, a benzothiazole group, a naphthothiazole group, a phenanthrenothiazole group, or a pyridothiazole group.

In an embodiment, ring A₂ and ring A₄ in Formulae 2-1 and 2-2 may be different from each other.

In an embodiment, ring A₂ and ring A₄ in Formulae 2-1 and 2-2 may each independently be i) Group E, ii) a polycyclic group in which two or more of Group E are condensed with each other, or iii) a polycyclic group in which one or more of Group E and one or more of Group F are condensed with each other,
Group E may be a benzene group, a pyridine group, a pyrimidine group, a pyridazine group, a pyrazine group, or a triazine group, and
Group F may be a furan group, a thiophene group, a selenophene group, a pyrrole group, a cyclopentadiene group, a silole group, a pyrazole group, an imidazole group, an oxazole group, a thiazole group, an isoxazole group, or an isothiazole group.

In an embodiment, ring A₂ in Formula 2-1 may be a polycyclic group in which two or more of Group E and one or more of Group F are condensed with each other.

In an embodiment, ring A₄ in Formula 2-2 may be a polycyclic group in which two or more of Group E and one or more of Group F are condensed with each other.

In an embodiment, ring A₂ in Formula 2-1 may be:
a benzene group, a naphthalene group, a phenanthrene group, a dibenzofuran group, a dibenzothiophene group, a dibenzoselenophene group, a carbazole group, a fluorene group, or a dibenzosilole group; or
a benzene group, a naphthalene group, a phenanthrene group, a dibenzofuran group, a dibenzothiophene group, a dibenzoselenophene group, a carbazole group, a fluorene group, or a dibenzosilole group, each condensed with a cyclohexane group, a norbornane group, a benzene group, or any combination thereof.

In an embodiment, ring A₄ in Formula 2-2 may be:
a benzene group, a naphthalene group, a phenanthrene group, a dibenzofuran group, a dibenzothiophene group, a dibenzoselenophene group, a carbazole group, a fluorene group, a dibenzosilole group, an azadibenzofuran group, an azadibenzothiophene group, an azadibenzoselenophene group, an azacarbazole group, an azafluorene group, or a dibenzosilole group; or
a benzene group, a naphthalene group, a phenanthrene group, a dibenzofuran group, a dibenzothiophene group, a dibenzoselenophene group, a carbazole group, a fluorene group, a dibenzosilole group, an azadibenzofuran group, an azadibenzothiophene group, an azadibenzoselenophene group, an azacarbazole group, an azafluorene group, or a dibenzosilole group, each condensed with a benzene group, a pyridine group, a pyrimidine group, a pyridazine group, a pyrazine group, a cyclohexane group, a norbornane group, a furan group, a thiophene group, a selenophene group, a pyrrole group, a cyclopentadiene group, a silole group, a pyrazole group, an imidazole group, an oxazole group, a thiazole group, an isoxazole group, an isothiazole group, or any combination thereof.

T₁₁ to T₁₄ in Formula 1 may each independently be a single bond, a double bond, *-N(R₅ₐ)-*', *-B(R₅ₐ)-*', *-P(R₅ₐ)-*', *-C(R₅ₐ)(R_{5b})-*', *-Si(R₅ₐ)(R_{5b})-*', *-Ge(R₅ₐ)(R_{5b})-*', *-S-*', *-Se-*', *-O-*', *-C(=O)-*', *-S(=O)-*', *-S(=O)₂-*', *-C(R₅ₐ)=*', *=C(R₅ₐ)-*', *-C(R₅ₐ)=C(R_{5b})-*', *-C(=S)-*', *-C≡C-*', a C₅-C₃₀ carbocyclic group that is unsubstituted or substituted with at least one R₁₀ₐ, or a C₁-C₃₀ heterocyclic group that is unsubstituted or substituted with at least one R₁₀ₐ.

For example, T₁₁ and T₁₂ in Formula 1 may be a single bond, and T₁₃ may be a single bond, *-N(R₅ₐ)-*', *-B(R₅ₐ)-*', *-P(R₅ₐ)-*', *-C(R₅ₐ)(R_{5b})-*', *-Si(R₅ₐ)(R_{5b})-*', *-Ge(R₅ₐ)(R_{5b})-*', *-S-*', or *-O-*'.
n1 to n4 in Formula 1 indicate numbers of T₁₁ to T₁₄, respectively, and may each independently be 0 or 1, wherein three or more of n1 to n4 may each be 1. In other words, the organometallic compound represented by Formula 1 may have a tetradentate ligand.

In Formula 1, when n1 is 0, T₁₁ does not exist (that is, ring CY₁ and ring CY₂ are not linked to each other), when n2 is 0, T₁₂ does not exist (that is, ring CY₂ and ring CY₃ are not linked to each other), when n3 is 0, T₁₃ does not exist (that is, ring CY₃ and ring CY₄ are not linked to each other), and when n4 is 0, T₁₄ does not exist (that is, ring CY₄ and ring CY₁ are not linked to each other).

In an embodiment, in Formula 1, n1 to n3 may each be 1, and n4 may be 0.

L₁ to L₄ and W₁ to W₄ in Formulae 1, 2-1, and 2-2 may each independently be a single bond, a C₁-C₆₀ alkylene group that is unsubstituted or substituted with at least one R₁₀ₐ, a C₅-C₃₀ carbocyclic group that is unsubstituted or substituted with at least one R₁₀ₐ, or a C₁-C₃₀ heterocyclic group that is unsubstituted or substituted with at least one R₁₀ₐ.

For example, L₁ to L₄ and W₁ to W₄ in Formulae 1, 2-1, and 2-2 may each independently be:
a single bond; or
a cyclopentene group, a cyclohexane group, a cyclohexene group, a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluoren-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, a 5,6,7,8-tetrahydroquinoline group, an adamantane group, a norbornane group, or a norbornene group, each unsubstituted or substituted with at least one R₁₀ₐ.

In an embodiment, L₁ to L₄ and W₁ to W₄ in Formulae 1, 2-1, and 2-2 may each independently be:
a single bond; or
a benzene group, a naphthalene group, a pyridine group, a fluorene group, a carbazole group, a dibenzofuran group, or a dibenzothiophene group, each unsubstituted or substituted with at least one R₁₀ₐ.

In an embodiment, L₁ to L₄ and W₁ to W₄ in Formulae 1, 2-1, and 2-2 may each independently be:
a single bond; or
a C₁-C₂₀ alkylene group, a benzene group, a naphthalene group, a dibenzofuran group, or a dibenzothiophene group, each unsubstituted or substituted with deuterium, -F, a cyano group, a C₁-C₂₀ alkyl group, a deuterated C₁-C₂₀ alkyl group, a fluorinated C₁-C₂₀ alkyl group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a phenyl group, a deuterated phenyl group, a fluorinated phenyl group, a (C₁-C₂₀ alkyl)phenyl group, a naphthyl group, a pyridinyl group, a furanyl group, a thiophenyl group, a benzofuranyl group, a benzothiophenyl group, a dibenzofuranyl group, a dibenzothiophenyl group, or any combination thereof.
b1 to b4 in Formula 1 indicate numbers of L₁ to L₄, respectively, and may each independently be an integer from 1 to 10. When b1 is 2 or more, two or more L₁ may be identical to or different from each other, when b2 is 2 or more, two or more L₂ may be identical to or different from each other, when b3 is 2 or more, two or more L₃ may be identical to or different from each other, and when b4 is 2 or more, two or more L₄ may be identical to or different from each other. For example, b1 to b4 may each independently be 1, 2, or 3.
R₁ to R₄, R₅ₐ, R_{5b}, R', R", and Z₁ to Z₄ in Formulae 1, 2-1, and 2-2 may each independently be hydrogen, deuterium, -F, -Cl, -Br, -I, -SF₅, a hydroxyl group, a cyano group, a nitro group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkylaryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkylheteroaryl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -Ge(Q₃)(Q₄)(Q₅), - B(Q₆)(Q₇), -P(=O)(Q₈)(Q₉), or -P(Q₈)(Q₉). Q₁ to Q₉ may respectively be the same as those described in the present specification.

In Formulae 1, 2-1, and 2-2, R₁ to R₄, R₅ₐ, R_{5b}, R', R", and Z₁ to Z₄ may each independently be:
hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, -SF₅, C₁-C₂₀ alkyl group, a C₂-C₂₀ alkenyl group, a C₁-C₂₀ alkoxy group, or a C₁-C₂₀ alkylthio group;
a C₁-C₂₀ alkyl group, a C₂-C₂₀ alkenyl group, a C₁-C₂₀ alkoxy group, or a C₁-C₂₀ alkylthio group, each substituted with deuterium, -F, -Cl, -Br, -I, -CD₃, -CD₂H, - CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a cyclopentyl group, a cyclohexyl group, a cycloheptyl group, a cyclooctyl group, an adamantanyl group, a norbornanyl group (or, a bicyclo[2.2.1]heptyl group), a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.2]octyl group, a phenyl group, a (C₁-C₂₀ alkyl)phenyl group, a biphenyl group, a terphenyl group, a naphthyl group, a pyridinyl group, a pyrimidinyl group, or any combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a phenyl group, a (C₁-C₂₀ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a deuterated C₁-C₂₀ alkyl group, a fluorinated C₁-C₂₀ alkyl group, a C₁-C₂₀ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cyclooctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.2]octyl group, a phenyl group, a (C₁-C₂₀ alkyl)phenyl group, a deuterated phenyl group, a fluorinated phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzoimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, or any combination thereof; or
-N(Q₁)(Q₂), -Si(Q₃)(Q₄)(Q₅), -Ge(Q₃)(Q₄)(Q₅), -B(Q₆)(Q₇), -P(=O)(Q₈)(Q₉), or - P(Q₈)(Q₉), and Q₁ to Q₉ may each independently be:
   deuterium, -F, -CH₃, -CD₃, -CD₂H, -CDH₂, -CH₂CH₃, -CH₂CD₃, -CH₂CD₂H, - CH₂CDH₂, -CHDCH₃, -CHDCD₂H, -CHDCDH₂, -CHDCD₃, -CD₂CD₃, -CD₂CD₂H, - CD₂CDH₂, -CF₃, -CF₂H, -CFH₂, -CH₂CF₃, -CH₂CF₂H, -CH₂CFH₂, -CHFCH₃, - CHFCF₂H, -CHFCFH₂, -CHFCF₃, -CF₂CF₃, -CF₂CF₂H, or -CF₂CFH₂; or
   an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with deuterium, -F, a C₁-C₁₀ alkyl group, a phenyl group, or any combination thereof.

In an embodiment, R₁ to R₄, R₅ₐ, R_{5b}, R', R", and Z₁ to Z₄ in Formulae 1, 2-1, and 2-2 may each independently be:
hydrogen, deuterium, -F, or a cyano group;
a C₁-C₂₀ alkyl group that is unsubstituted or substituted with deuterium, -F, a cyano group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, a dibenzofuranyl group, a deuterated dibenzofuranyl group, a fluorinated dibenzofuranyl group, a (C₁-C₂₀ alkyl)dibenzofuranyl group, a dibenzothiophenyl group, a deuterated dibenzothiophenyl group, a fluorinated dibenzothiophenyl group, a (C₁-C₂₀ alkyl)dibenzothiophenyl group, or any combination thereof;
a C₃-C₁₀ cycloalkyl group, a C₁-C₁₀ heterocycloalkyl group, a phenyl group, a biphenyl group, a naphthyl group, a pyridinyl group, a fluorenyl group, a carbazolyl group, a dibenzofuranyl, or a dibenzothiophenyl group, each unsubstituted or substituted with deuterium, -F, a cyano group, a C₁-C₂₀ alkyl group, a deuterated C₁-C₂₀ alkyl group, a fluorinated C₁-C₂₀ alkyl group, a C₁-C₂₀ alkoxy group, a deuterated C₁-C₂₀ alkoxy group, a fluorinated C₁-C₂₀ alkoxy group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, a dibenzofuranyl group, a deuterated dibenzofuranyl group, a fluorinated dibenzofuranyl group, a (C₁-C₂₀ alkyl)dibenzofuranyl group, a dibenzothiophenyl group, a deuterated dibenzothiophenyl group, a fluorinated dibenzothiophenyl group, a (C₁-C₂₀ alkyl)dibenzothiophenyl group, or any combination thereof; or
-Si(Q₃)(Q₄)(Q₅) or -Ge(Q₃)(Q₄)(Q₅).

In an embodiment, in Formula 2-1, each of e1 and d1 may not be 0, and at least one of a plurality of Z₁ may be a deuterated C₁-C₂₀ alkyl group, -Si(Q₃)(Q₄)(Q₅), or -Ge(Q₃)(Q₄)(Q₅). Q₃ to Q₅ may respectively be the same as those described in the present specification.

For example, Q₃ to Q₅ may each independently be:
a C₁-C₆₀ alkyl group that is unsubstituted or substituted with deuterium, a C₁-C₆₀ alkyl group, a C₆-C₆₀ aryl group, or any combination thereof; or
a C₆-C₆₀ aryl group that is unsubstituted or substituted with deuterium, a C₁-C₆₀ alkyl group, a C₆-C₆₀ aryl group, or any combination thereof.

In an embodiment, Q₃ to Q₅ may each independently be:
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, or -CD₂CDH₂; or
an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with deuterium, a C₁-C₁₀ alkyl group, a phenyl group, or any combination thereof.

In an embodiment, Q₃ to Q₅ may be identical to each other.

In an embodiment, two or more of Q₃ to Q₅ may be different from each other.

In an embodiment, the organometallic compound represented by Formula 2 may satisfy at least one of Condition (1) to Condition (8):
Condition (1)
   in Formula 2-1, each of e1 and d1 is not 0, and at least one Z₁ includes deuterium;
Condition (2)
   in Formula 2-1, each of e2 and d2 is not 0, and at least one Z₂ includes deuterium;
Condition (3)
   in Formula 2-2, each of e3 and d3 is not 0, and at least one Z₃ includes deuterium;
Condition (4)
   in Formula 2-2, each of e4 and d4 is not 0, and at least one Z₄ includes deuterium;
Condition (5)
   in Formula 2-1, each of e1 and d1 is not 0, and at least one Z₁ includes a fluoro group;
Condition (6)
   in Formula 2-1, each of e2 and d2 is not 0, and at least one Z₂ includes a fluoro group;
Condition (7)
   in Formula 2-2, each of e3 and d3 is not 0, and at least one Z₃ includes a fluoro group; and
Condition (8)
   in Formula 2-2, each of e4 and d4 is not 0, and at least one Z₄ includes a fluoro group.

In an embodiment, R₁ to R₄, R₅ₐ, R_{5b}, R', R", and Z₁ to Z₄ in Formulae 1, 2-1, and 2-2 may each independently be hydrogen, deuterium, -F, -CH₃, -CD₃, -CD₂H, -CDH₂, -CF₃, -CF₂H, -CFH₂, a C₂-C₁₀ alkenyl group, a C₁-C₁₀ alkoxy group, a C₁-C₁₀ alkylthio group, a group represented by one of Formulae 9-1 to 9-39, a group represented by one of Formulae 9-1 to 9-39 in which at least one hydrogen is substituted with deuterium, a group represented by one of Formulae 9-1 to 9-39 in which at least one hydrogen is substituted with -F, a group represented by one of Formulae 9-201 to 9-227, a group represented by one of Formulae 9-201 to 9-227 in which at least one hydrogen is substituted with deuterium, a group represented by one of Formulae 9-201 to 9-227 in which at least one hydrogen is substituted with -F, a group represented by one of Formulae 10-1 to 10-129, a group represented by one of Formulae 10-1 to 10-129 in which at least one hydrogen is substituted with deuterium, a group represented by one of Formulae 10-1 to 10-129 in which at least one hydrogen is substituted with -F, a group represented by one of Formulae 10-201 to 10-350, a group represented by one of Formulae 10-201 to 10-350 in which at least one hydrogen is substituted with deuterium, a group represented by one of Formulae 10-201 to 10-350 in which at least one hydrogen is substituted with -F, -Si(Q₃)(Q₄)(Q₅), or -Ge(Q₃)(Q₄)(Q₅) (wherein Q₃ to Q₅ are respectively the same as those described in the present specification):

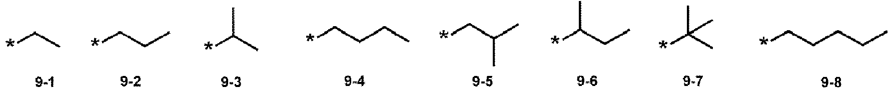

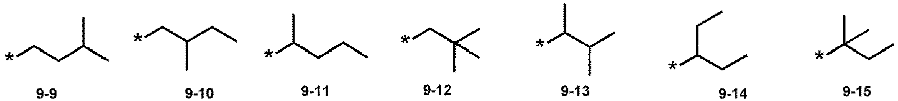

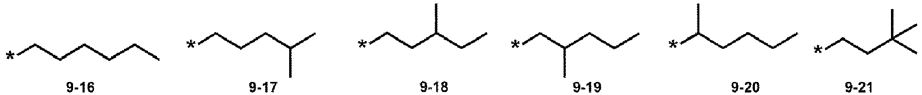

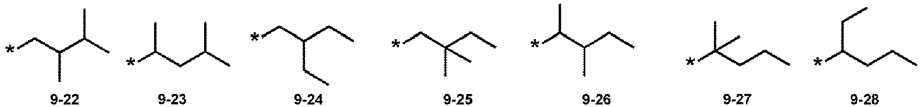

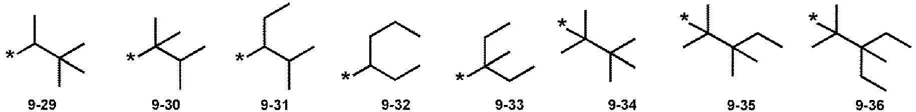

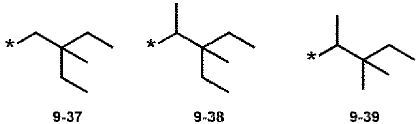

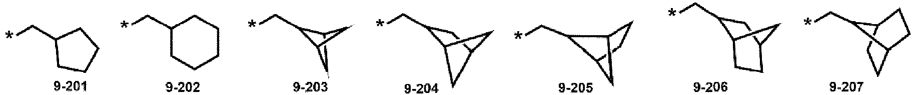

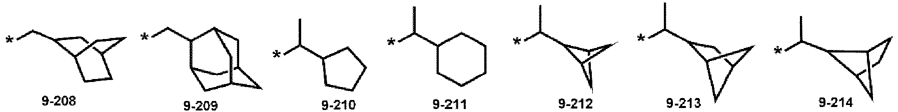

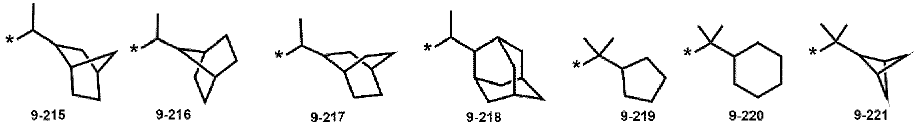

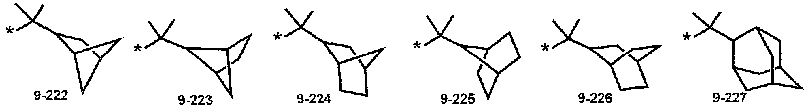

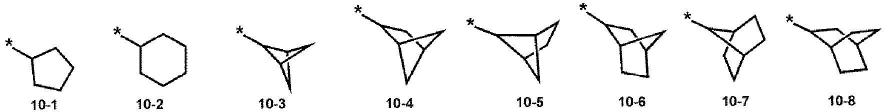

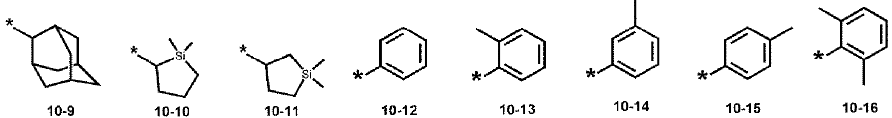

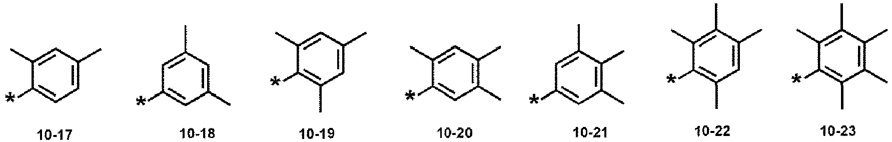

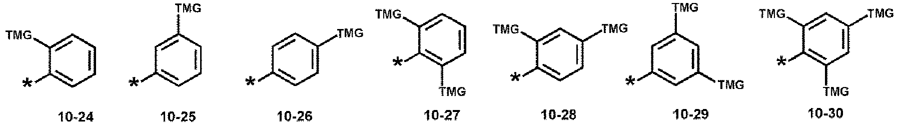

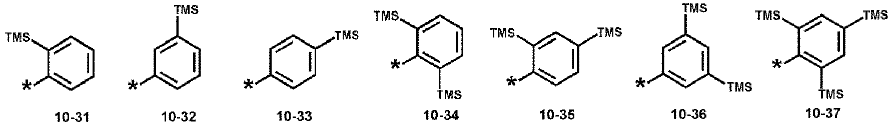

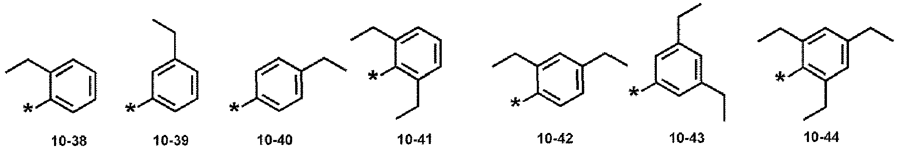

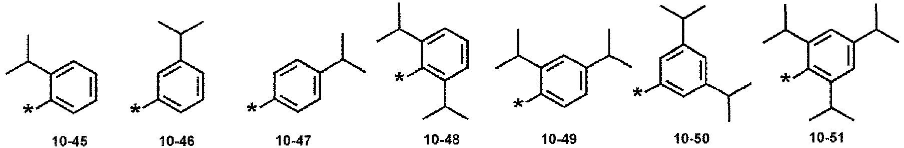

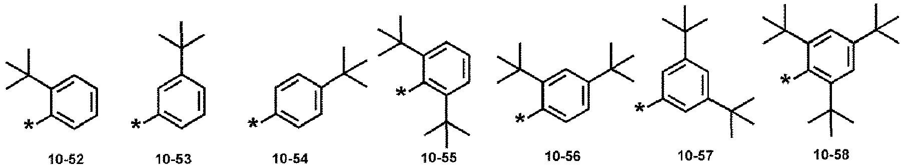

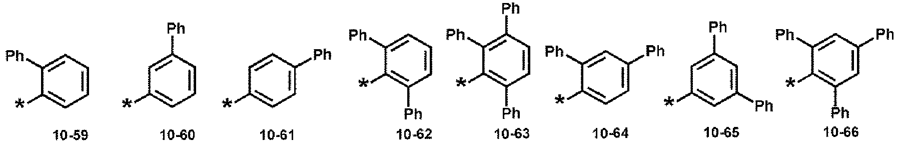

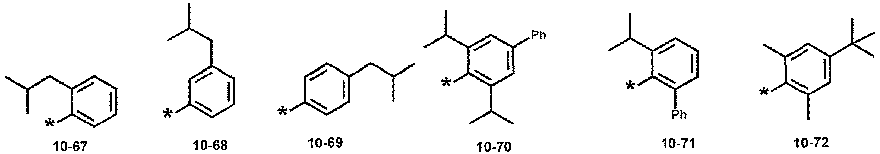

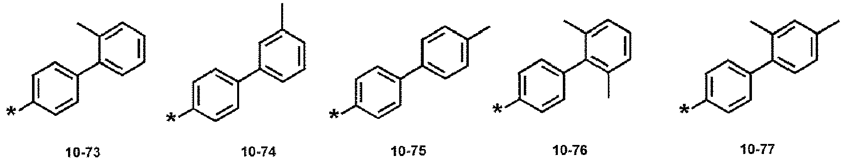

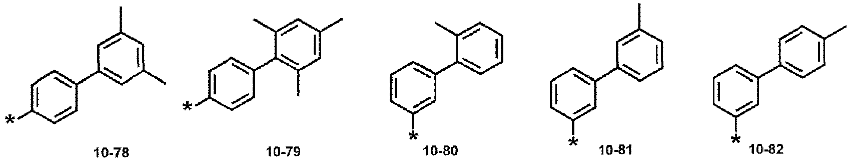

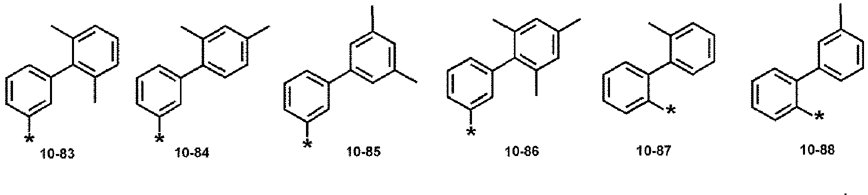

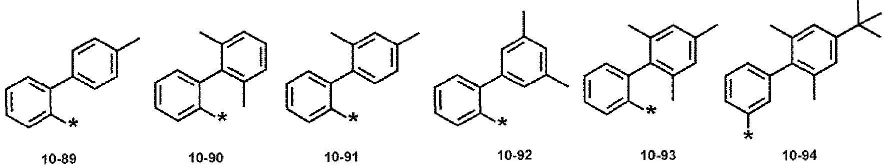

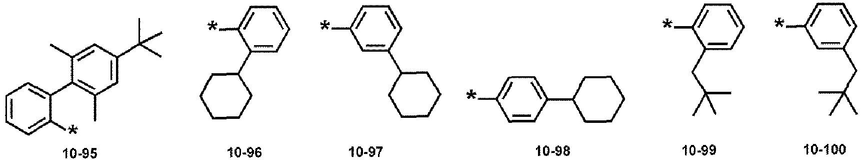

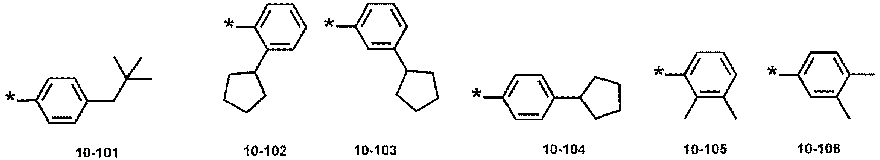

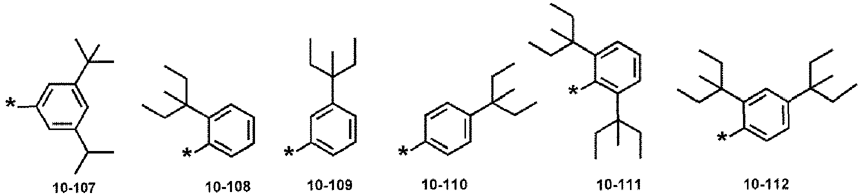

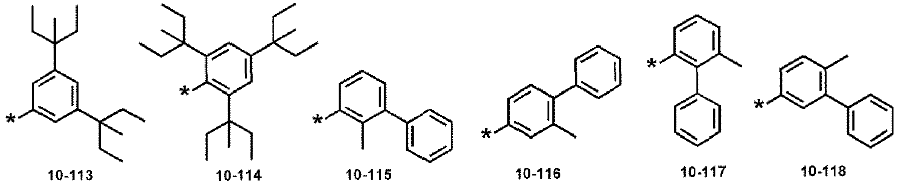

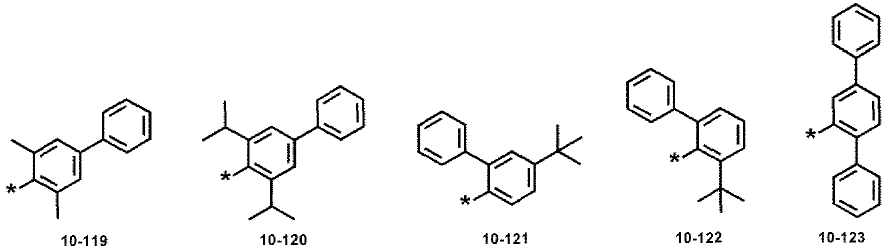

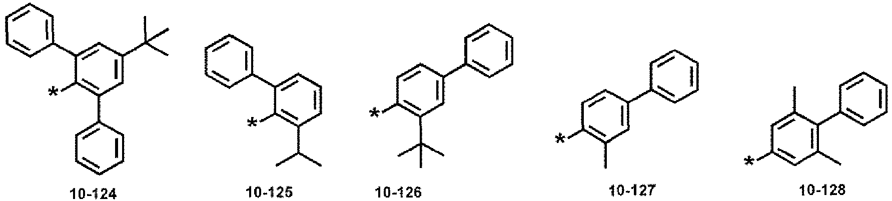

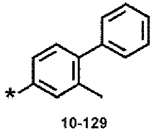

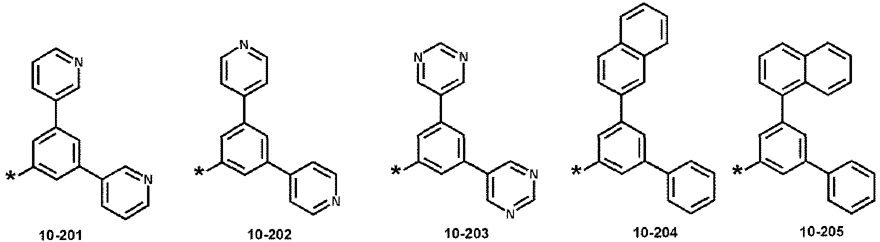

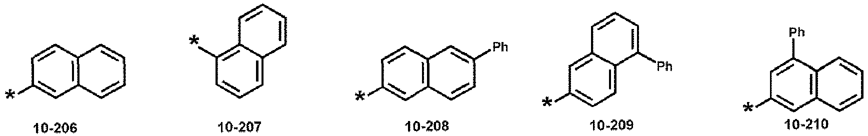

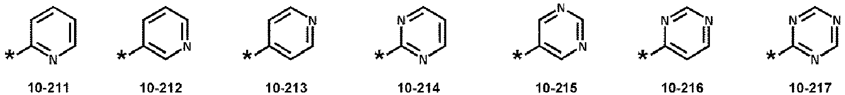

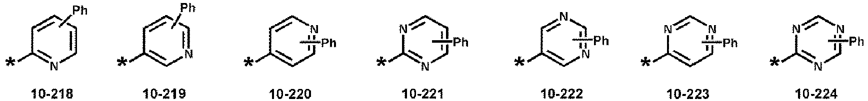

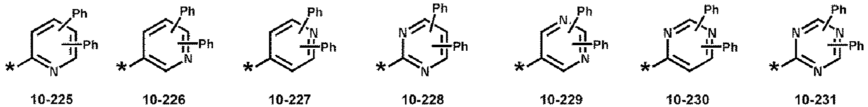

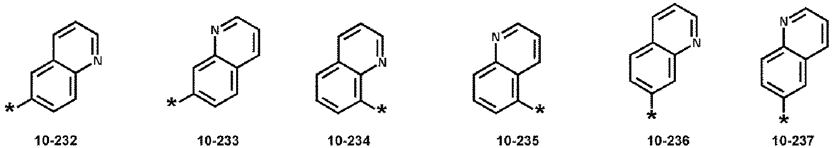

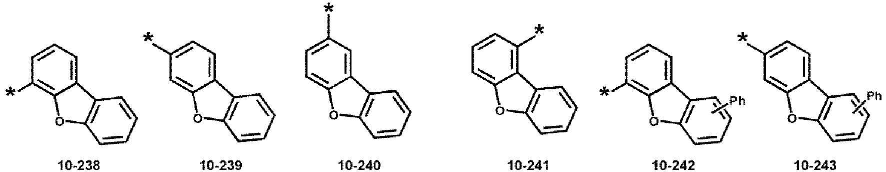

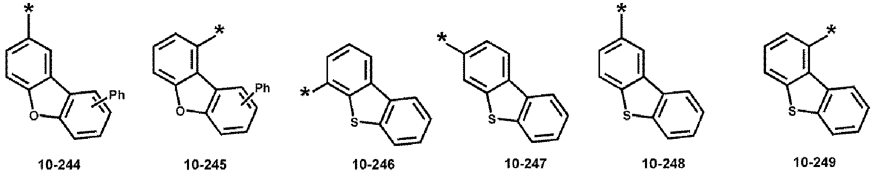

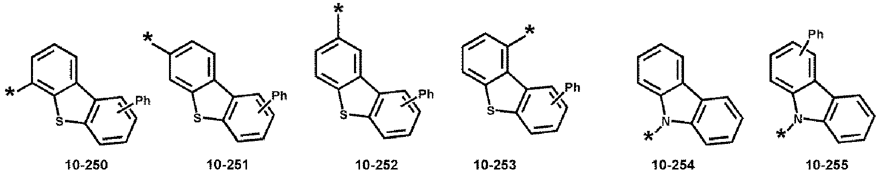

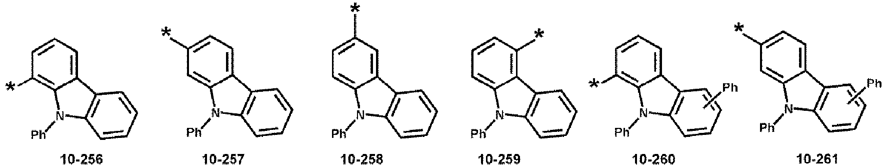

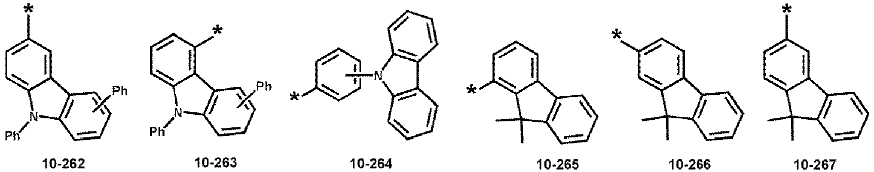

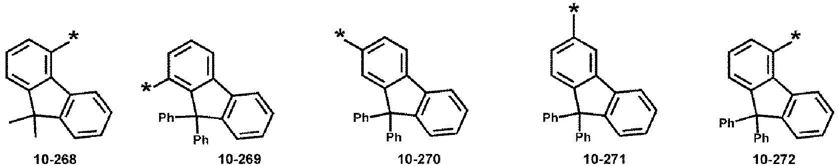

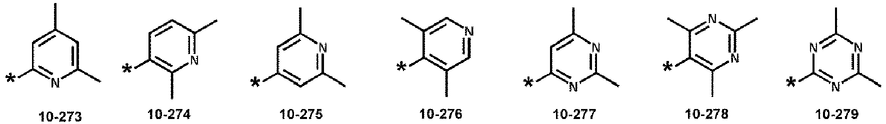

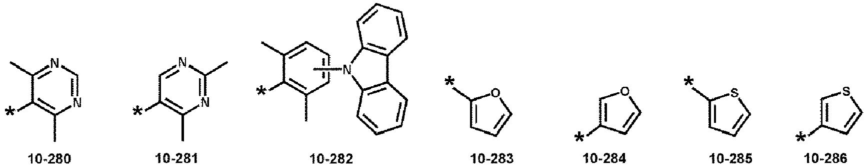

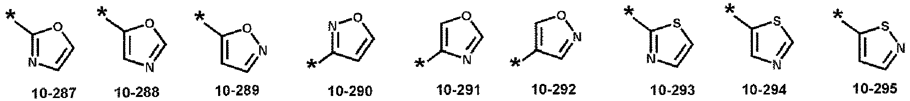

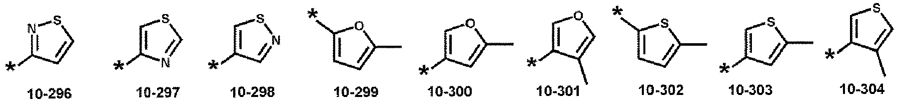

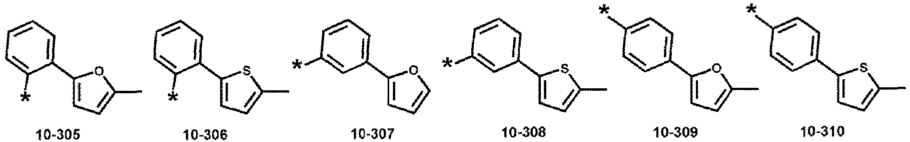

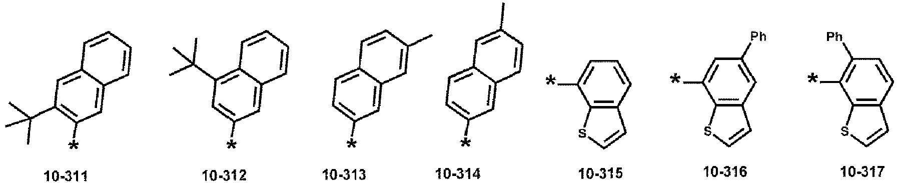

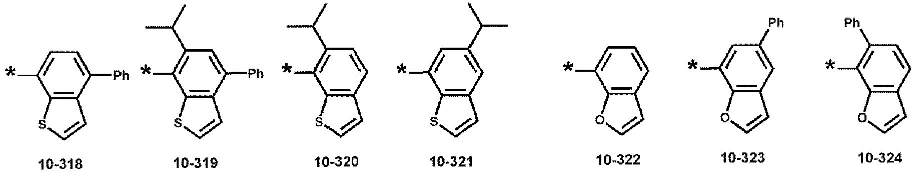

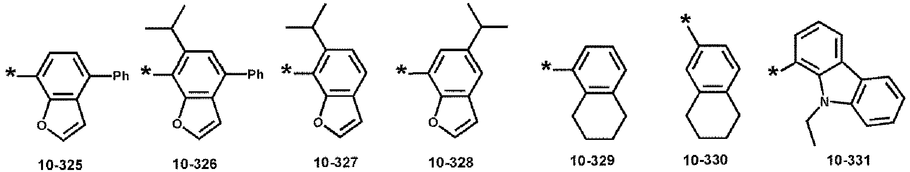

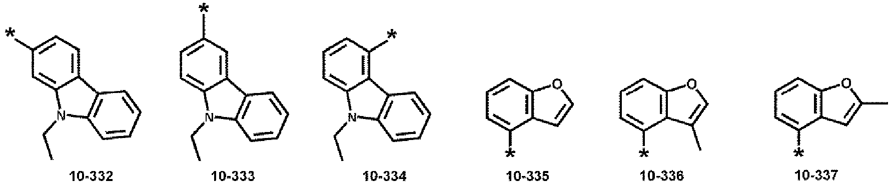

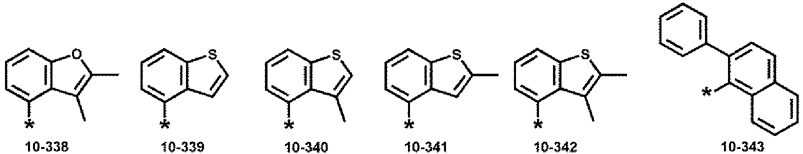

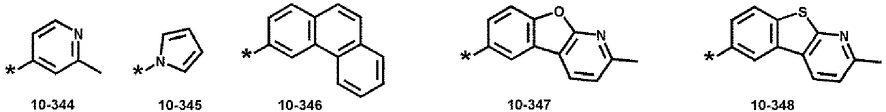

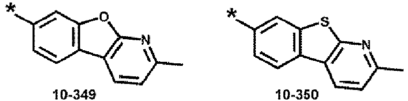

In Formulae 9-1 to 9-39, 9-201 to 9-227, 10-1 to 10-129, and 10-201 to 10-350, * indicates a binding site to a neighboring atom, Ph is a phenyl group, TMS is a trimethylsilyl group, and TMG is a trimethylgermyl group.

The "group represented by one of Formulae 9-1 to 9-39 in which at least one hydrogen is substituted with deuterium" and the "group represented by one of Formulae 9-201 to 9-227 in which at least one hydrogen is substituted with deuterium" may each be, for example, a group represented by one of Formulae 9-501 to 9-514 and 9-601 to 9-636:

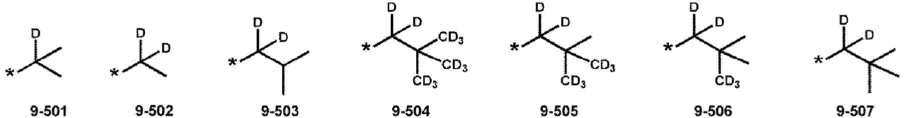

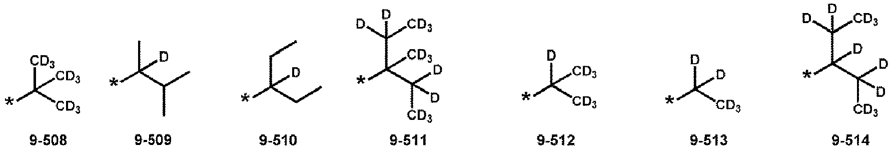

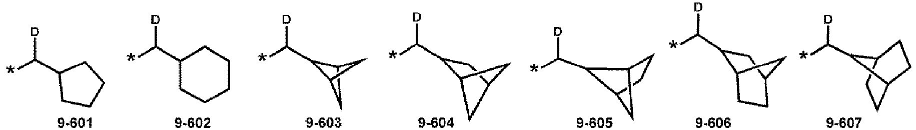

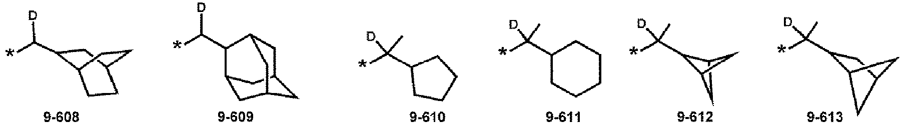

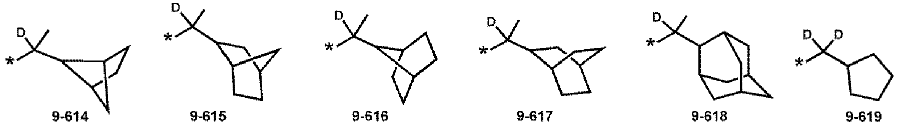

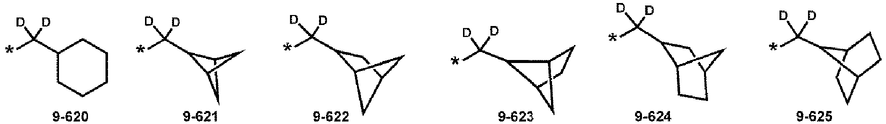

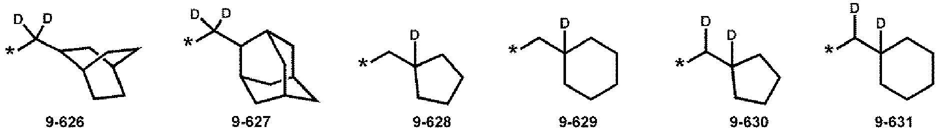

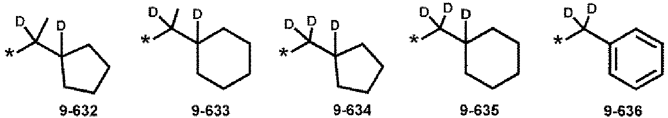

The "group represented by one of Formulae 9-1 to 9-39 in which at least one hydrogen is substituted with -F" and the "group represented by one of Formulae 9-201 to 9-227 in which at least one hydrogen is substituted with -F" may each be, for example, a group represented by one of Formulae 9-701 to 9-710:

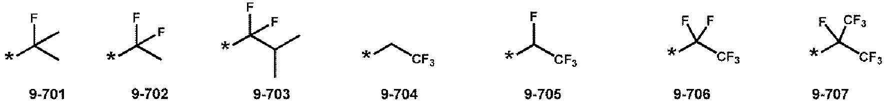

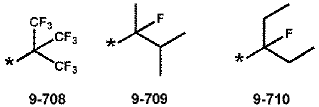

The "group represented by one of Formulae 10-1 to 10-129 in which at least one hydrogen is substituted with deuterium" and the "group represented by one of Formulae 10-201 to 10-350 in which at least one hydrogen is substituted with deuterium" may be, for example, a group represented by one of Formulae 10-501 to 10-553:

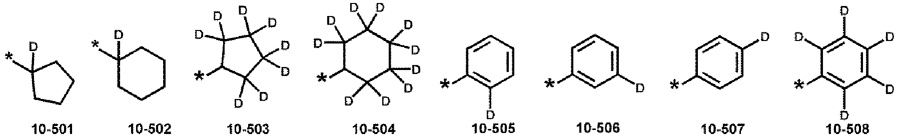

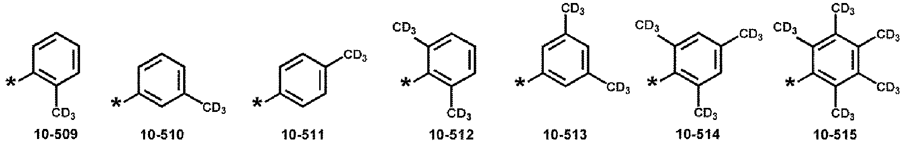

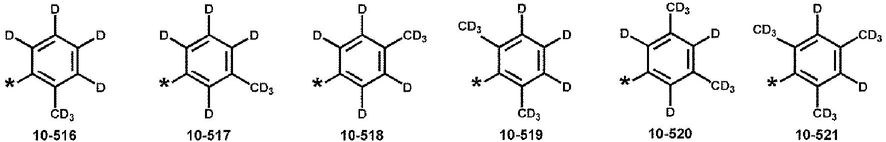

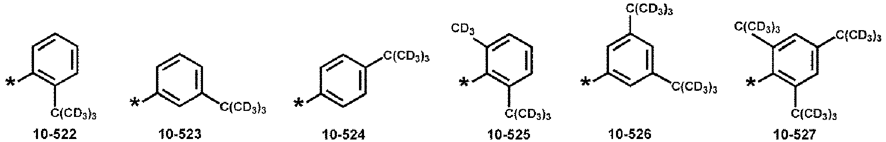

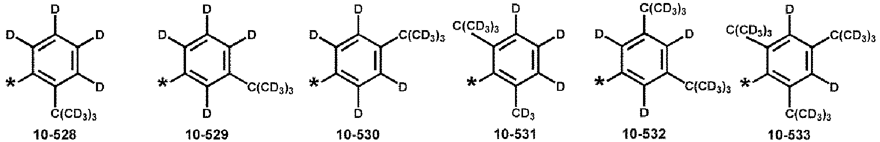

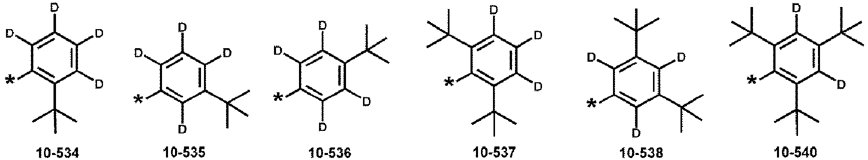

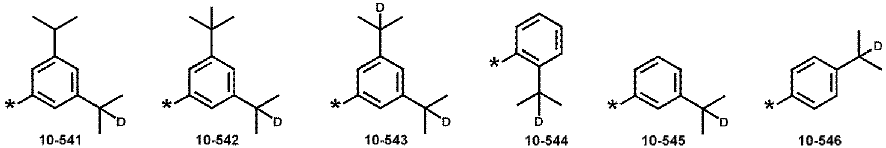

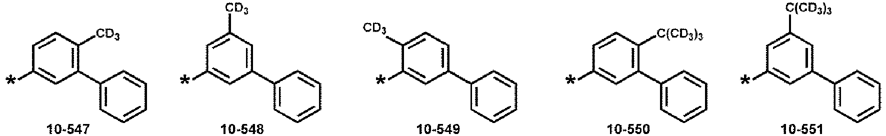

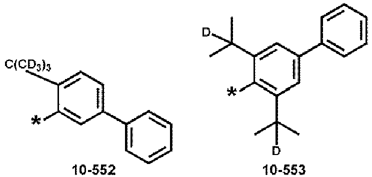

The "group represented by one of Formulae 10-1 to 10-129 in which at least one hydrogen is substituted with -F" and the "group represented by one of Formulae 10-201 to 10-350 in which at least one hydrogen is substituted with -F" may be, for example, a group represented by one of Formulae 10-601 to 10-617:

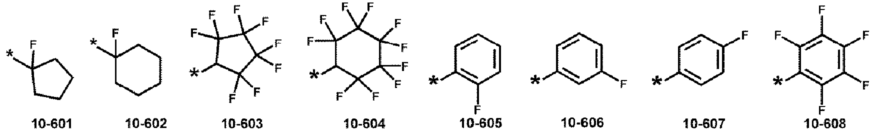

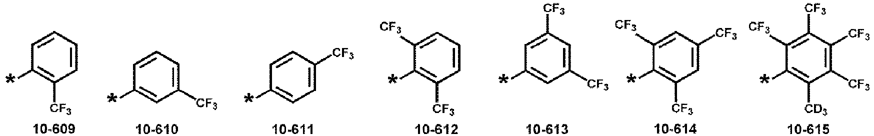

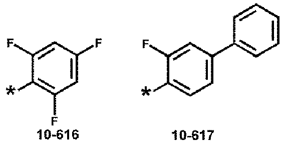

c1 to c4, a1 to a4, e1 to e4, and d1 to d4 in Formulae 1, 2-1, and 2-2 indicate numbers of R₁ to R₄, a group represented by *-[(L₁)_{b1}-(R₁)_{c1}], a group represented by *-[(L₂)_{b2}-(R₂)_{c2}], a group represented by *-[(L₃)_{b3}-(R₃)_{c3}], a group represented by *-[(L₄)_{b4}-(R₄)_{c4}], Z₁ to Z₄, a group represented by *-[W₁-(Z₁)ₑ₁], a group represented by *-[W₂-(Z₂)ₑ₂], a group represented by *-[W₃-(Z₃)ₑ₃], and a group represented by *-[W₄-(Z₄)ₑ₄], respectively, and may each independently be an integer from 0 to 20. When c1 is 2 or more, two or more R₁ may be identical to or different from each other, when c2 is 2 or more, two or more R₂ may be identical to or different from each other, when c3 is 2 or more, two or more R₃ may be identical to or different from each other, when c4 is 2 or more, two or more R₄ may be identical to or different from each other, when a1 is 2 or more, two or more groups represented by *-[(L₁)_{b1}-(R₁)_{c1}] may be identical to or different from each other, when a2 is 2 or more, two or more groups represented by *-[(L₂)_{b2}-(R₂)_{c2}] may be identical to or different from each other, when a3 is 2 or more, two or more groups represented by *-[(L₃)_{b3}-(R₃)_{c3}] may be identical to or different from each other, when a4 is 2 or more, two or more groups represented by *-[(L₄)_{b4}-(R₁)_{c4}] may be identical to or different from each other, when e1 is 2 or more, two or more Z₁ may be identical to or different from each other, when e2 is 2 or more, two or more Z₂ may be identical to or different from each other, when e3 is 2 or more, two or more Z₃ may be identical to or different from each other, when e4 is 2 or more, two or more Z₄ may be identical to or different from each other, when d1 is 2 or more, two or more groups represented by *-[W₁-(Z₁)ₑ₁] may be identical to or different from each other, when d2 is 2 or more, two or more groups represented by*-[W₂-(Z₂)ₑ₂] may be identical to or different from each other, when d3 is 2 or more, two or more groups represented by *-[W₃-(Z₃)ₑ₃] may be identical to or different from each other, and when d4 is 2 or more, two or more groups represented by *-[W₄-(Z₄)ₑ₁] may be identical to or different from each other. For example, c1 to c4, a1 to a4, e1 to e4, and d1 to d4 in Formulae 1, 2-1, and 2-2 may each independently be 0, 1, 2, or 3.

In an embodiment, each of the first dopant and the second dopant may not be tris[2-phenylpyridine]iridium.

In an embodiment, a case where, in Formula 2-1, Y₁ is N, ring A₁ is a pyridine group, Y₂ is C, ring A₂ is a benzene group, and each of d1 and d2 is 0 may be excluded.

In Formulae 1, 2-1, and 2-2, at least one of i) two or more of a plurality of R₁, ii) two or more of a plurality of R₂, iii) two or more of a plurality of R₃, iv) two or more of a plurality of R₄, v) R₅ₐ and R_{5b}, vi) two or more of a plurality of Z₁, vii) two or more of a plurality of Z₂, viii) two or more of a plurality of Z₃, ix) two or more of a plurality of Z₄, x) two or more of R₁ to R₄, R₅ₐ, and R_{5b}, and xi) two or more of Z₁ to Z₄ may optionally be bonded to each other to form a C₅-C₃₀ carbocyclic group that is unsubstituted or substituted with at least one R₁₀ₐ or a C₁-C₃₀ heterocyclic group that is unsubstituted or substituted with at least one R₁₀ₐ.

For example, in Formulae 1, 2-1, and 2-2, i) two or more of a plurality of R₁ may optionally be bonded to each other to form a C₅-C₃₀ carbocyclic group that is unsubstituted or substituted with at least one R₁₀ₐ or a C₁-C₃₀ heterocyclic group that is unsubstituted or substituted with at least one R₁₀ₐ, ii) two or more of a plurality of R₂ may optionally be bonded to each other to form a C₅-C₃₀ carbocyclic group that is unsubstituted or substituted with at least one R₁₀ₐ or a C₁-C₃₀ heterocyclic group that is unsubstituted or substituted with at least one R₁₀ₐ, iii) two or more of a plurality of R₃ may optionally be bonded to each other to form a C₅-C₃₀ carbocyclic group that is unsubstituted or substituted with at least one R₁₀ₐ or a C₁-C₃₀ heterocyclic group that is unsubstituted or substituted with at least one R₁₀ₐ, iv) two or more of a plurality of R₄ may optionally be bonded to each other to form a C₅-C₃₀ carbocyclic group that is unsubstituted or substituted with at least one R₁₀ₐ or a C₁-C₃₀ heterocyclic group that is unsubstituted or substituted with at least one R₁₀ₐ, v) R₅ₐ and R_{5b} may optionally be bonded to each other to form a C₅-C₃₀ carbocyclic group that is unsubstituted or substituted with at least one R₁₀ₐ or a C₁-C₃₀ heterocyclic group that is unsubstituted or substituted with at least one R₁₀ₐ, vi) two or more of a plurality of Z₁ may optionally be bonded to each other to form a Cs-C₃₀ carbocyclic group that is unsubstituted or substituted with at least one R₁₀ₐ or a C₁-C₃₀ heterocyclic group that is unsubstituted or substituted with at least one R₁₀ₐ, vii) two or more of a plurality of Z₂ may optionally be bonded to each other to form a C₅-C₃₀ carbocyclic group that is unsubstituted or substituted with at least one R₁₀ₐ or a C₁-C₃₀ heterocyclic group that is unsubstituted or substituted with at least one R₁₀ₐ, viii) two or more of a plurality of Z₃ may optionally be bonded to each other to form a C₅-C₃₀ carbocyclic group that is unsubstituted or substituted with at least one R₁₀ₐ or a C₁-C₃₀ heterocyclic group that is unsubstituted or substituted with at least one R₁₀ₐ, ix) two or more of a plurality of Z₄ may optionally be bonded to each other to form a C₅-C₃₀ carbocyclic group that is unsubstituted or substituted with at least one R₁₀ₐ or a C₁-C₃₀ heterocyclic group that is unsubstituted or substituted with at least one R₁₀ₐ, x) two or more of R₁ to R₄, R₅ₐ, and R_{5b} may optionally be bonded to each other to form a C₅-C₃₀ carbocyclic group that is unsubstituted or substituted with at least one R₁₀ₐ or a C₁-C₃₀ heterocyclic group that is unsubstituted or substituted with at least one R₁₀ₐ, and/or xi) two or more of Z₁ to Z₄ may optionally be bonded to each other to form a C₅-C₃₀ carbocyclic group that is unsubstituted or substituted with at least one R₁₀ₐ or a C₁-C₃₀ heterocyclic group that is unsubstituted or substituted with at least one R₁₀ₐ.

R₁₀ₐ may be the same as described in connection with R₁.

* and *' as used herein each indicate a binding site to a neighboring atom, unless otherwise stated.

In an embodiment, in Formula 1, n1 may not be 0, n4 may be 0, and a group represented by 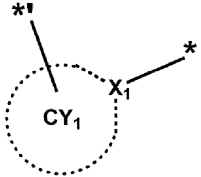 may be a group represented by one of Formulae CY1(1) to CY1(23): 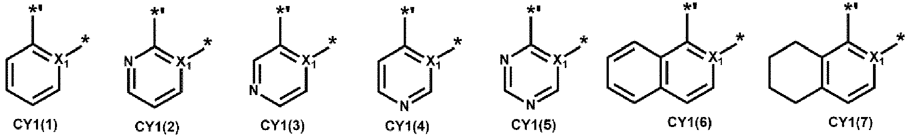 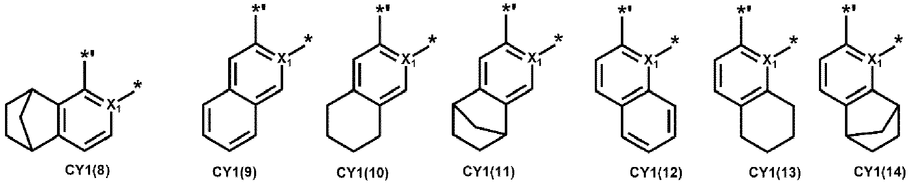 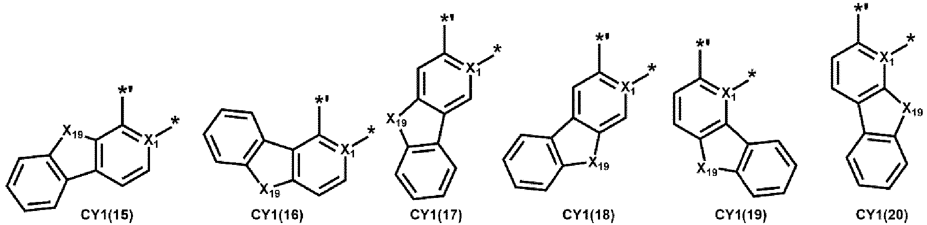 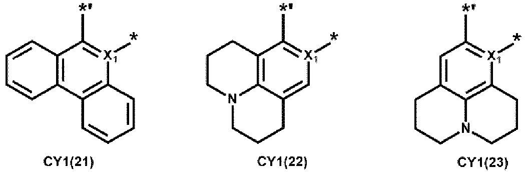 wherein, in Formulae CY1(1) to CY1(23),
X₁ may be the same as described in the present specification,
X₁₉ may be O, S, Se, N(R₁₉ₐ), C(R₁₉ₐ)(R_{19b}), or Si(R₁₉ₐ)(R_{19b}),
R₁₉ₐ and R_{19b} may each be the same as described in connection with R₁,
* may indicate a binding site to X₅ or M₁ in Formula 1, and
*' may indicate a binding site to T₁₁ in Formula 1.

In an embodiment, in Formula 1, n1 may be 1, n4 may be 0, and a group represented by 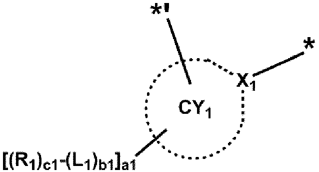 may be a group represented by one of Formulae CY1-1 to CY1-18: 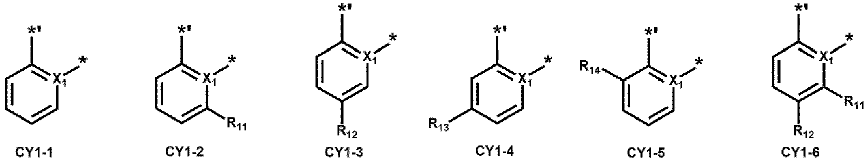 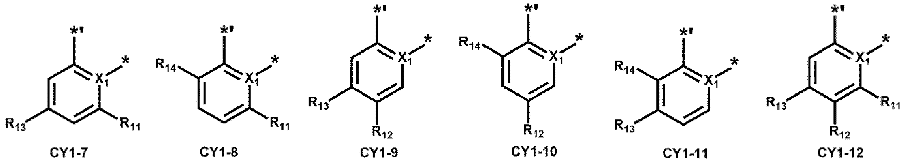 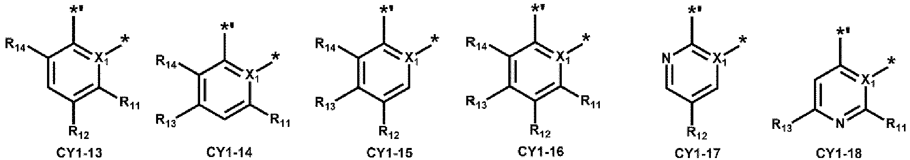 wherein, in Formulae CY1-1 to CY1-18,
X₁ may be the same as described in the present specification,
R₁₁ to R₁₄ may each be the same as described in connection with R₁, wherein each of R₁₁ to R₁₄ is not hydrogen,
* may indicate a binding site to X₅ or M₁ in Formula 1, and
*' may indicate a binding site to T₁₁ in Formula 1.

In an embodiment, in Formula 1, n1 and n2 may each be 1, and ring CY₂ may be a group represented by Formula CY2A or CY2B: 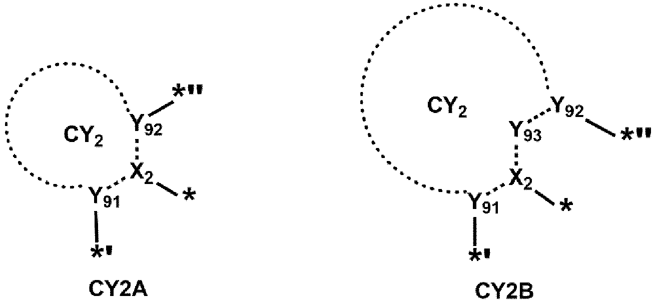 wherein, in Formulae CY2A and CY2B,
X₂ and ring CY₂ may respectively be the same as those described in the present specification,
Y₉₁ and Y₉₂ may each independently be N, C, or Si, and Y₉₃ may be O, S, N, C, or Si,
a bond between X₂ and Y₉₁, a bond between X₂ and Y₉₂, a bond between X₂ and Y₉₃, and a bond between Y₉₂ and Y₉₃ in Formulae CY2A and CY2B may each be a chemical bond,
*' may indicate a binding site to T₁₁ in Formula 1,
* may indicate a binding site to X₆ or M₁ in Formula 1, and
*" may indicate a binding site to T₁₂ in Formula 1.

In an embodiment, in Formula 1, each of n1 and n2 may not be 0, and a group represented by 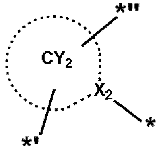 may be a group represented by one of Formulae CY2(1) to CY2(21): 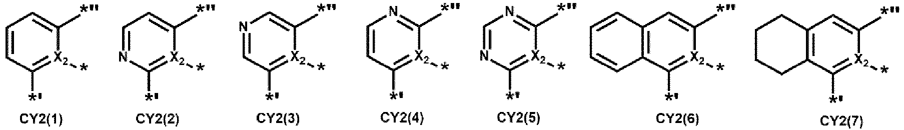 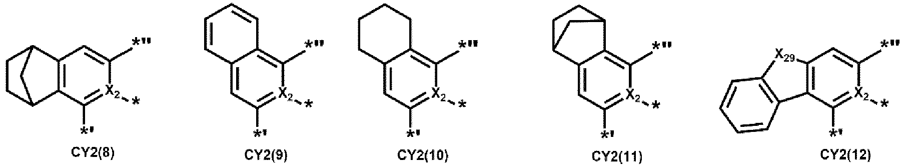 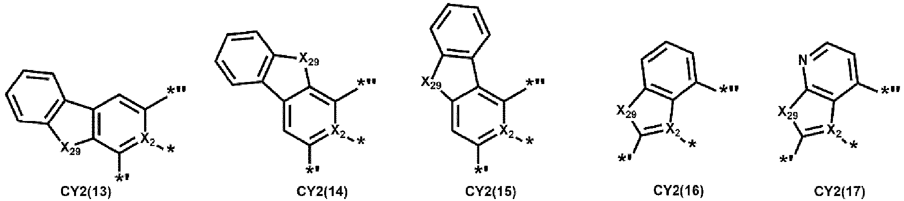 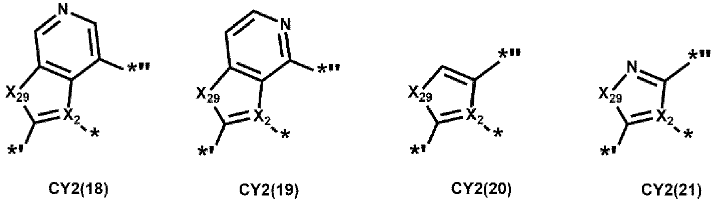 wherein, in Formulae CY2(1) to CY2(21),
X₂ may be the same as described in the present specification,
X₂₉ may be O, S, N-[(L₂)_{b2}-(R₂)_{c2}], C(R₂₉ₐ)(R_{29b}), or Si(R₂₉ₐ)(R_{29b}),
L₂, b2, R₂, and c2 may respectively be the same as those described in the present specification,
R₂₉ₐ and R_{29b} may each be the same as described in connection with R₂,
*' may indicate a binding site to T₁₁ in Formula 1,
* may indicate a binding site to X₆ or M₁ in Formula 1, and
*" may indicate a binding site to T₁₂ in Formula 1.

In an embodiment, in Formula 1, each of n1 and n2 may be 1, and a group represented by 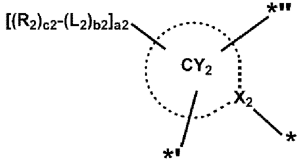 may be a group represented by one of Formulae CY2-1 to CY2-16: 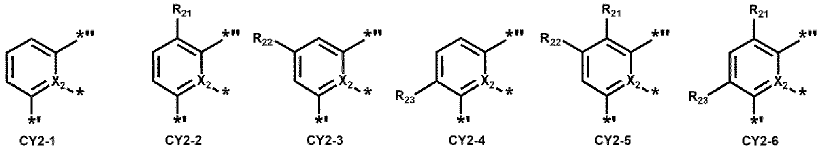 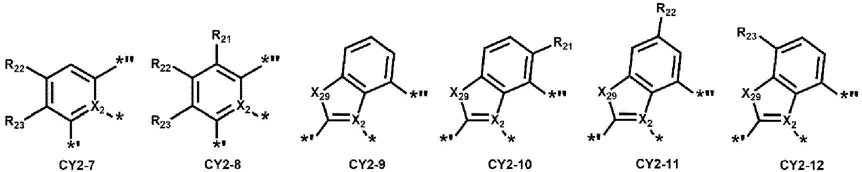 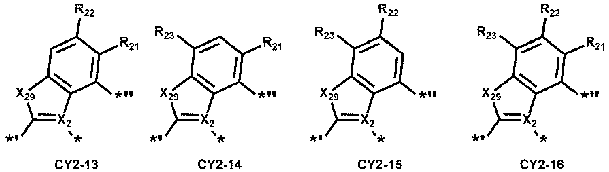 wherein, in Formulae CY2-1 to CY2-16,
X₂ may be the same as described in the present specification,
X₂₉ may be O, S, N-[(L₂)_{b2}-(R₂)_{c2}], C(R₂₉ₐ)(R_{29b}), or Si(R₂₉ₐ)(R_{29b}),
L₂, b2, R₂, and c2 may respectively be the same as those described in the present specification,
R₂₁ to R₂₃, R₂₉ₐ, and R_{29b} may each be the same as described in connection with R₂, wherein each of R₂₁ to R₂₃ is not hydrogen,
*' may indicate a binding site to T₁₁ in Formula 1,
* may indicate a binding site to X₆ or M₁ in Formula 1, and
*" may indicate a binding site to T₁₂ in Formula 1.

In an embodiment, in Formula 1,
each of n1 and n2 may be 1,
a group represented by 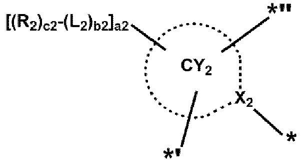 may be a group represented by one of Formulae CY2-9 to CY2-16,
X₂₉ in Formulae CY2-9 to CY2-16 may be N-[(L₂)_{b2}-(R₂)_{c2}],
L₂ may be a benzene group that is unsubstituted or substituted with at least one R₁₀ₐ,
b2 may be 1 or 2,
c2 may be 1 or 2, and
when c2 is 1, R₂ may be a phenyl group that is unsubstituted or substituted with deuterium, a C₁-C₂₀ alkyl group, a phenyl group, a deuterated phenyl group, a (C₁-C₂₀ alkyl)phenyl group, or any combination thereof, and when c2 is 2, a) one of two R₂ may be a phenyl group that is unsubstituted or substituted with deuterium, a C₁-C₂₀ alkyl group, a phenyl group, a deuterated phenyl group, a (C₁-C₂₀ alkyl)phenyl group, or any combination thereof, and b) the other R₂ may be a C₄-C₂₀ alkyl group or a deuterated C₁-C₂₀ alkyl group, each unsubstituted or substituted with a C₃-C₁₀ cycloalkyl group.

In an embodiment, in Formula 1, each of n2 and n3 may not be 0, and a group represented by 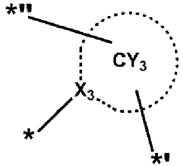 may be a group represented by one of Formulae CY3(1) to CY3(15): 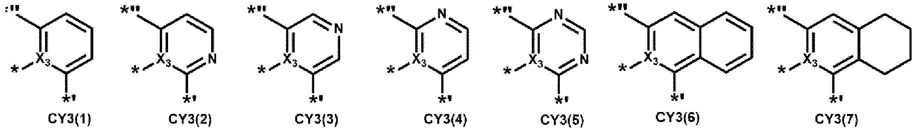 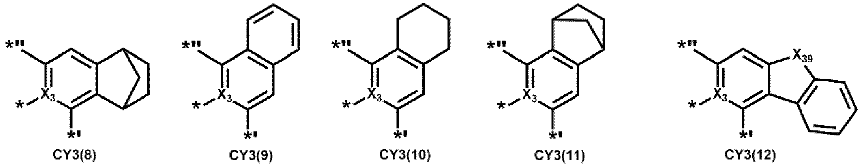 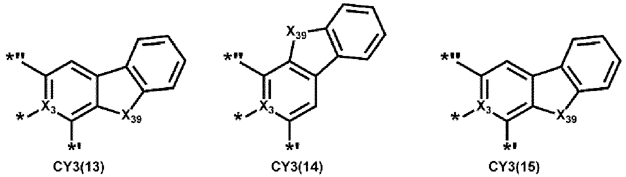 wherein, in Formulae CY3(1) to CY3(15),
X₃ may be the same as described in the present specification,
X₃₉ may be O, S, N(Z₃₉ₐ), C(R₃₉ₐ)(R_{39b}), or Si(R₃₉ₐ)(R_{39b}),
R₃₉ₐ and R_{39b} may each be the same as described in connection with R₃,
*" may indicate a binding site to T₁₂ in Formula 1,
* may indicate a binding site to X₇ or M₁ in Formula 1, and
*' may indicate a binding site to T₁₃ in Formula 1.

In an embodiment, in Formula 1, each of n2 and n3 may be 1, and a group represented by 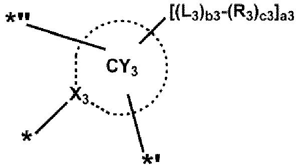 may be represented by one of Formulae CY3-1 to CY3-13: 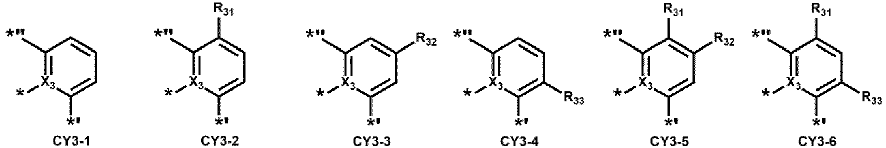 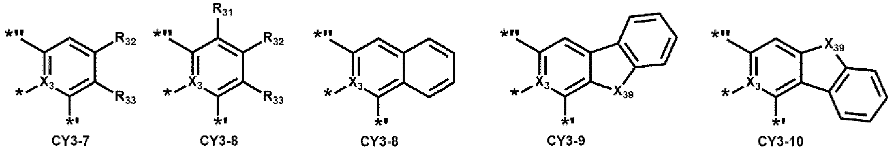 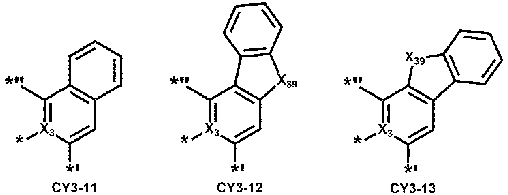 wherein, in Formulae CY3-1 to CY3-13,
X₃ may be the same as described in the present specification,
X₃₉ may be O, S, N-[(L₃)_{b3}-(R₃)_{c3}], C(R₃₉ₐ)(R_{39b}), or Si(R₃₉ₐ)(R_{39b}),
L₃, b3, R₃, and c3 may respectively be the same as those described in the present specification,
R₃₁ to R₃₃, R₃₉ₐ, and R_{39b} may each be the same as described in connection with R₃, wherein each of R₃₁ to R₃₃ is not hydrogen,
*" may indicate a binding site to T₁₂ in Formula 1,
* may indicate a binding site to X₇ or M₁ in Formula 1, and
*' may indicate a binding site to T₁₃ in Formula 1.

In an embodiment, in Formula 1, n3 may not be 0, n4 may be 0, and a group represented by 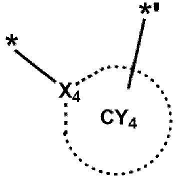 may be represented by one of Formulae CY4(1) to CY4(20): 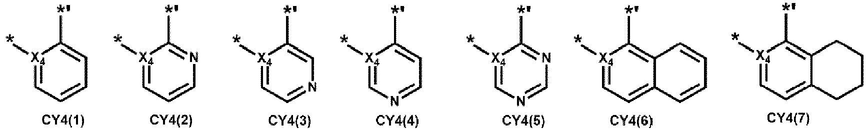 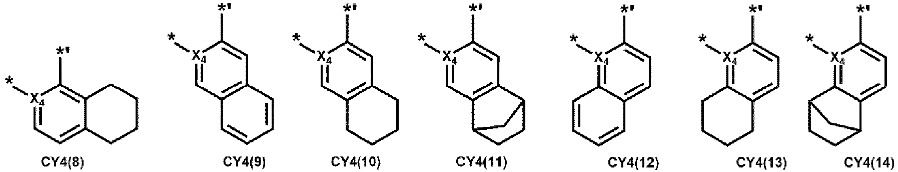 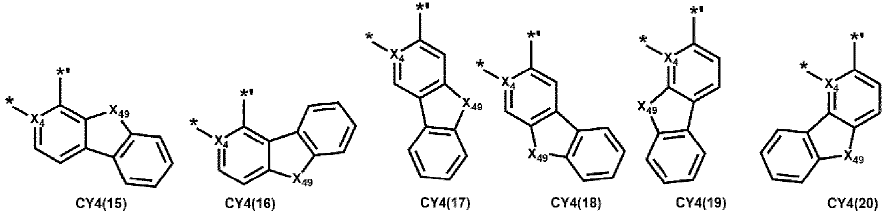 wherein, in Formulae CY4(1) to CY4(20),
X₄ may be the same as described in the present specification,
X₄₉ may be O, S, N(R₄₉ₐ), C(R₄₉ₐ)(R_{49b}), or Si(R₄₉ₐ)(R_{49b}),
R₄₉ₐ and R_{49b} may each be the same as described in connection with R₄,
*' may indicate a binding site to T₁₃ in Formula 1, and
* may indicate a binding site to X₈ or M₁ in Formula 1.

In an embodiment, in Formula 1, n3 may be 1, n4 may be 0, and a group represented by 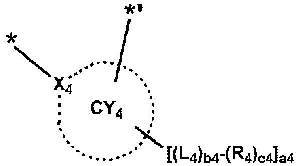 may be a group represented by one of Formulae CY4-1 to CY4-16: 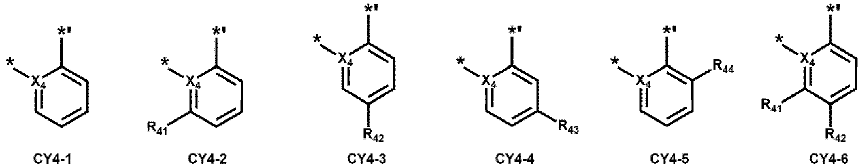 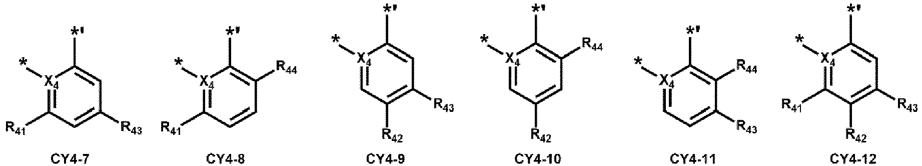 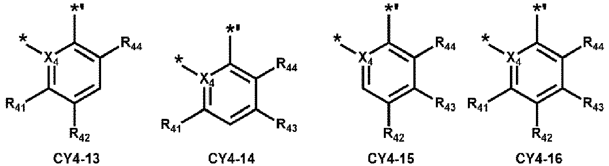 wherein, in Formulae CY4-1 to CY4-16,
X₄ may be the same as described in the present specification,
R₄₁ to R₄₄ may each be the same as described in connection with R₄, wherein each of R₄₁ to R₄₄ is not hydrogen,
*' may indicate a binding site to T₁₃ in Formula 1, and
* may indicate a binding site to X₈ or M₁ in Formula 1.

In an embodiment, the organometallic compound represented by Formula 1 may be a compound represented by one of Formulae 1-1 to 1-3: 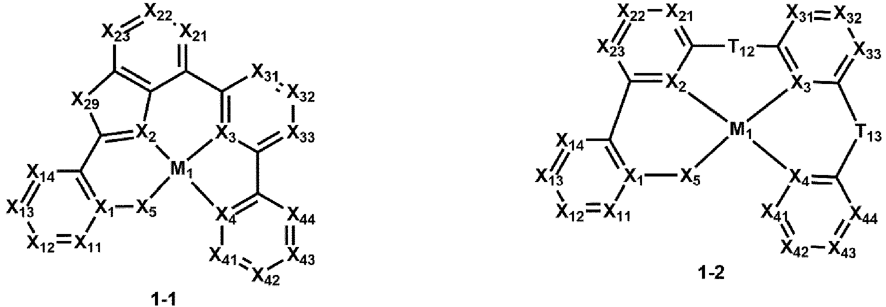 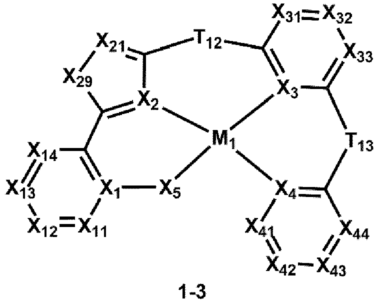 wherein, in Formulae 1-1 to 1-3,
M₁, X₁ to X₅, T₁₂, and T₁₃ may respectively be the same as those described in the present specification,
X₁₁ may be N or C(R₁₁), X₁₂ may be N or C(R₁₂), X₁₃ may be N or C(R₁₃), and X₁₄ may be N or C(R₁₄),
R₁₁ to R₁₄ may each be the same as described in connection with R₁, or
two or more of R₁₁ to R₁₄ may optionally be bonded to each other to form a C₅-C₃₀ carbocyclic group that is unsubstituted or substituted with at least one R₁₀ₐ or a C₁-C₃₀ heterocyclic group that is unsubstituted or substituted with at least one R₁₀ₐ,
X₂₁ may be N or C(R₂₁), X₂₂ may be N or C(R₂₂), and X₂₃ may be N or C(R₂₃),
X₂₉ may be O, S, N-[(L₂)_{b2}-(R₂)_{c2}], C(R₂₉ₐ)(R_{29b}), or Si(R₂₉ₐ)(R_{29b}),
L₂, b2, R₂, and c2 may respectively be the same as those described in the present specification,
R₂₁ to R₂₃, R₂₉ₐ, and R_{29b} may each be the same as described in connection with R₂, or
two or more of R₂₁ to R₂₃ may optionally be bonded to each other to form a C₅-C₃₀ carbocyclic group that is unsubstituted or substituted with at least one R₁₀ₐ or a C₁-C₃₀ heterocyclic group that is unsubstituted or substituted with at least one R₁₀ₐ,
X₃₁ may be N or C(R₃₁), X₃₂ may be N or C(R₃₂), and X₃₃ may be N or C(R₃₃),
R₃₁ to R₃₃ may each be the same as described in connection with R₃, or
two or more of R₃₁ to R₃₃ may optionally be bonded to each other to form a C₅-C₃₀ carbocyclic group that is unsubstituted or substituted with at least one R₁₀ₐ or a C₁-C₃₀ heterocyclic group that is unsubstituted or substituted with at least one R₁₀ₐ,
X₄₁ may be N or C(R₄₁), X₄₂ may be N or C(R₄₂), X₄₃ may be N or C(R₄₃), and X₄₄ may be N or C(R₄₄),
R₄₁ to R₄₄ may each be the same as described in connection with R₄, or
two or more of R₄₁ to R₄₄ may optionally be bonded to each other to form a C₅-C₃₀ carbocyclic group that is unsubstituted or substituted with at least one R₁₀ₐ or a C₁-C₃₀ heterocyclic group that is unsubstituted or substituted with at least one R₁₀ₐ.

In an embodiment, Y₁ in Formula 2-1 may be N, and
a group represented by 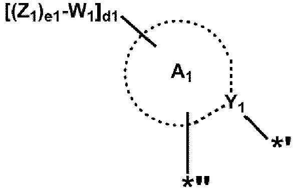 in Formula 2-1 may be a group represented by one of Formulae A1-1 to A1-3: 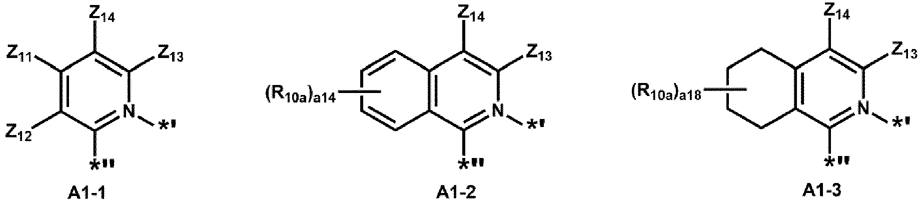 wherein, in Formulae A1-1 to A1-3,
Z₁₁ to Z₁₄ may each be the same as described in connection with Z₁,
R₁₀ₐ may be the same as described in the present specification,
a14 may be an integer from 0 to 4,
a18 may be an integer from 0 to 8,
*' may indicate a binding site to M₂ in Formula 2, and
*" may indicate a binding site to ring A₂.

For example, at least one of Z₁₁, Z₁₂, and Z₁₄ (for example, Z₁₄) in Formulae A1-1 to A1-3 may be:
a C₁-C₂₀ alkyl group that is unsubstituted or substituted with deuterium, -F, a phenyl group, or any combination thereof;

-Si(Q₃)(Q₄)(Q₅); or

-Ge(Q₃)(Q₄)(Q₅).

In an embodiment, Y₃ in Formula 2-2 may be N, and
a group represented by 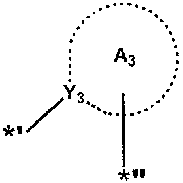 in Formula 2-2 may be a group represented by one of Formulae NR1 to NR48: 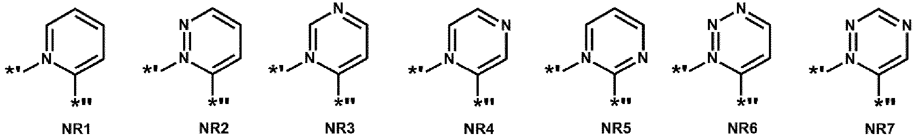 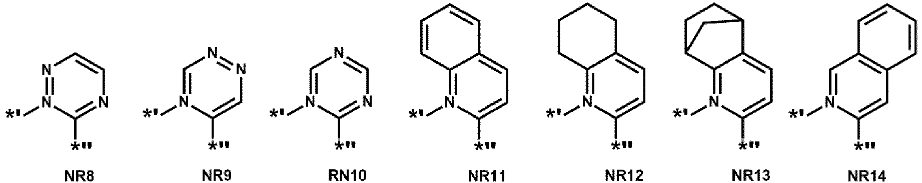 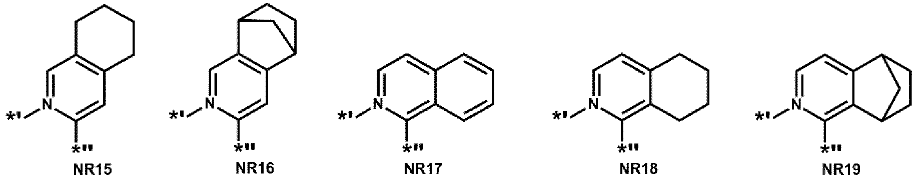 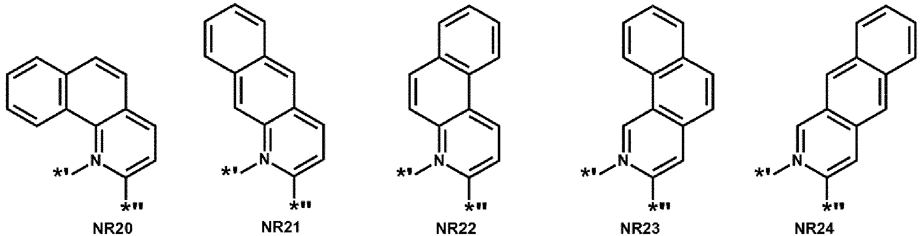 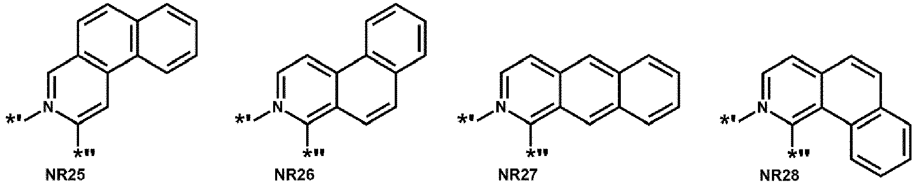 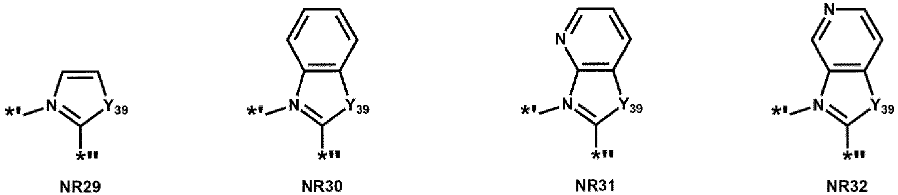 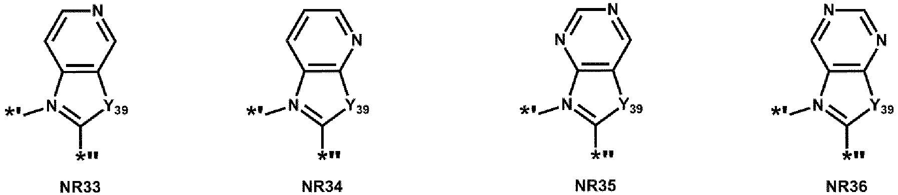 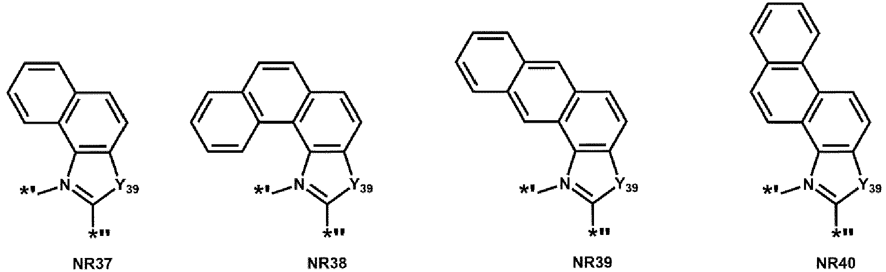 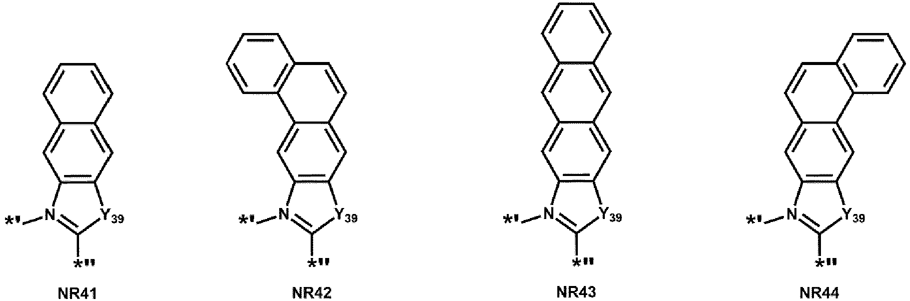 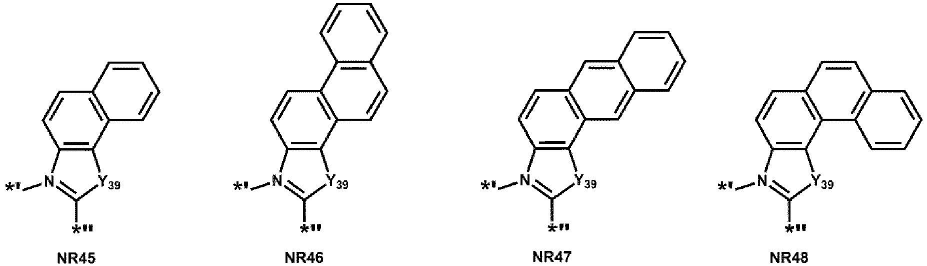 wherein, in Formulae NR1 to NR48,
Y₃₉ may be O, S, Se, N-[W₃-(Z₃)ₑ₃], C(Z₃₉ₐ)(Z_{39b}), or Si(Z₃₉ₐ)(Z_{39b}),W₃, Z₃, and e3 may respectively be the same as those described in the present specification, and Z₃₉ₐ and Z_{39b} may each be the same as described in connection with Z₃,
*' may indicate a binding site to M₂ in Formula 2, and
*" may indicate a binding site to ring A₄.

In an embodiment, each of Y₂ and Y₄ in Formulae 2-1 and 2-2 may be C, and
a group represented by 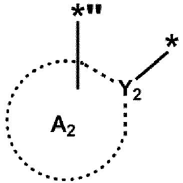 in Formula 2-1 and a group represented by 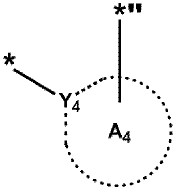 in Formula 2-2 may each independently be a group represented by one of Formulae CR1 to CR29: 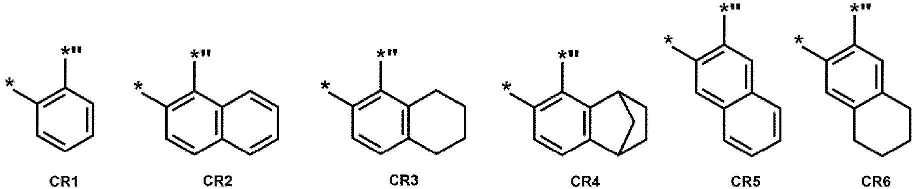 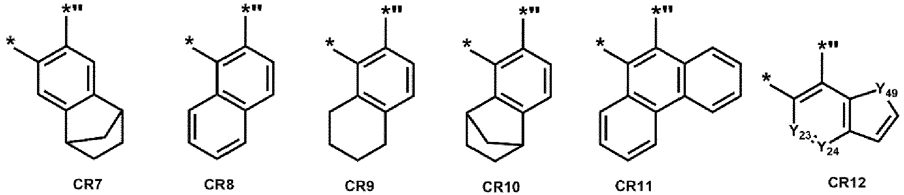 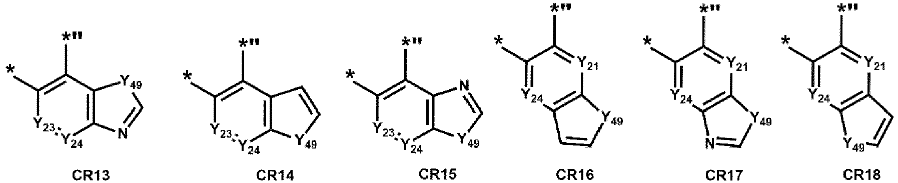 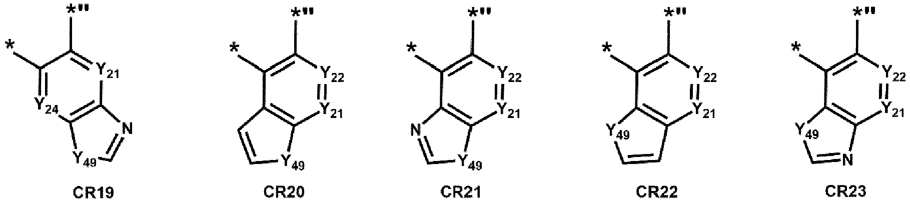 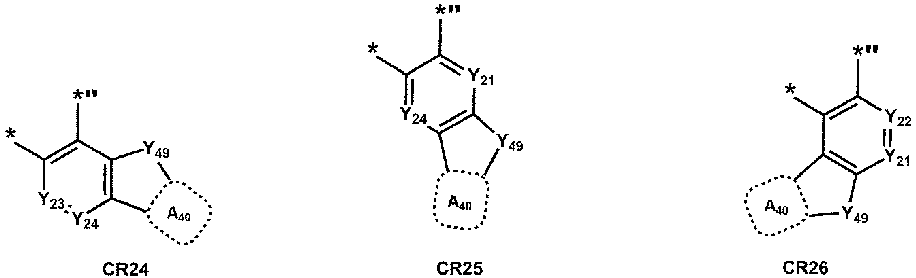 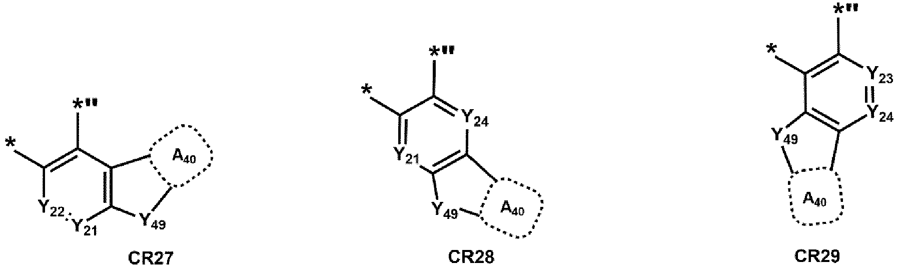 wherein, in Formulae CR1 to CR29,
Y₄₉ may be O, S, Se, N-[W₂-(Z₂)ₑ₂], N-[W₄-(Z₄)ₑ₄], C(Z₂₉ₐ)(Z_{29b}), C(Z₄₉ₐ)(Z_{49b}), Si(Z₂₉ₐ)(Z_{29b}), or Si(Z₄₉ₐ)(Z_{49b}),
W₂, W₄, Z₂, Z₄, e2, and e4 may respectively be the same as those described in the present specification, Z₂₉ₐ and Z_{29b} may each be the same as described in connection with Z₂, and Z₄₉ₐ and Z_{49b} may each be the same as described in connection with Z₄,
Y₂₁ to Y₂₄ may each independently be N or C,
ring A₄₀ may be a C₅-C₃₀ carbocyclic group or a C₁-C₃₀ heterocyclic group (for example, a benzene group, a naphthalene group, an anthracene group, a phenanthrene group, a pyridine group, a pyrimidine group, a pyrazine group, a pyridazine group, a quinoline group, an isoquinoline group, a benzoquinoline group, a benzoisoquinoline group, a quinoxaline group, a benzoquinoxaline group, a quinazoline group, or a benzoquinazoline group),
* may indicate a binding site to M₂ in Formula 2, and
*" may indicate a binding site to ring A₁ or ring A₃.

In an embodiment,
a group represented by 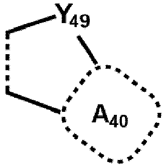 in Formulae CR24 to CR29 may be a group represented by one of Formulae CR(1) to CR(13): 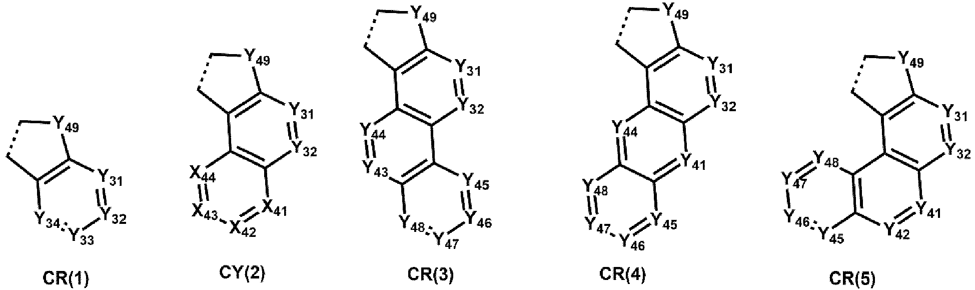 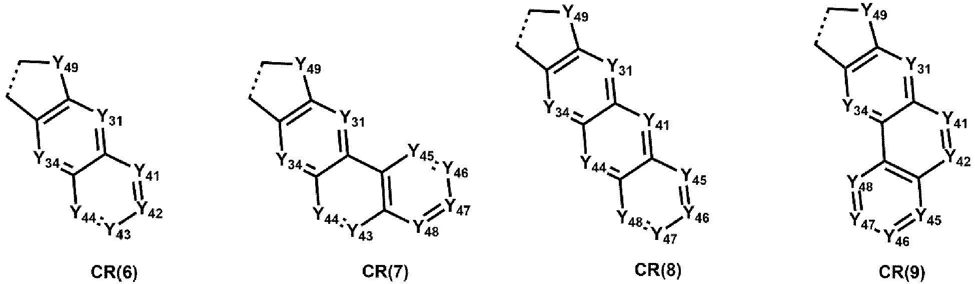 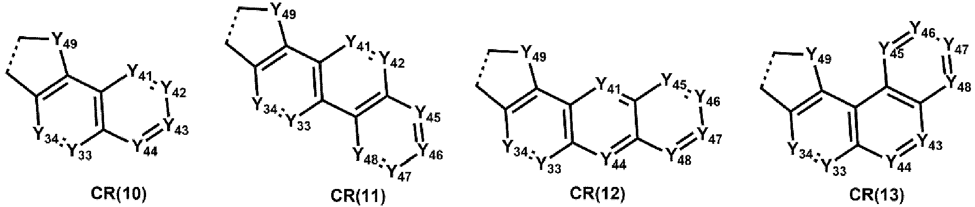 wherein, in Formulae CR(1) to CR(13),
Y₄₉ may be the same as described in the present specification, and
Y₃₁ to Y₃₄ and Y₄₁ to Y₄₈ may each independently be C or N.

In an embodiment, the first dopant may include at least one deuterium.

In an embodiment, the second dopant may include at least one deuterium.

For example, the first dopant and the second dopant may each independently be selected from a compound represented by Formula 1-1(1), a compound represented by Formula 1-2(1), and a compound represented by Formula 2A: 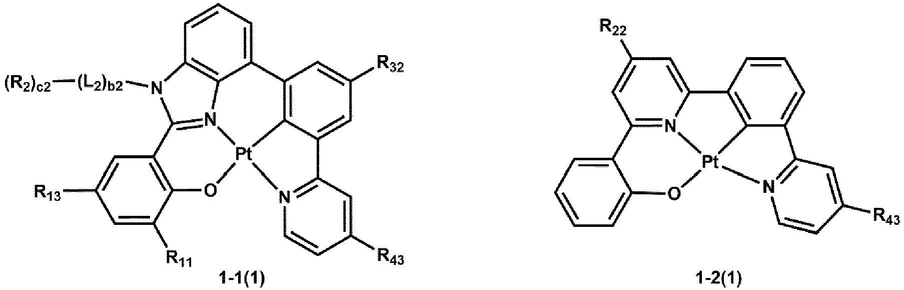 wherein, in Formulae 1-1(1) and 1-2(1),
R₁₁ and R₁₃ may each independently be a C₁-C₁₀ alkyl group that is unsubstituted or substituted with deuterium,
L₂ may be a benzene group that is unsubstituted or substituted with deuterium, a C₁-C₁₀ alkyl group, a C₃-C₁₀ cycloalkyl group, a phenyl group, a biphenyl group, or any combination thereof,
b2 may be 1 or 2,
c2 may be 0, 1, or 2,
R₂ and R₃₂ may each independently be:
   a C₁-C₁₀ alkyl group that is unsubstituted or substituted with deuterium, a C₃-C₁₀ cycloalkyl group, or any combination thereof; or
   a phenyl group that is unsubstituted or substituted with deuterium, a C₁-C₁₀ alkyl group, a C₃-C₁₀ cycloalkyl group, a phenyl group, a biphenyl group, or any combination thereof, and
   R₂₂ and R₄₃ may each independently be a phenyl group that is unsubstituted or substituted with deuterium, a C₁-C₁₀ alkyl group, a C₃-C₁₀ cycloalkyl group, a phenyl group, a biphenyl group, or any combination thereof:

      Formula 2A Ir(L₁₁)ₙ₁₁(L₁₂)ₙ₁₂

      wherein, in Formula 2A,
      n11 may be 0, 1, or 2, n12 may be 1, 2, or 3, and n11 + n12 may be 3,
      L₁₁ may be a ligand represented by Formula 2-1, and L₁₂ may be a ligand represented by Formula 2-2, 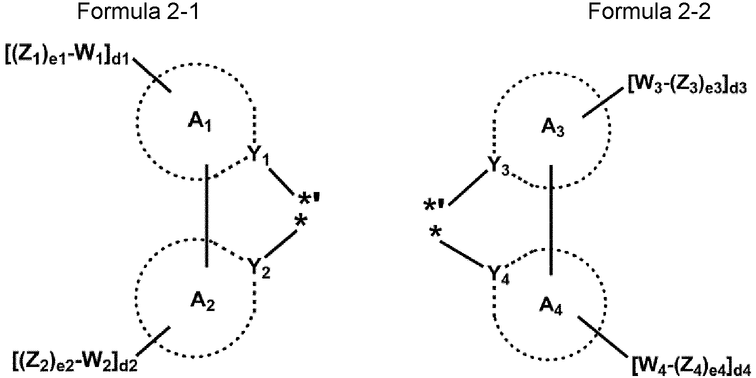
      a group represented by 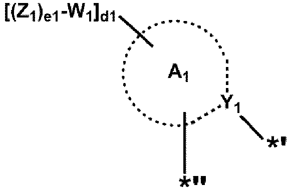 in Formula 2-1 may be a group represented by Formula A1-1,
      a group represented by 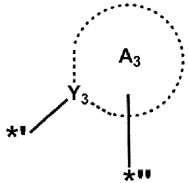 in Formula 2-2 may be a group represented by one of Formulae NR1, NR29, NR30, and NR37 to NR48,
      a group represented by 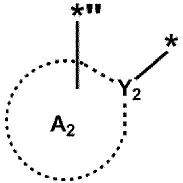 in Formula 2-1 may be a group represented by one of Formulae CR1, CR2, CR5, CR8, and CR24 to CR29,
      a group represented by 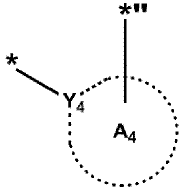 in Formula 2-2 may be a group represented by one of Formulae CR24 to CR29,
      W₂ to W₄ in Formula 2A may each independently be:
         a single bond; or
         a benzene group that is unsubstituted or substituted with deuterium, -F, a C₁-C₁₀ alkyl group, a C₃-C₁₀ cycloalkyl group, a phenyl group, a biphenyl group, or any combination thereof,
         Z₁₁ to Z₁₄ in Formula A1-1 and Z₂ to Z₄ in Formula 2A may each independently be hydrogen, deuterium, or -F;
         a C₁-C₁₀ alkyl group that is unsubstituted or substituted with deuterium, -F, a phenyl group, or any combination thereof;
         a phenyl group that is unsubstituted or substituted with deuterium, -F, a C₁-C₁₀ alkyl group, a phenyl group, or any combination thereof;

            -Si(Q₃)(Q₄)(Q₅); or

            -Ge(Q₃)(Q₄)(Q₅),
         Q₃ to Q₅ may each be a C₁-C₁₀ alkyl group or a deuterated C₁-C₁₀ alkyl group, and
         e2 to e4 and d2 to d4 may each independently be 0, 1, 2 or 3.

The C₁-C₁₀ alkyl group may include, for example, a methyl group, an ethyl group, an n-propyl group, an iso-propyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an iso-hexyl group, a sec-hexyl group, a tert-hexyl group, an n-heptyl group, an iso-heptyl group, a sec-heptyl group, a tert-heptyl group, an n-octyl group, an iso-octyl group, a sec-octyl group, a tert-octyl group, an n-nonyl group, an iso-nonyl group, a sec-nonyl group, a tert-nonyl group, an n-decyl group, an iso-decyl group, a sec-decyl group, and a tert-decyl group.

The C₃-C₁₀ cycloalkyl group may include a cyclopentyl group, a cyclohexyl group, a cycloheptyl group, a cyclooctyl group, an adamantanyl group, a norbornanyl group (or, a bicyclo[2.2.1]heptyl group), a bicyclo[1.1.1]pentyl group, a bicyclo[2.1.1]hexyl group, and a bicyclo[2.2.2]octyl group.

As another example, the first dopant and the second dopant may each independently be selected from compounds of Group 1-1 to Group 1-4 and compounds of Group 2-1 to Group 2-7:

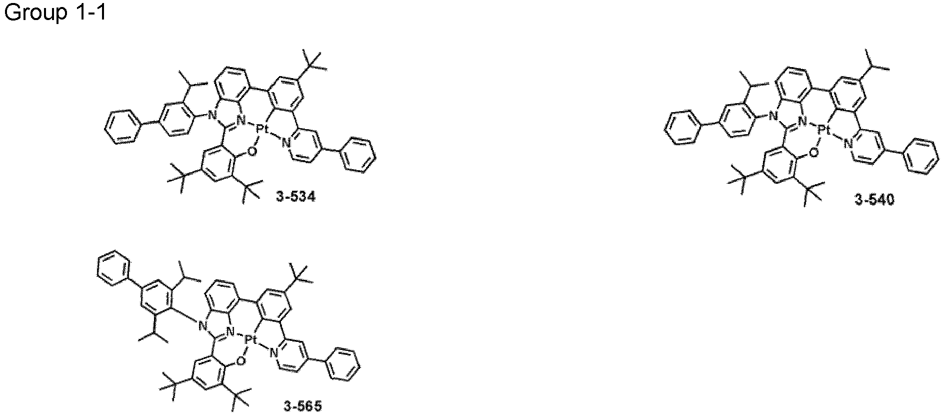

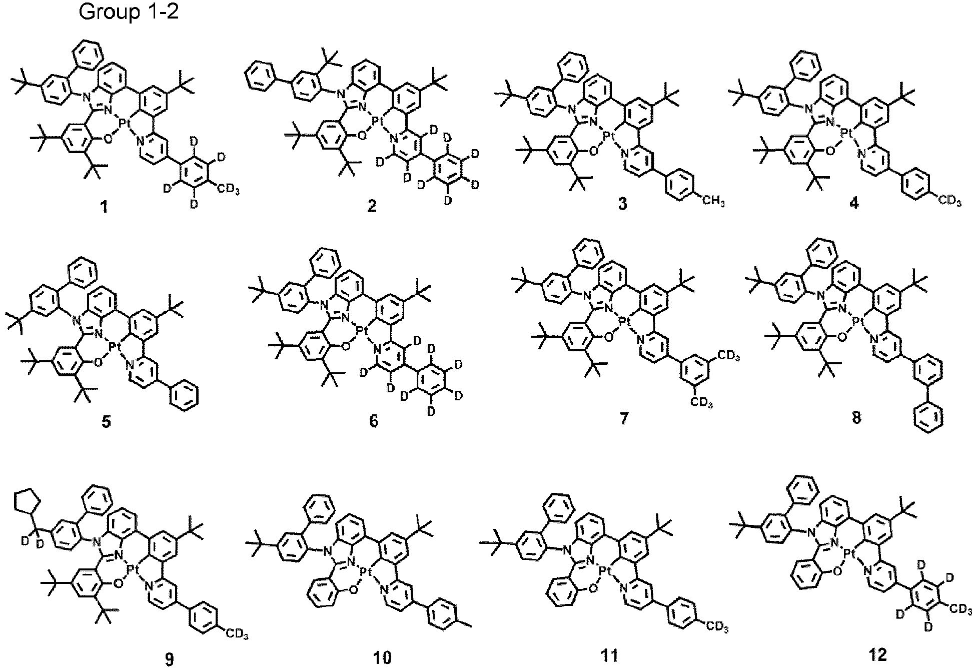

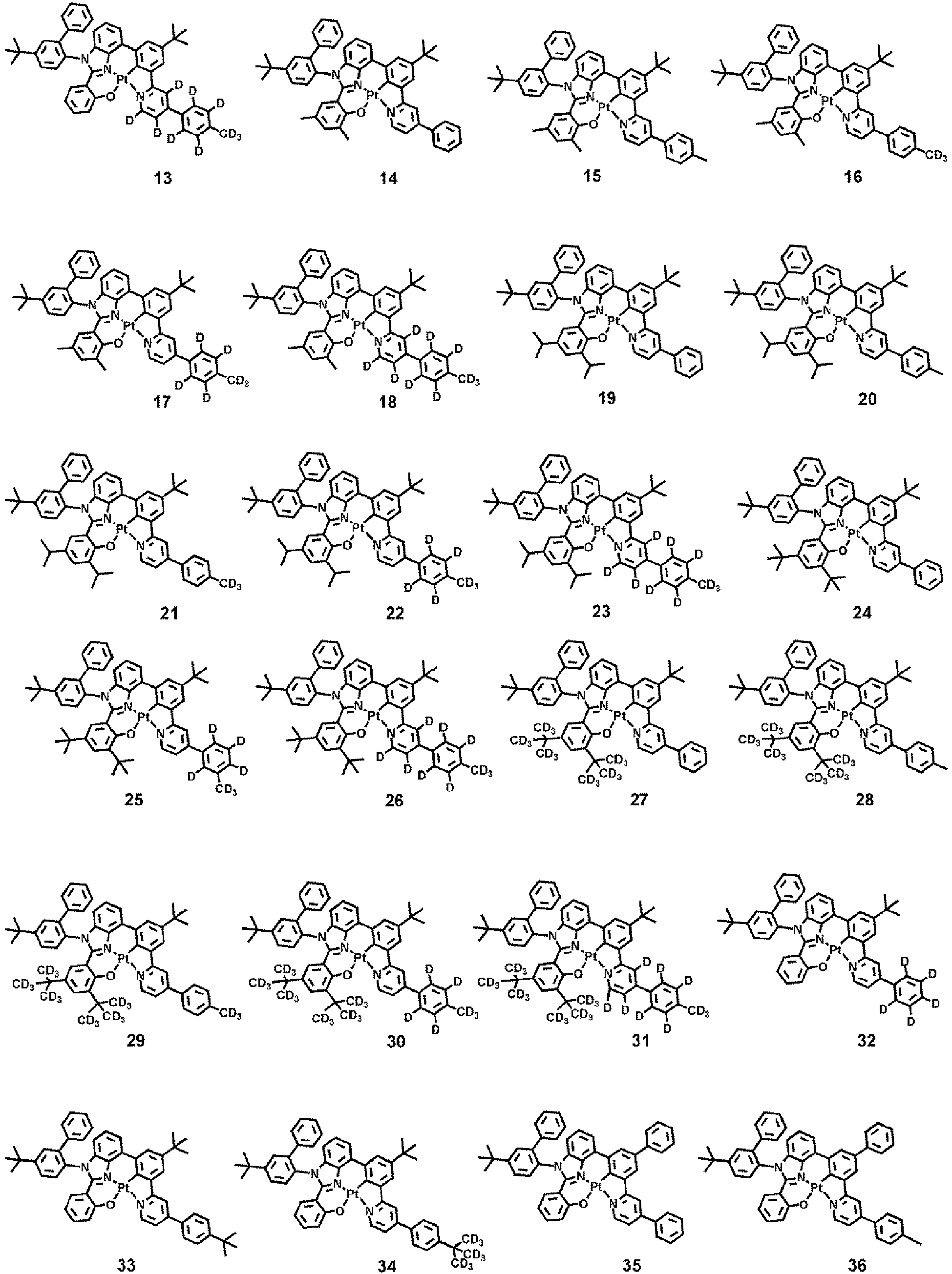

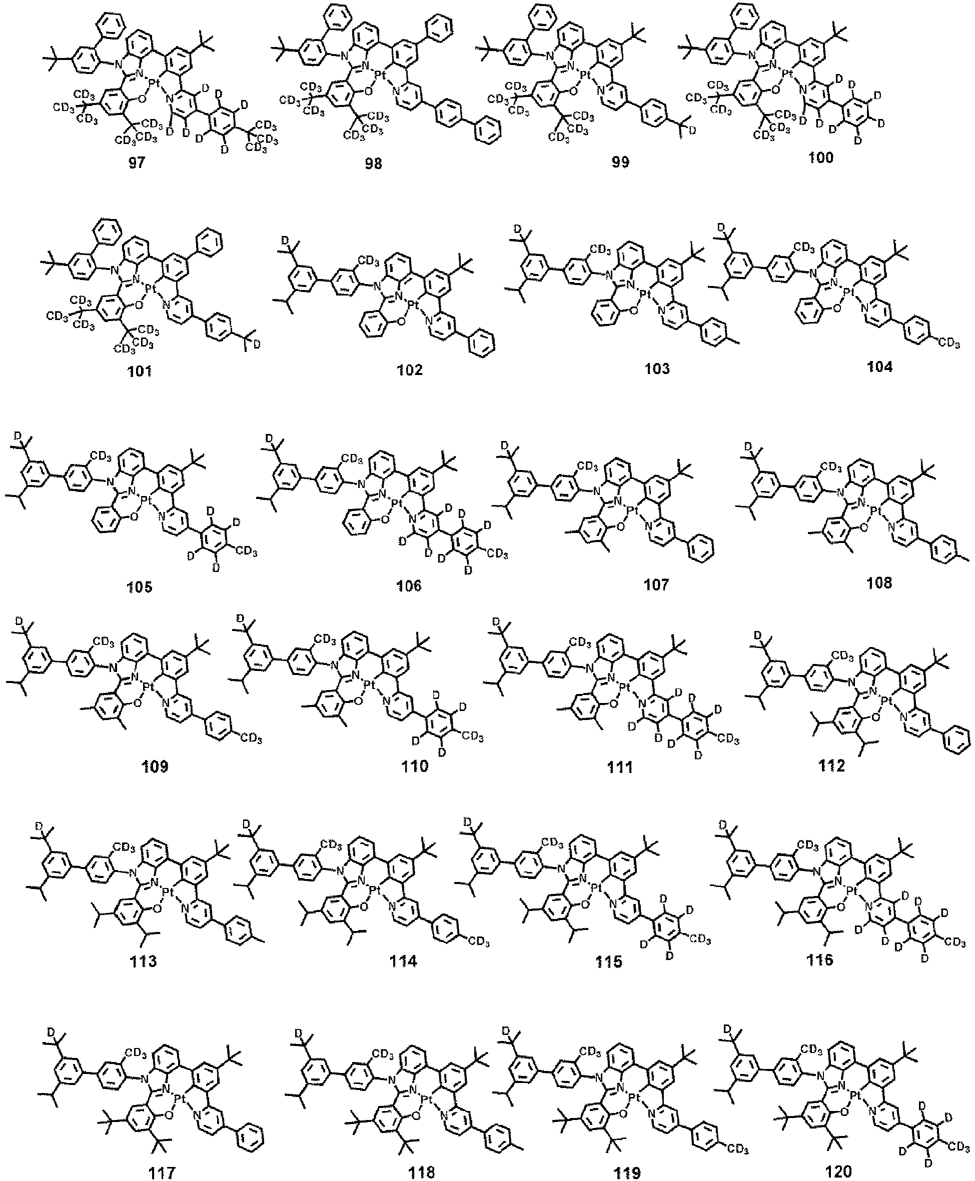

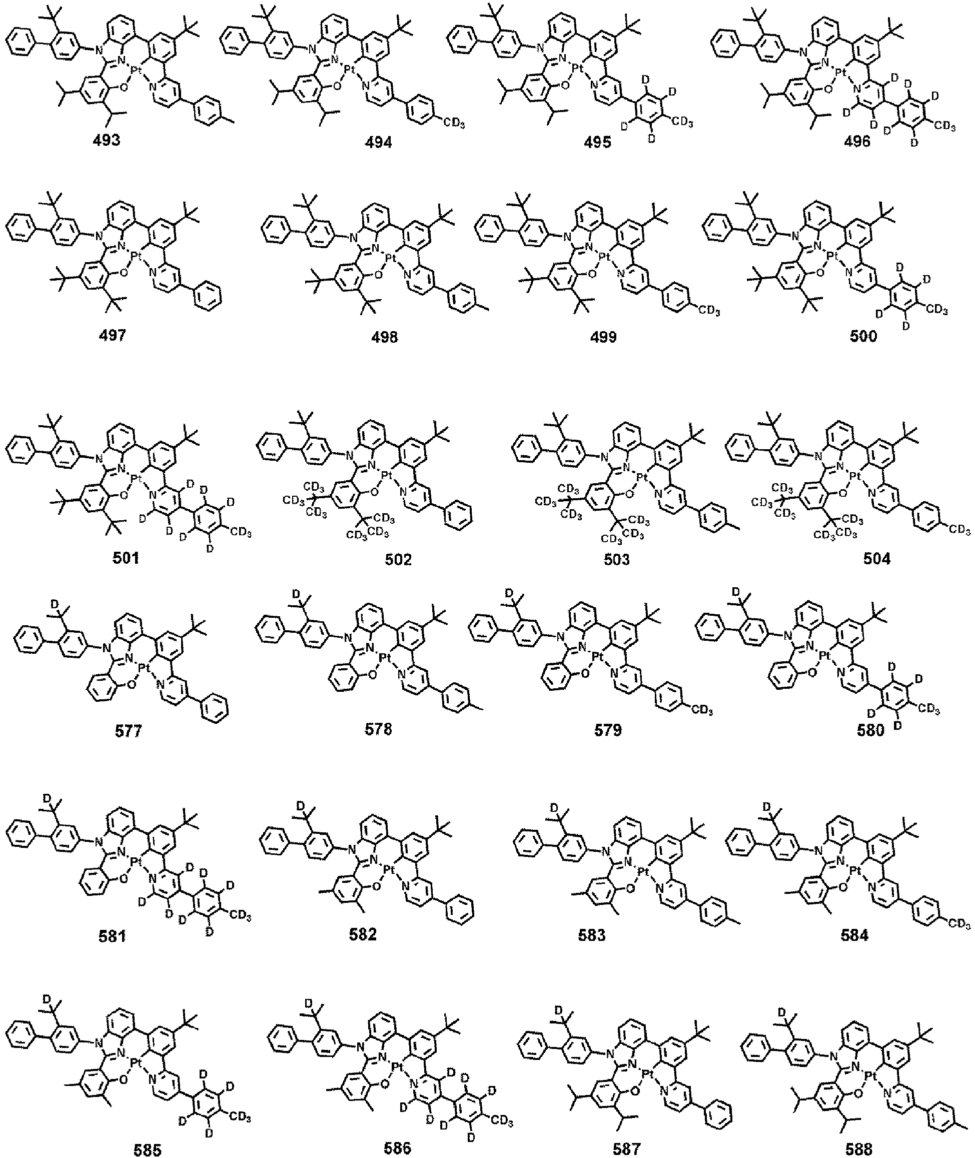

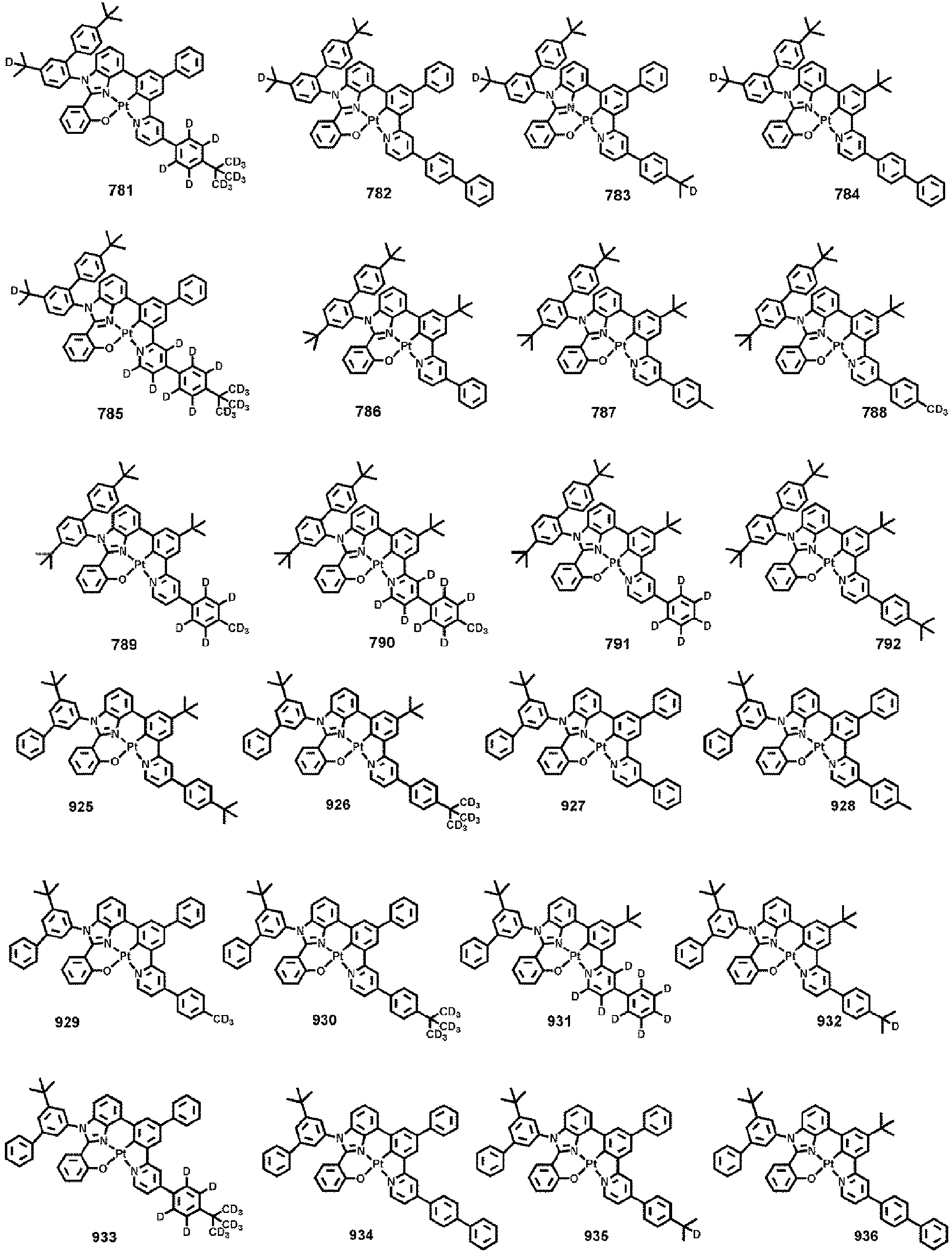

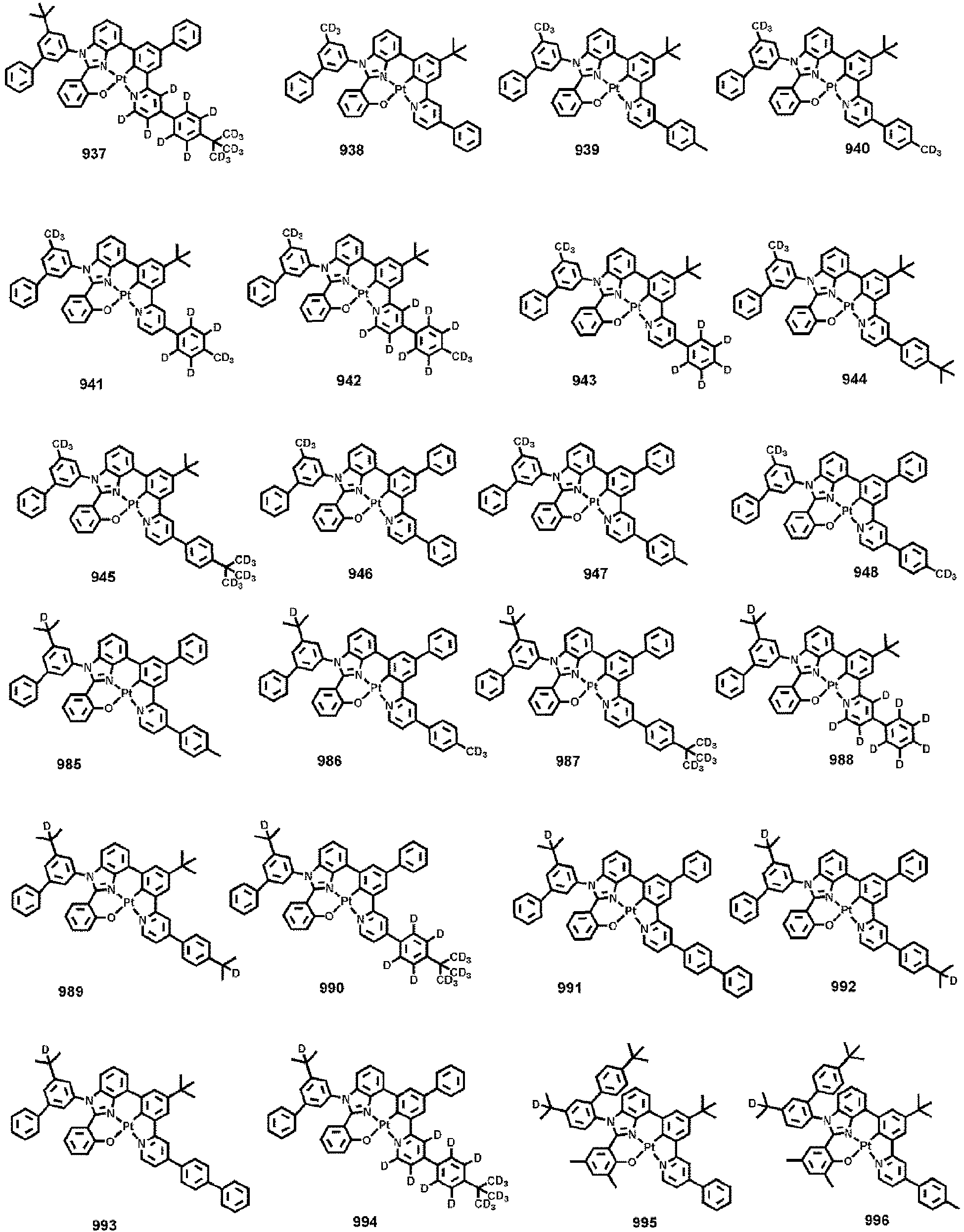

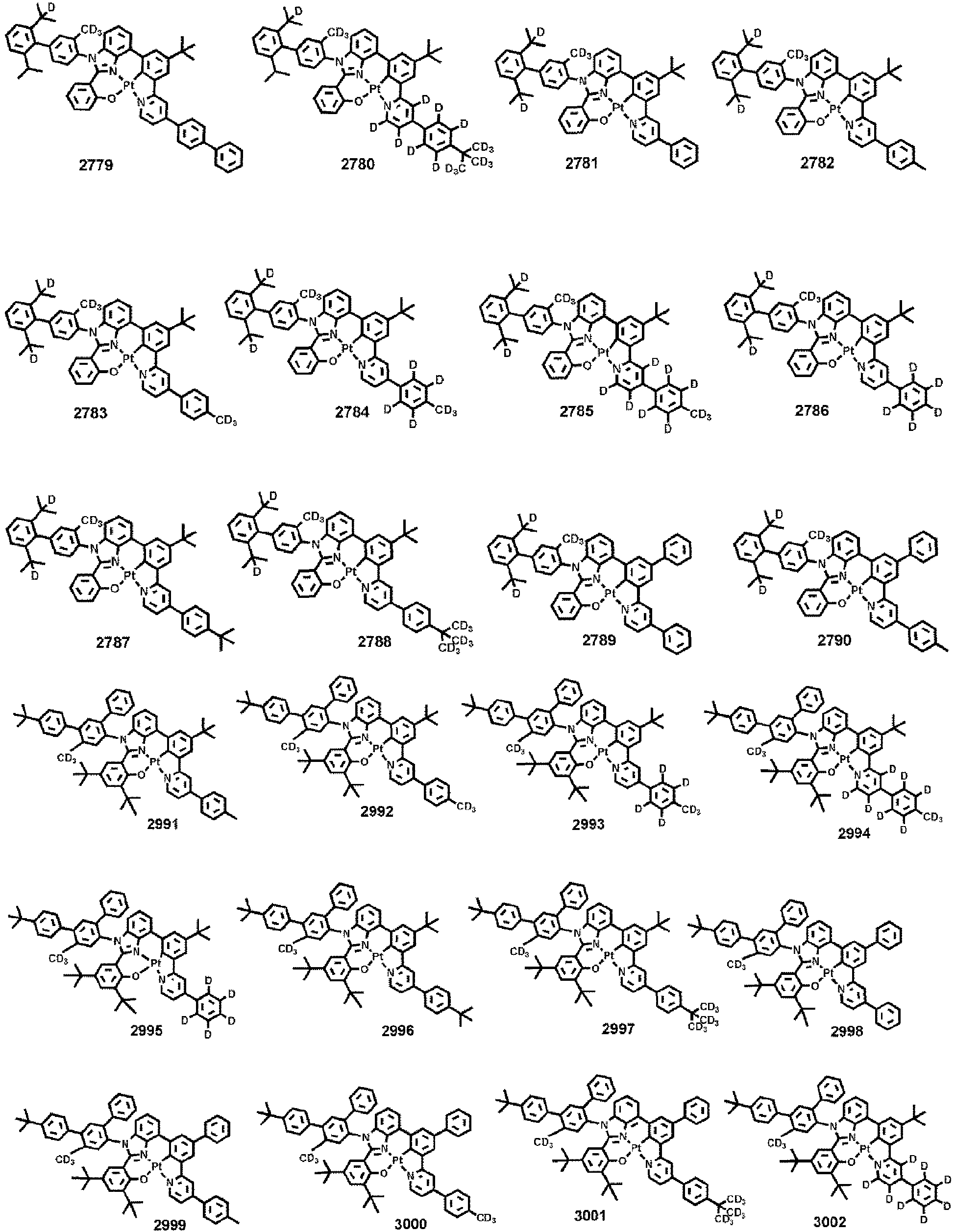

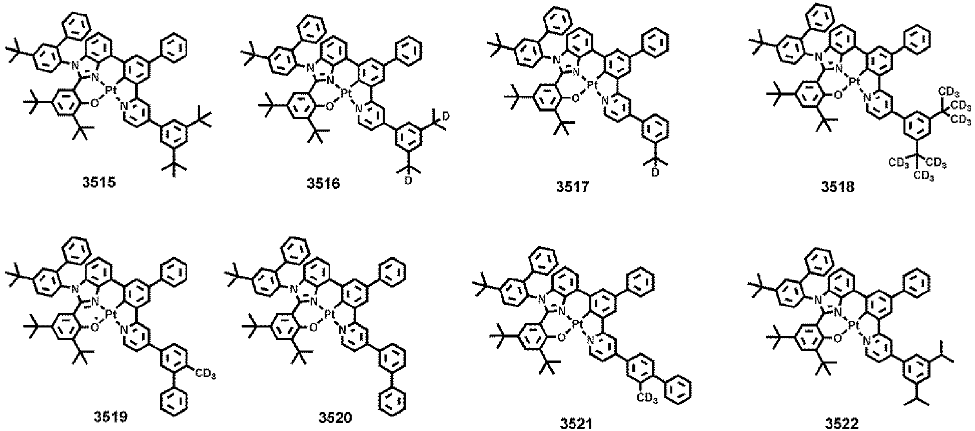

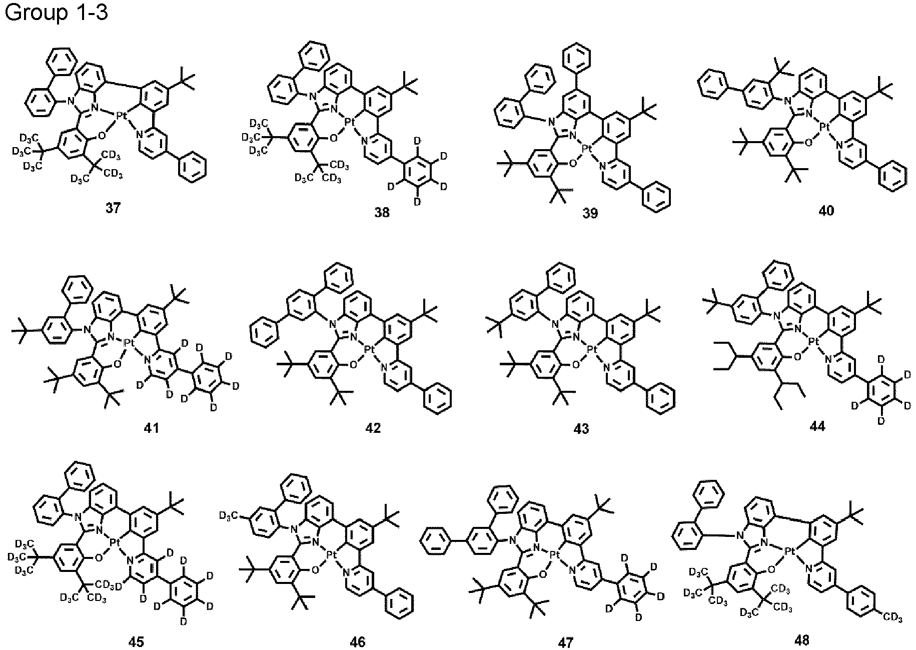

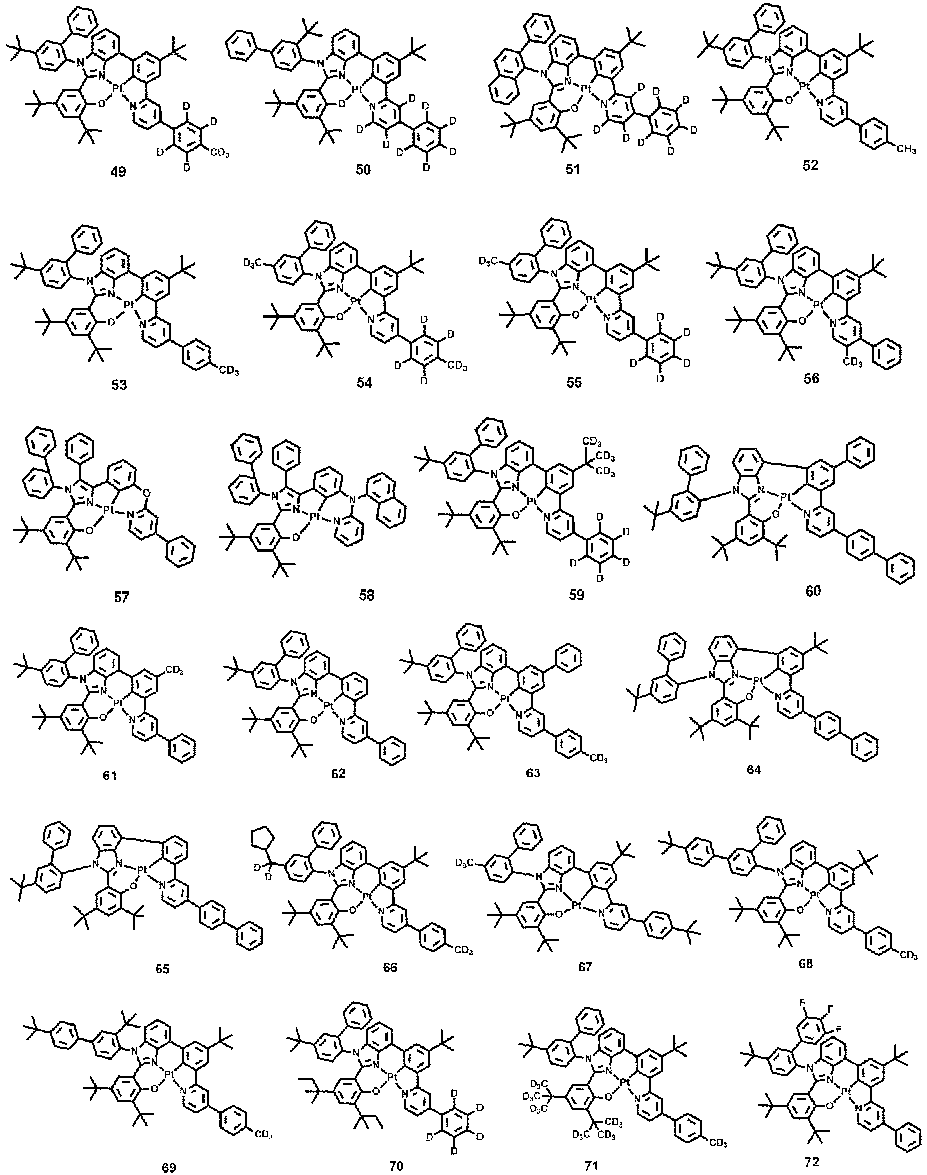

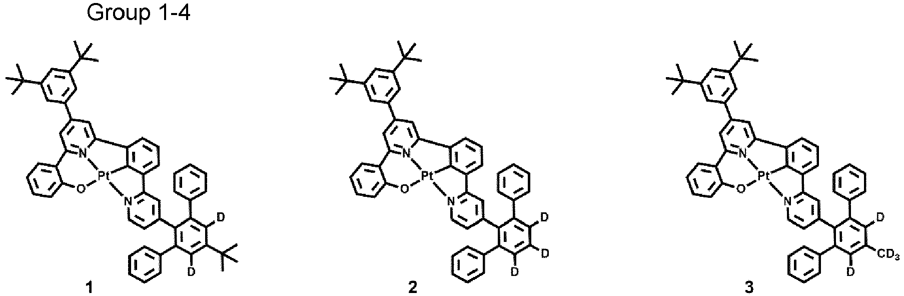

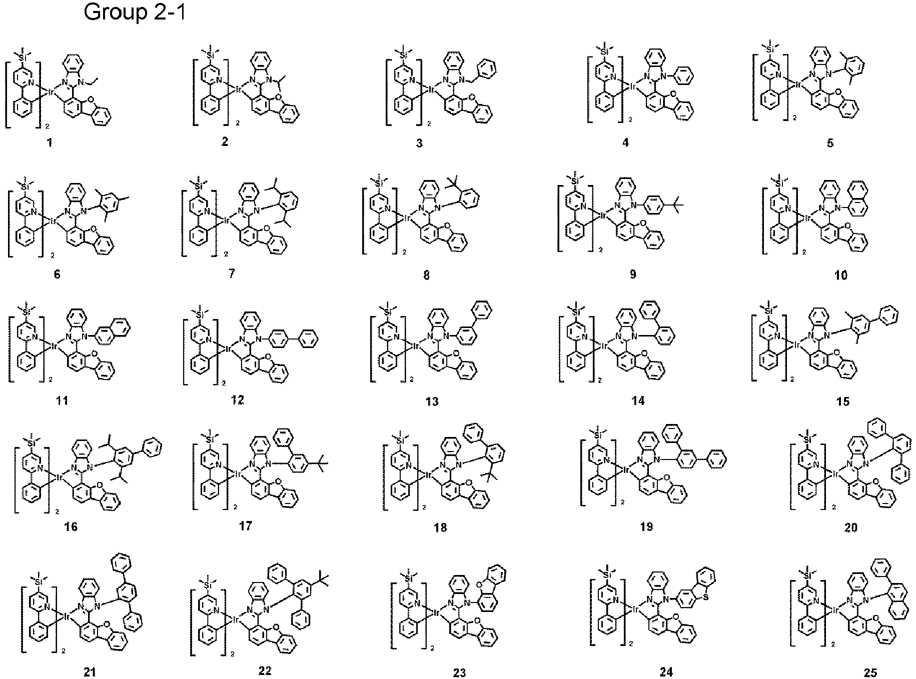

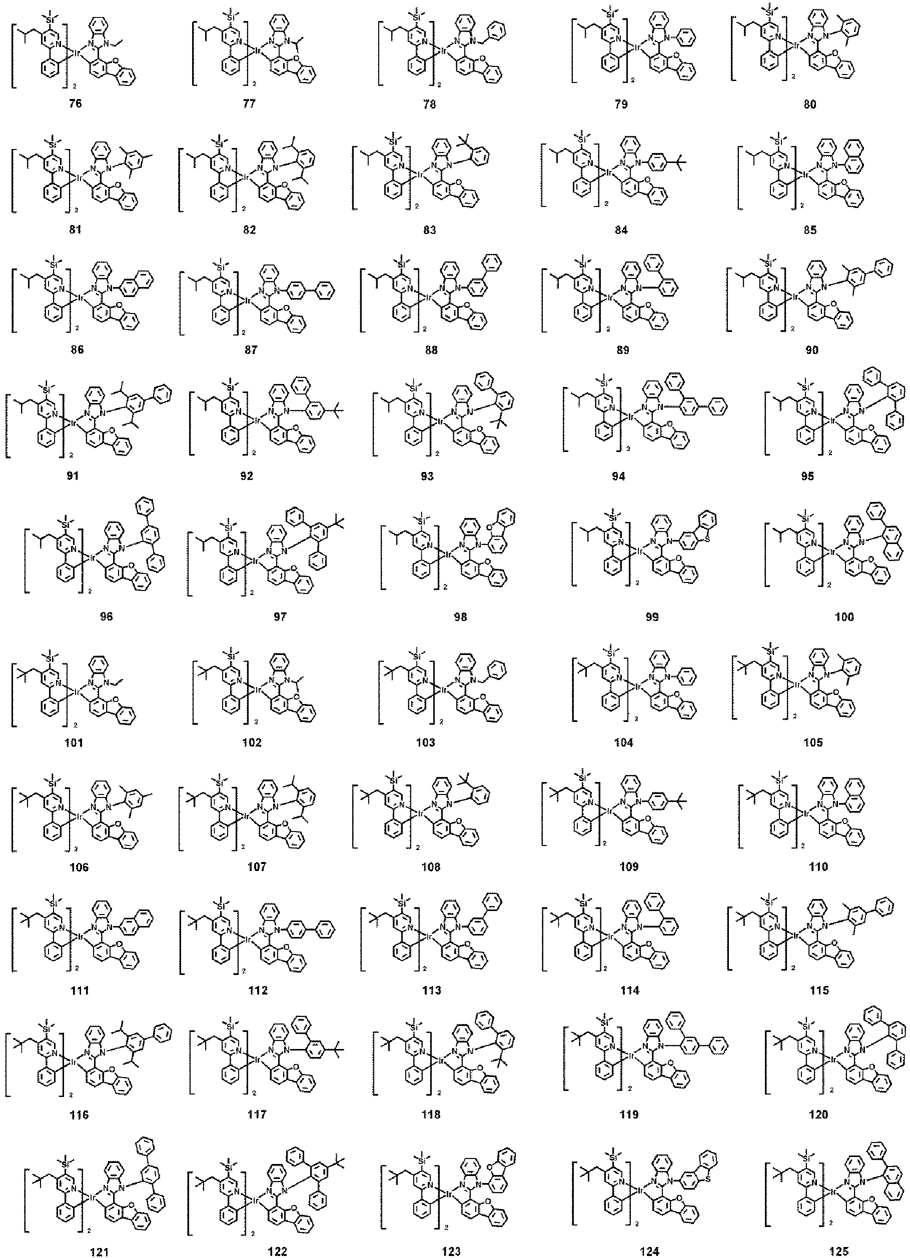

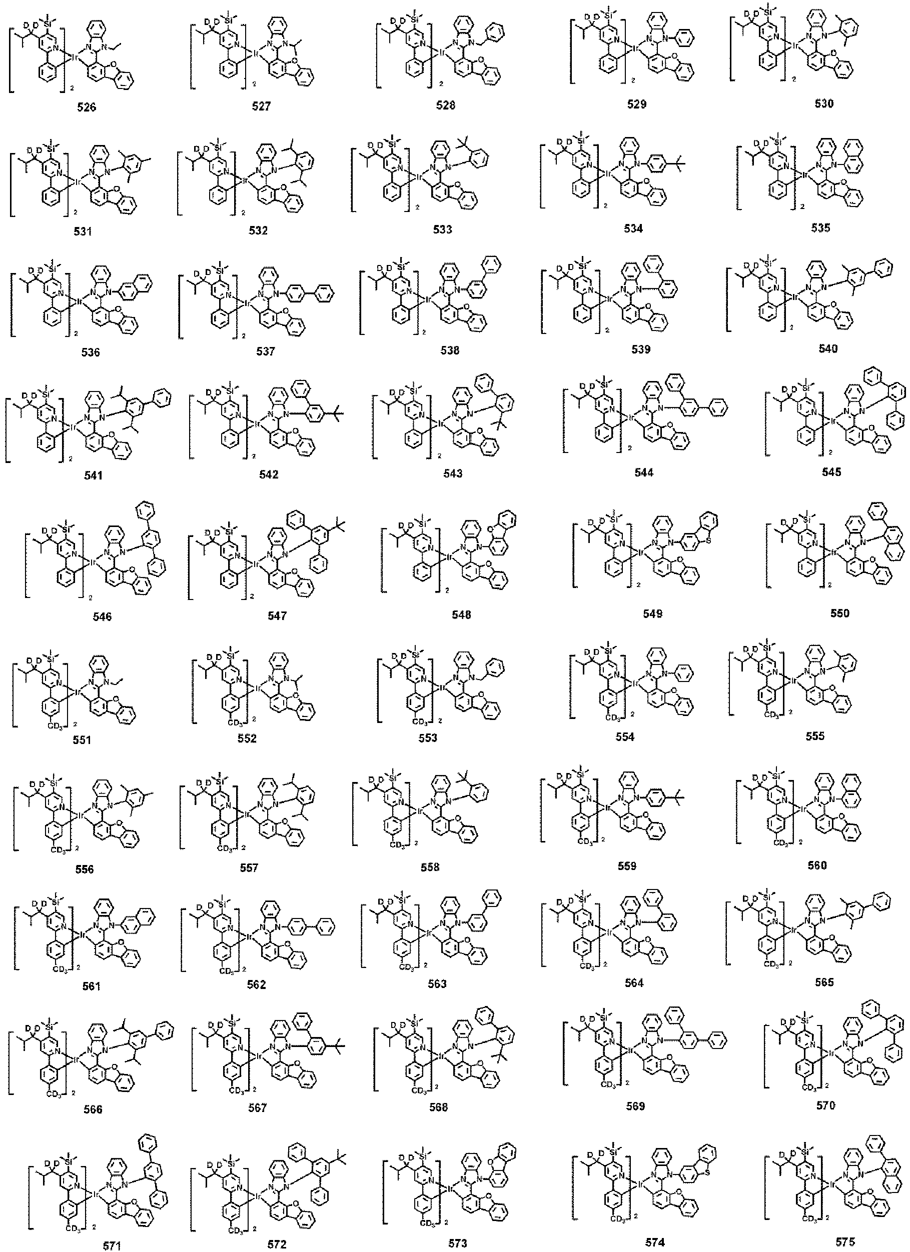

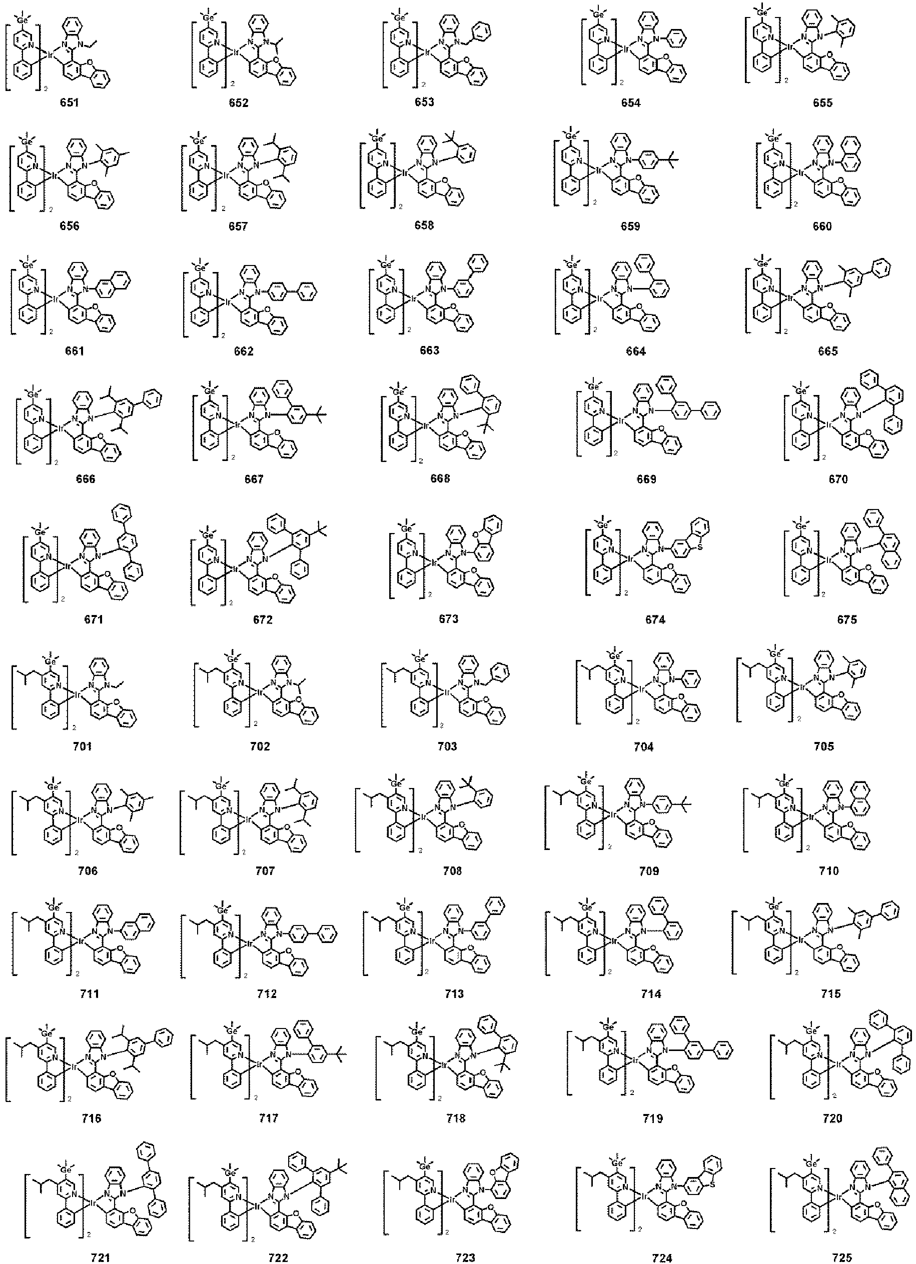

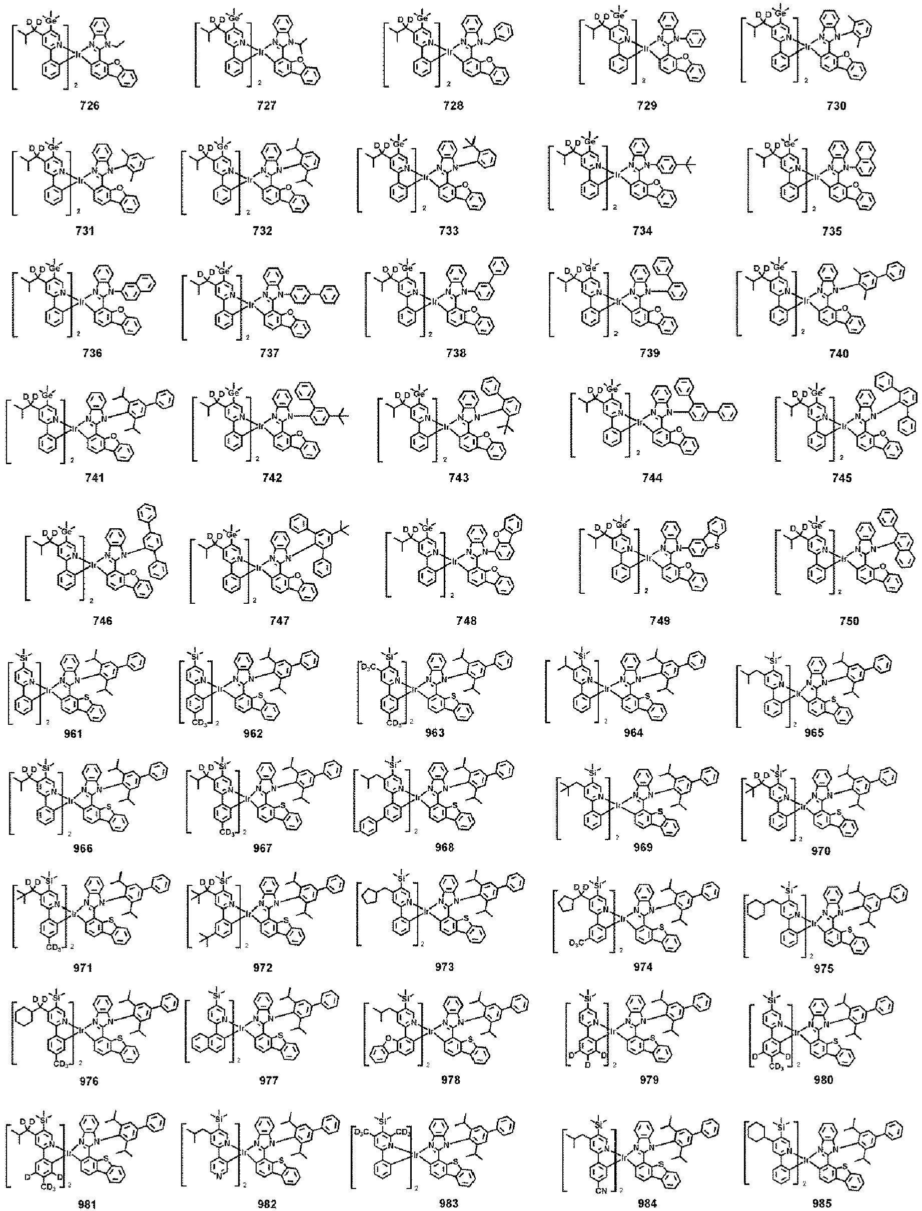

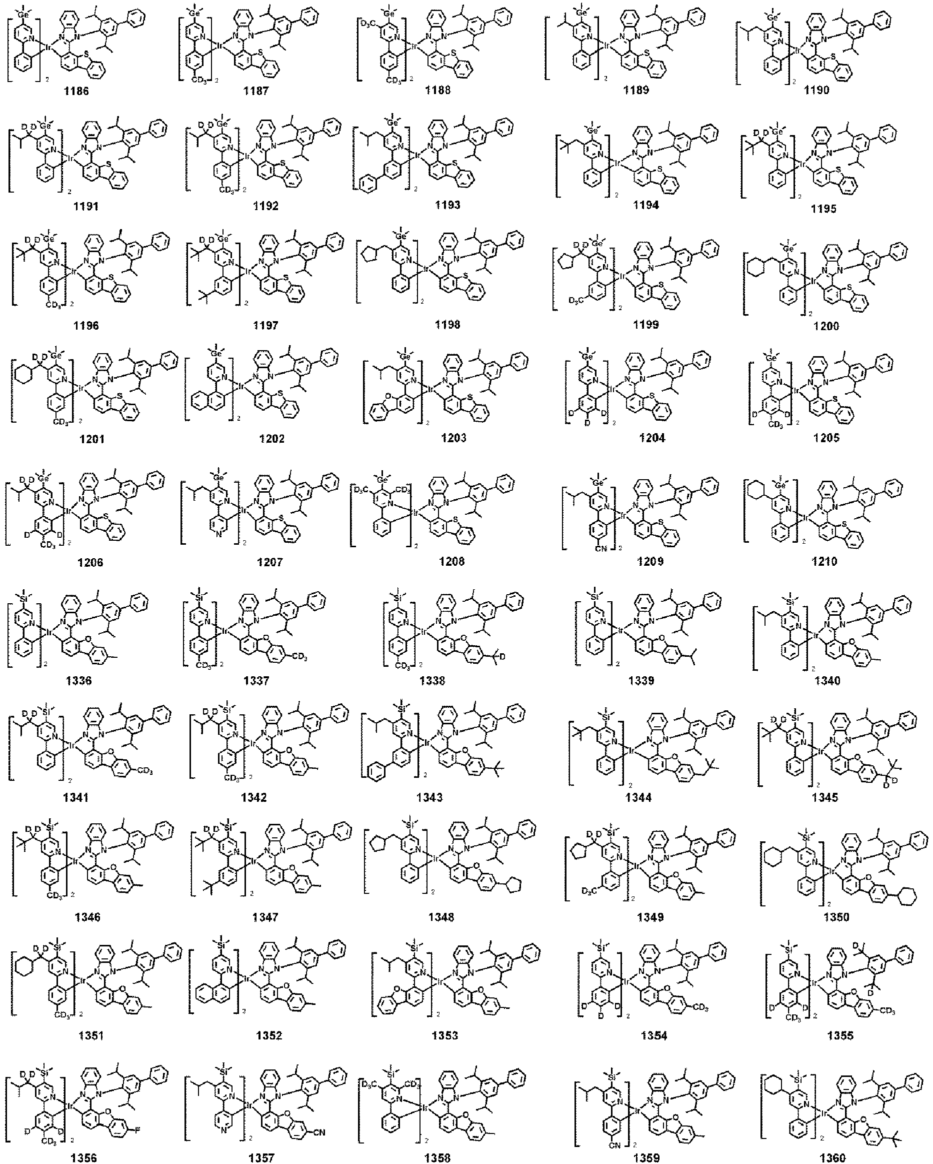

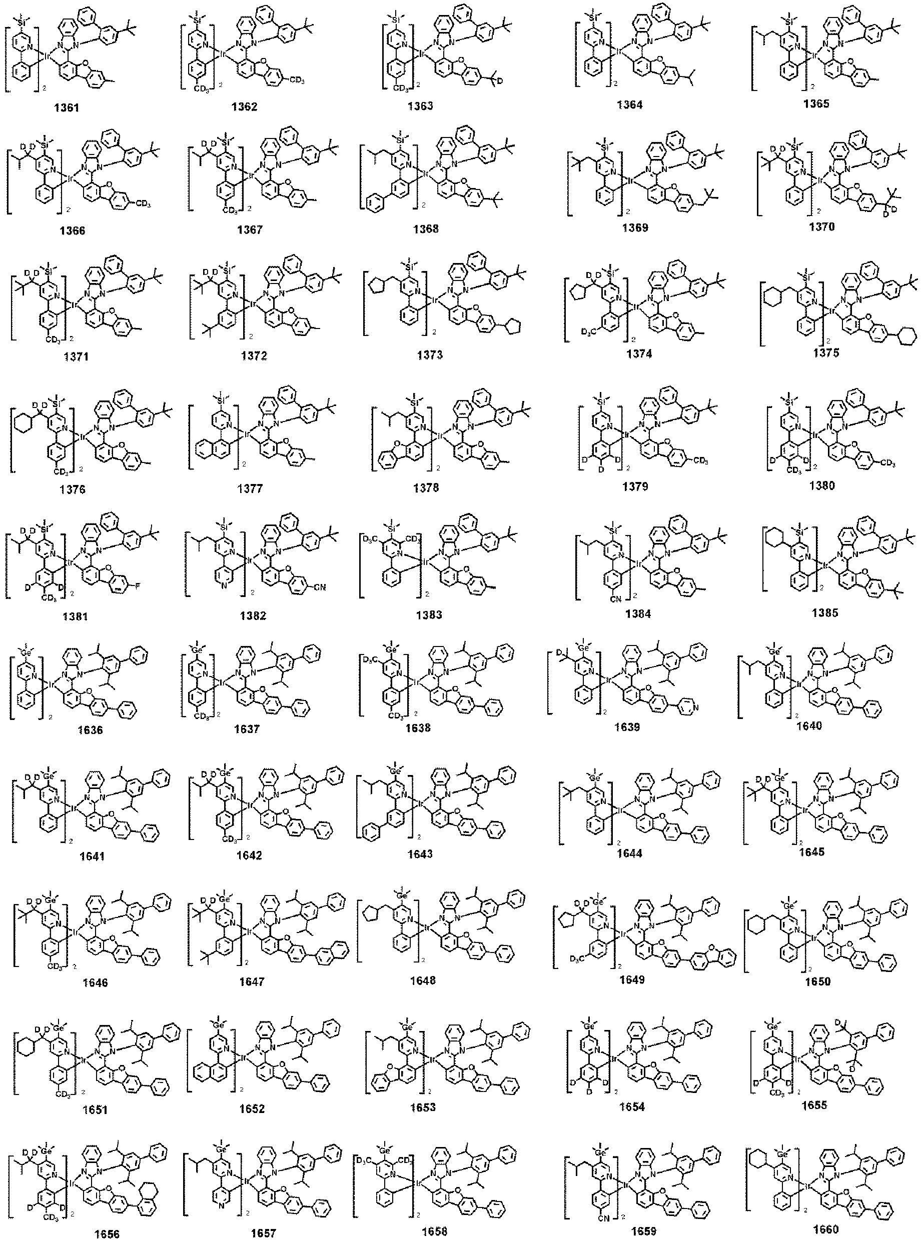

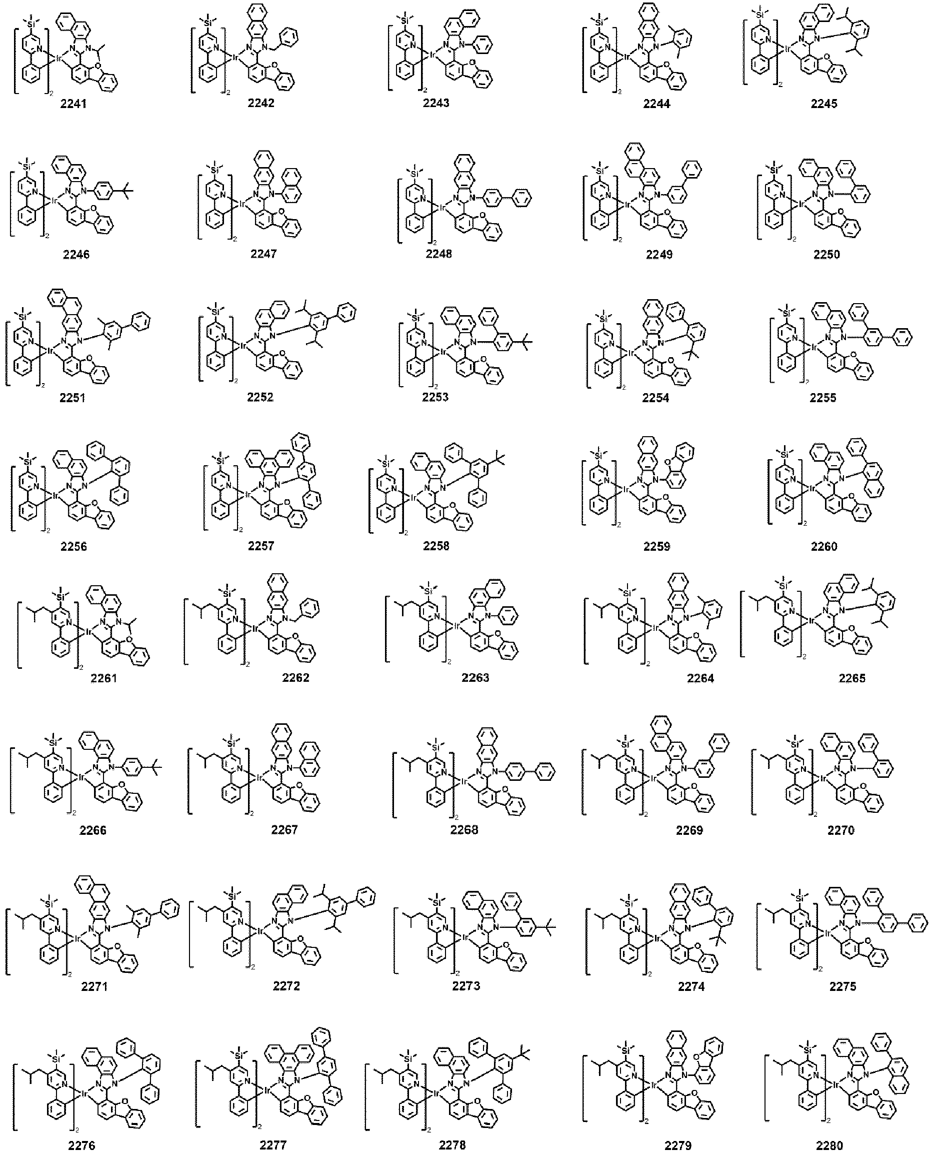

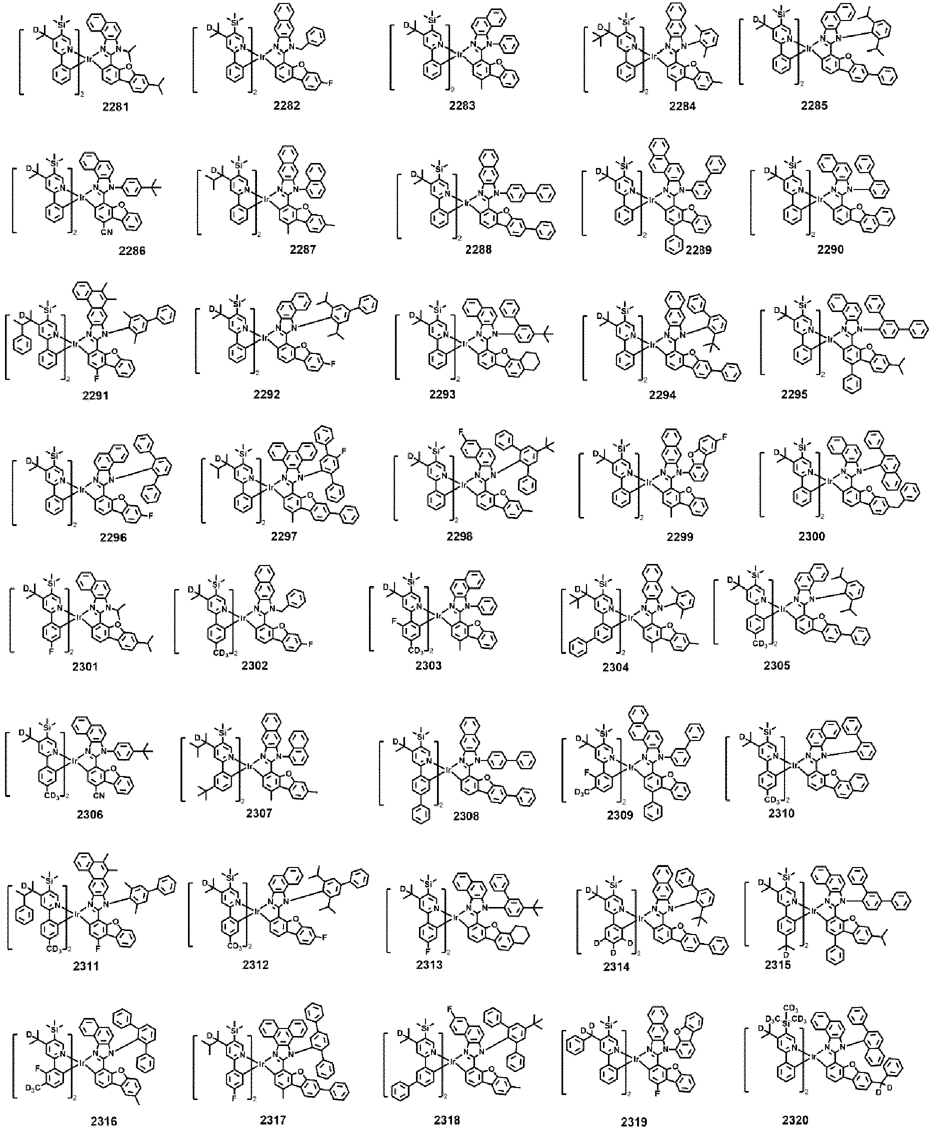

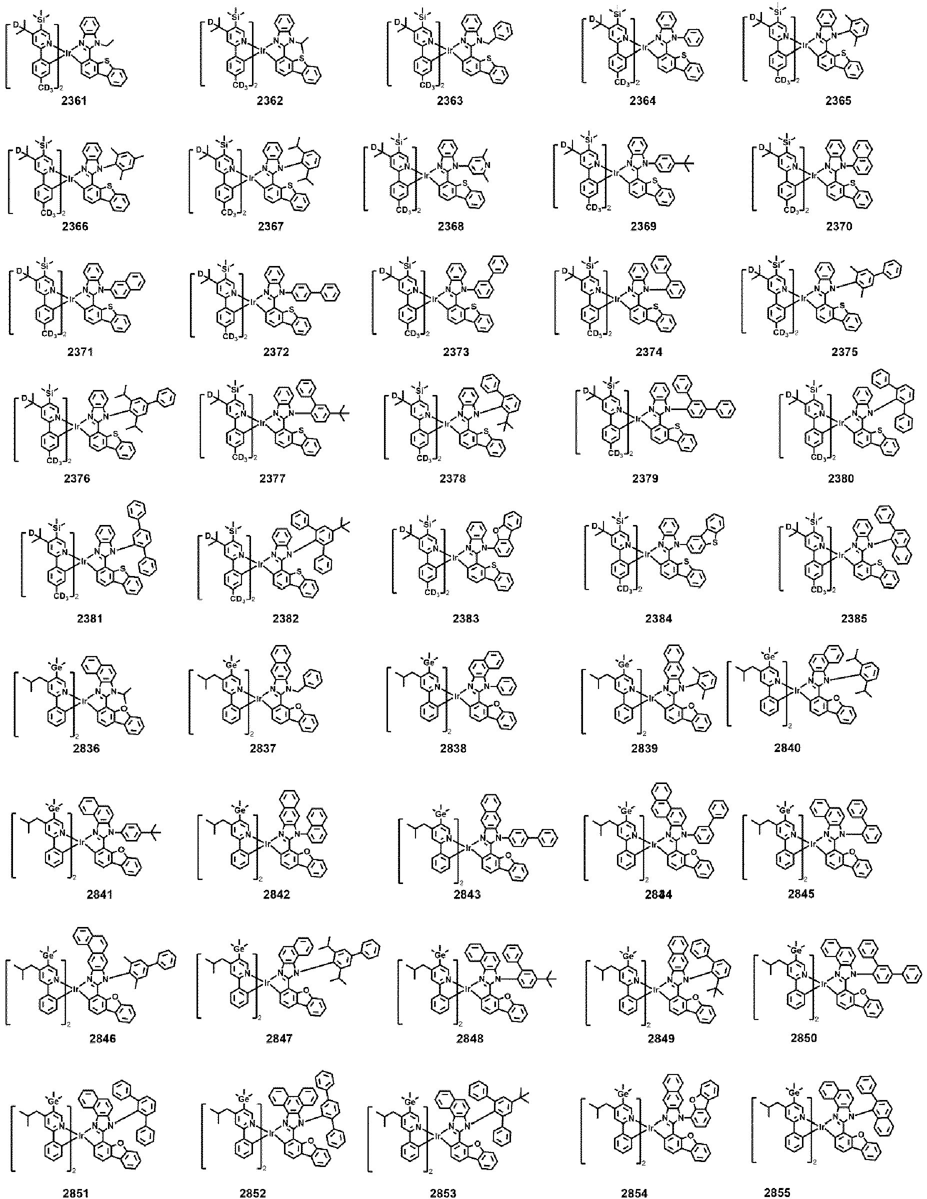

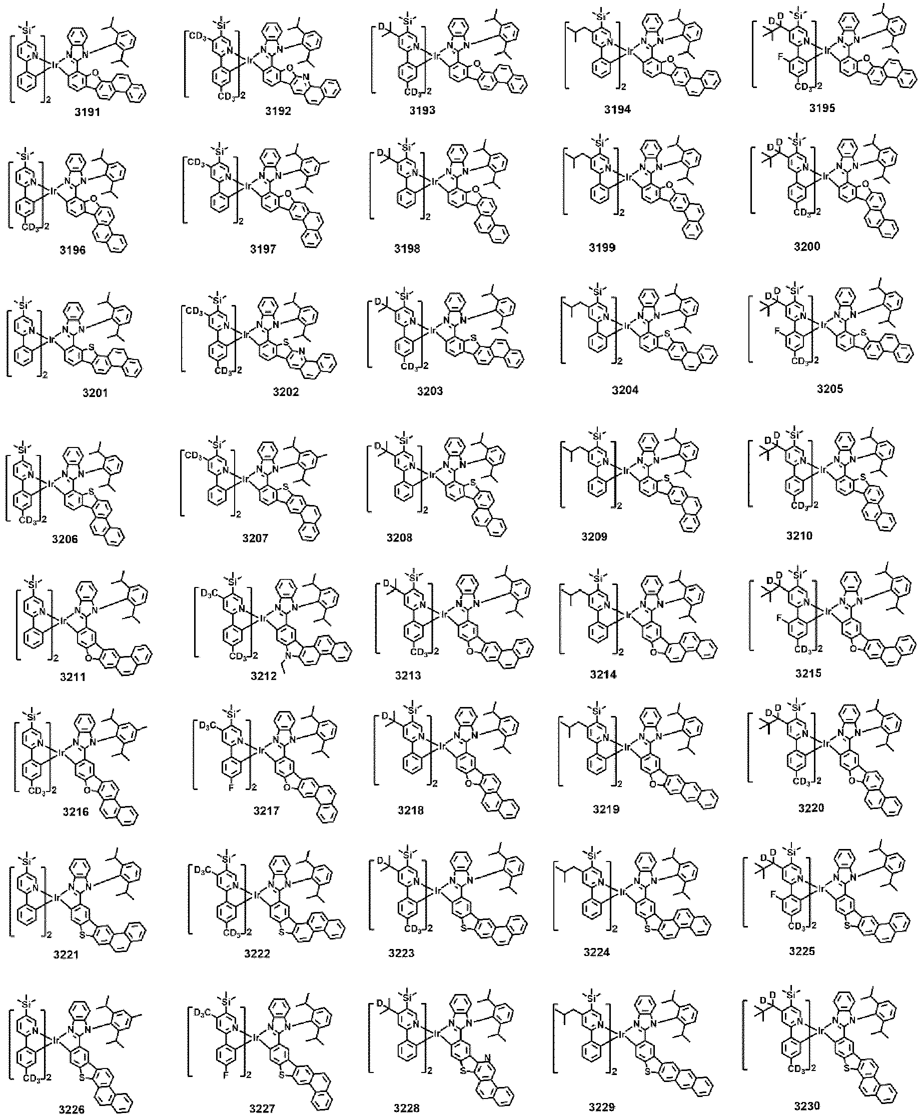

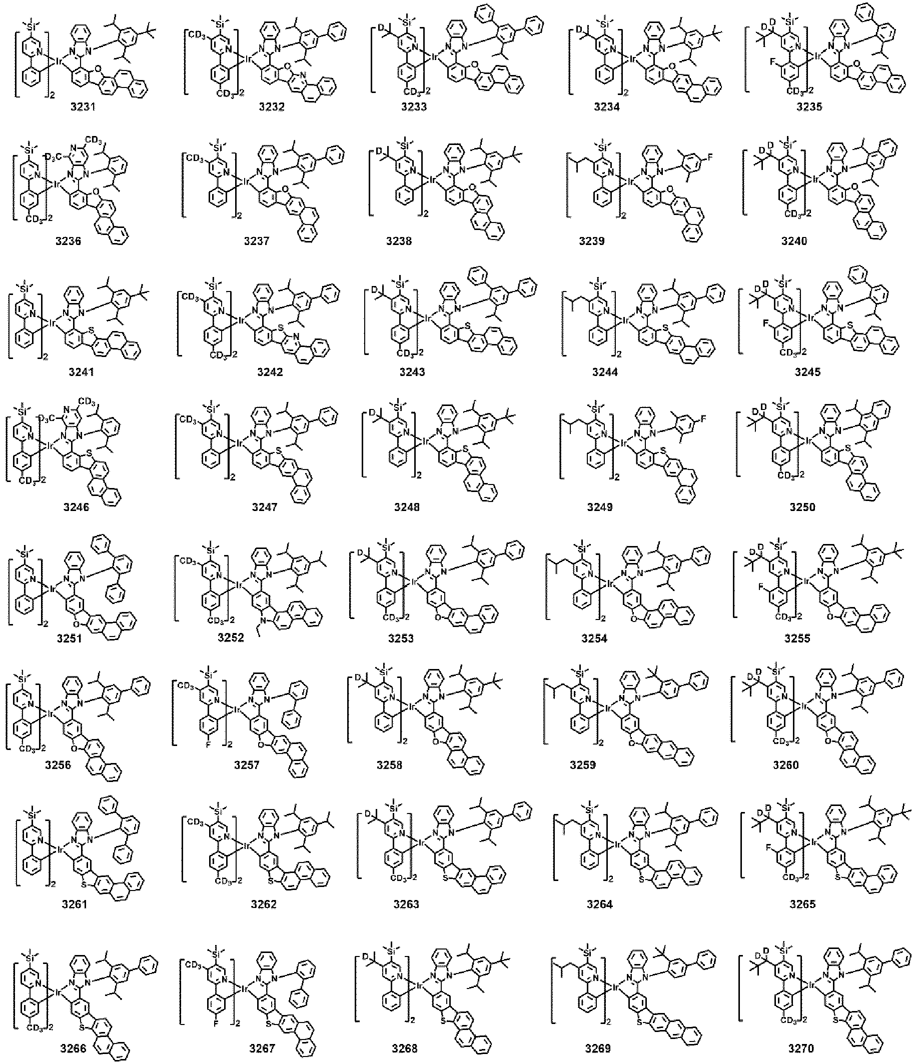

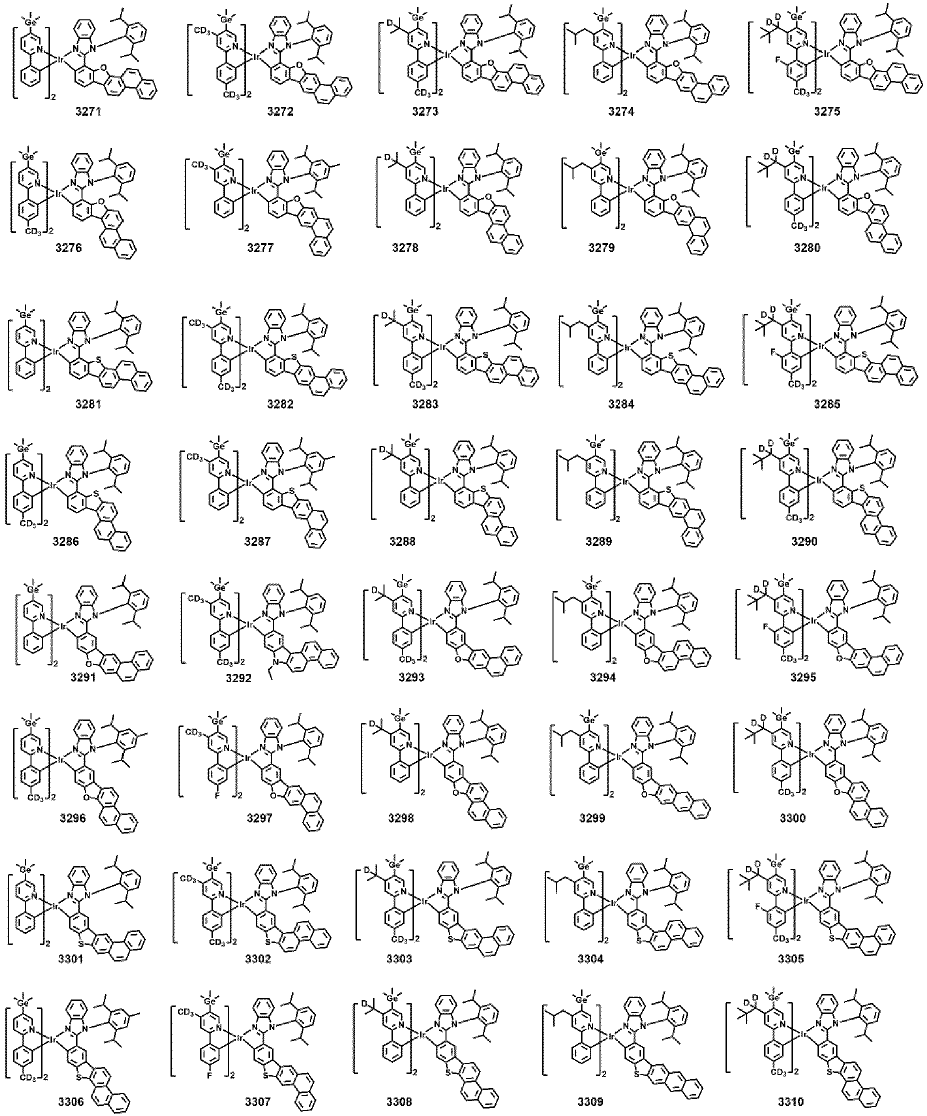

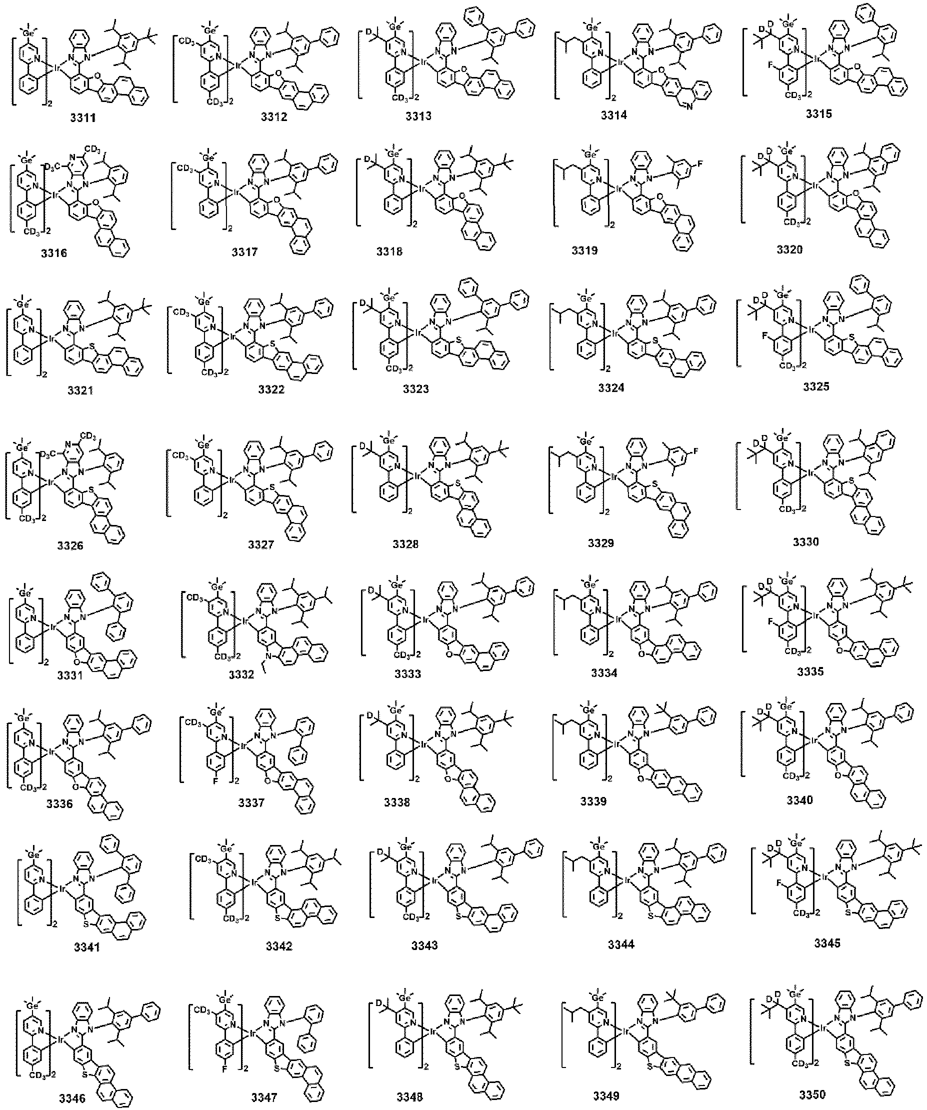

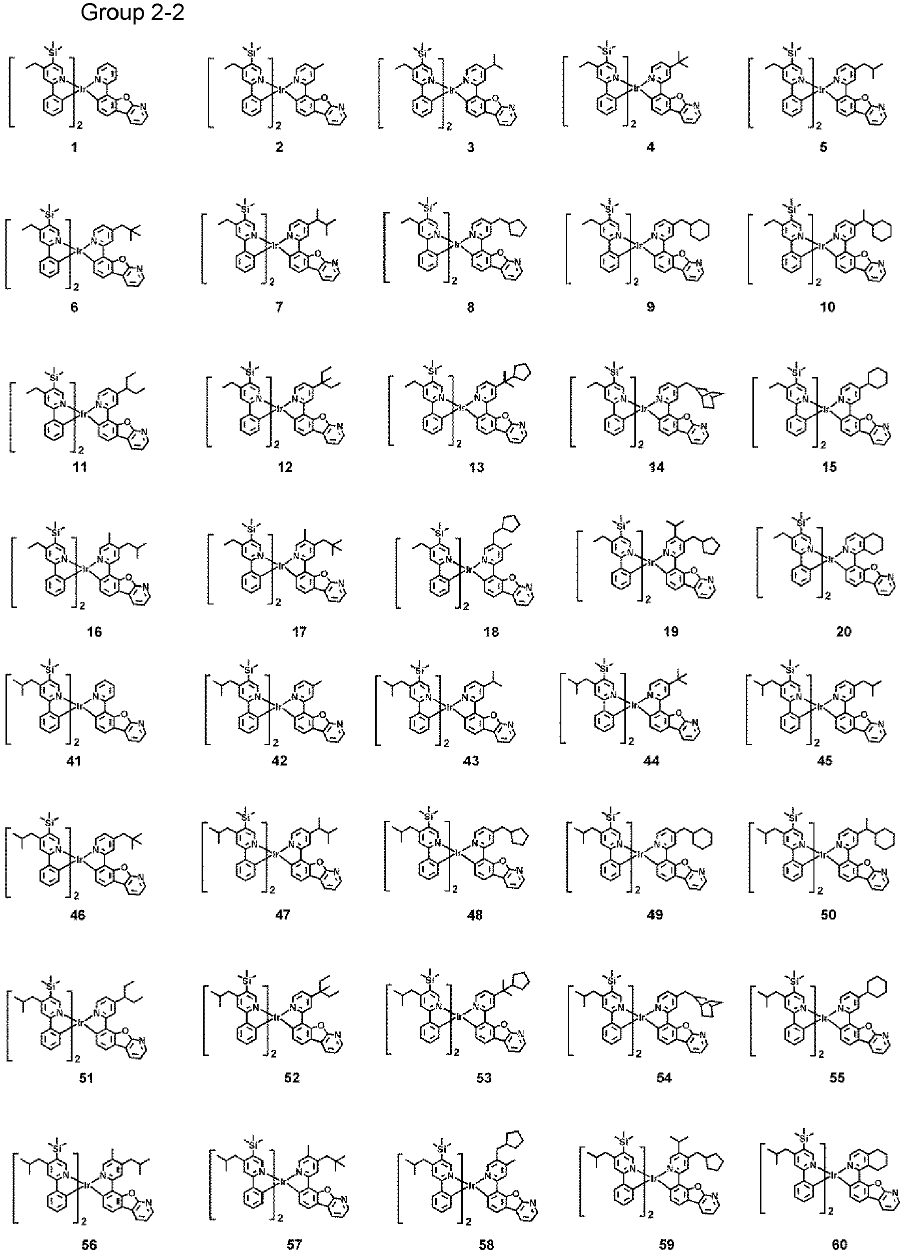

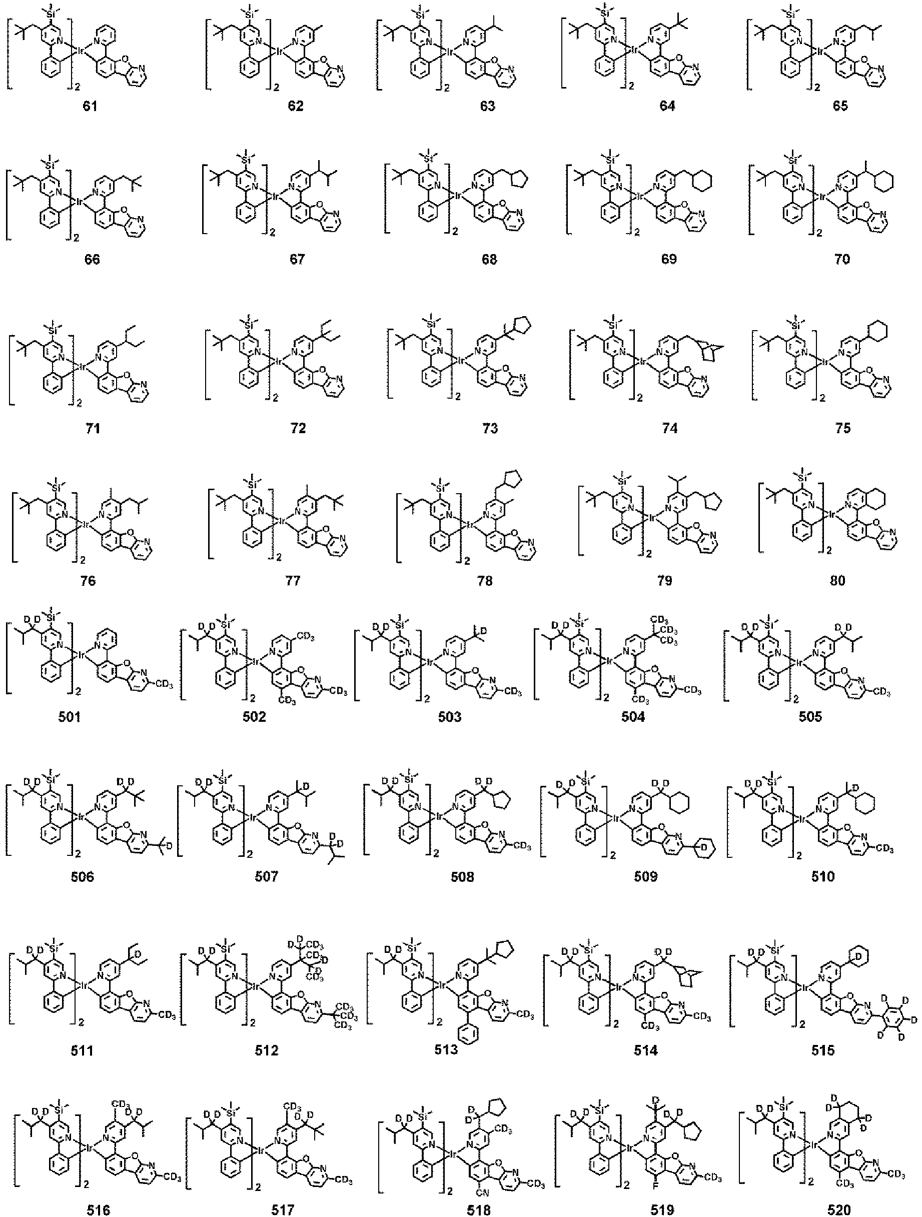

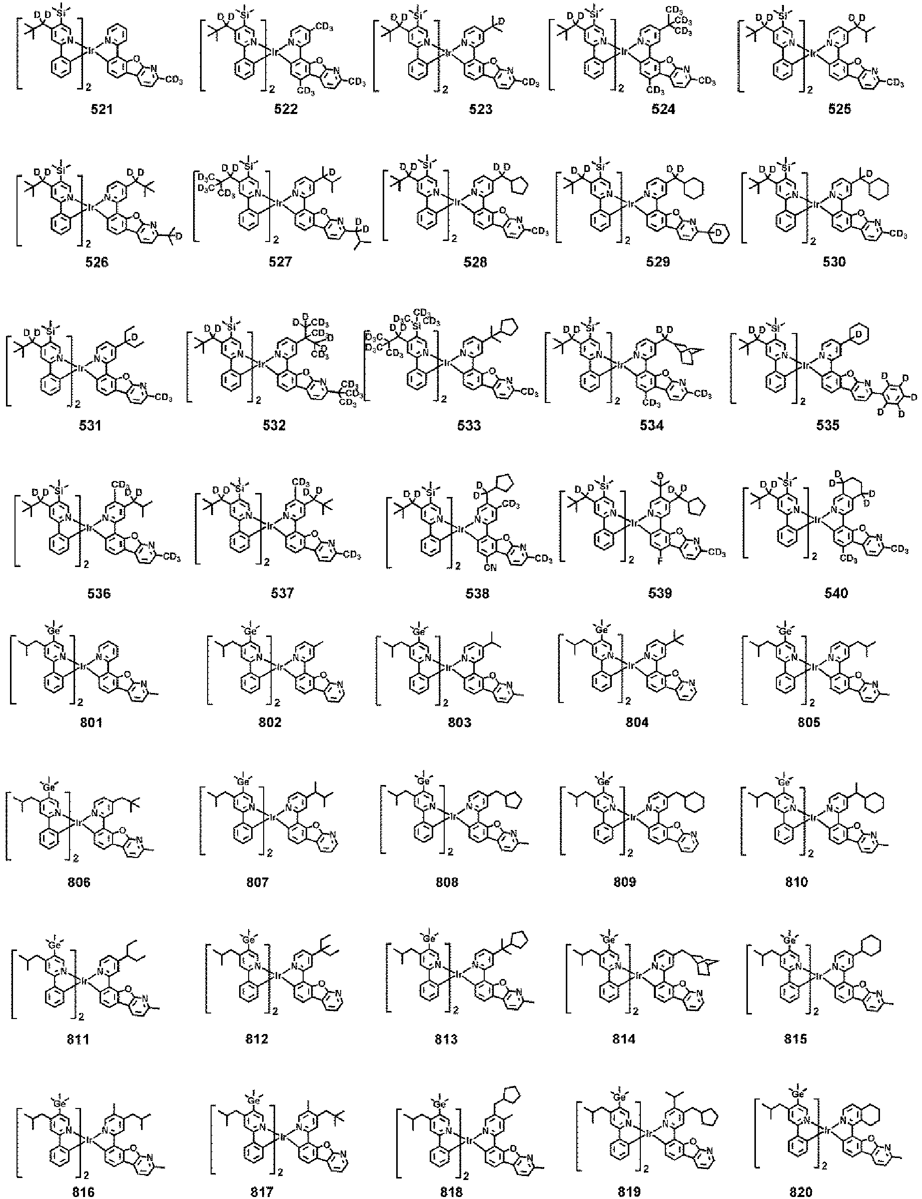

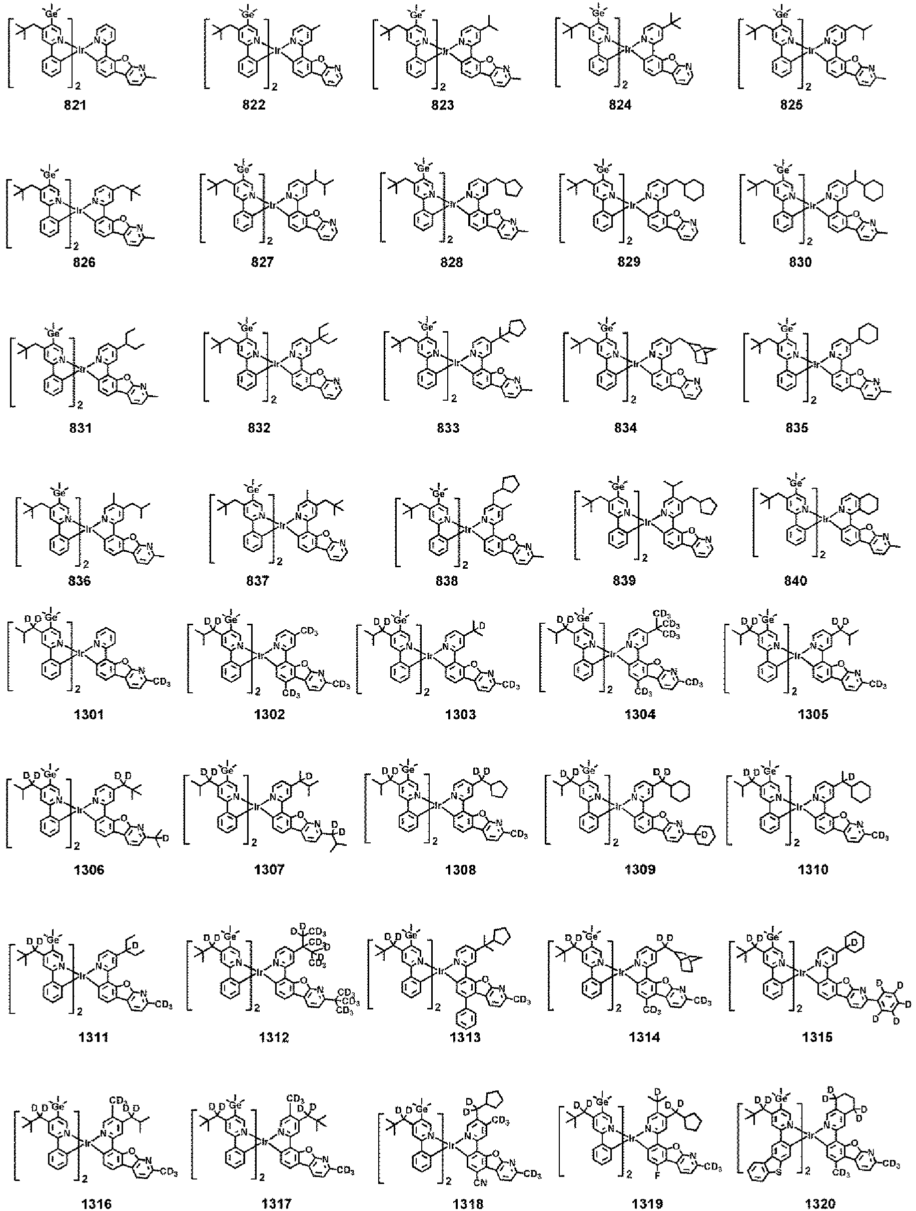

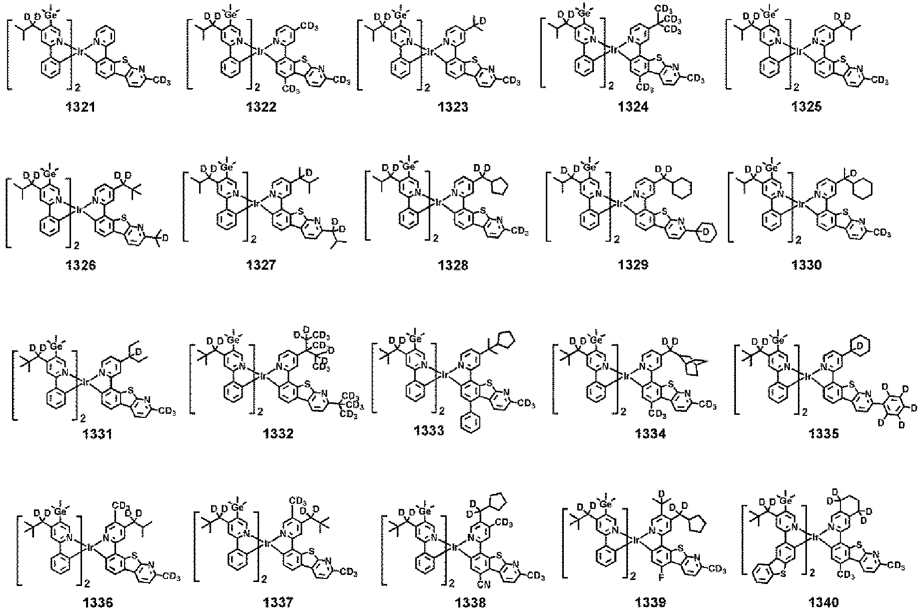

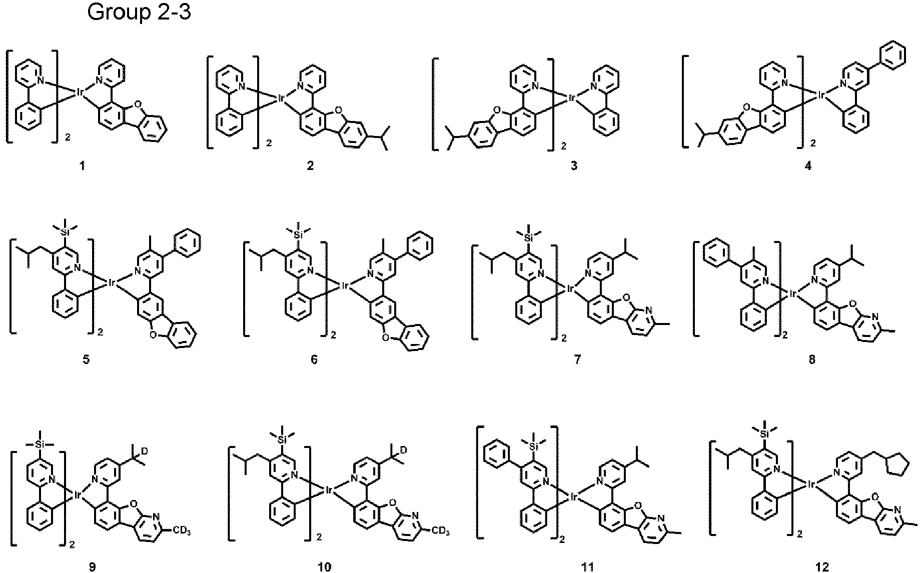

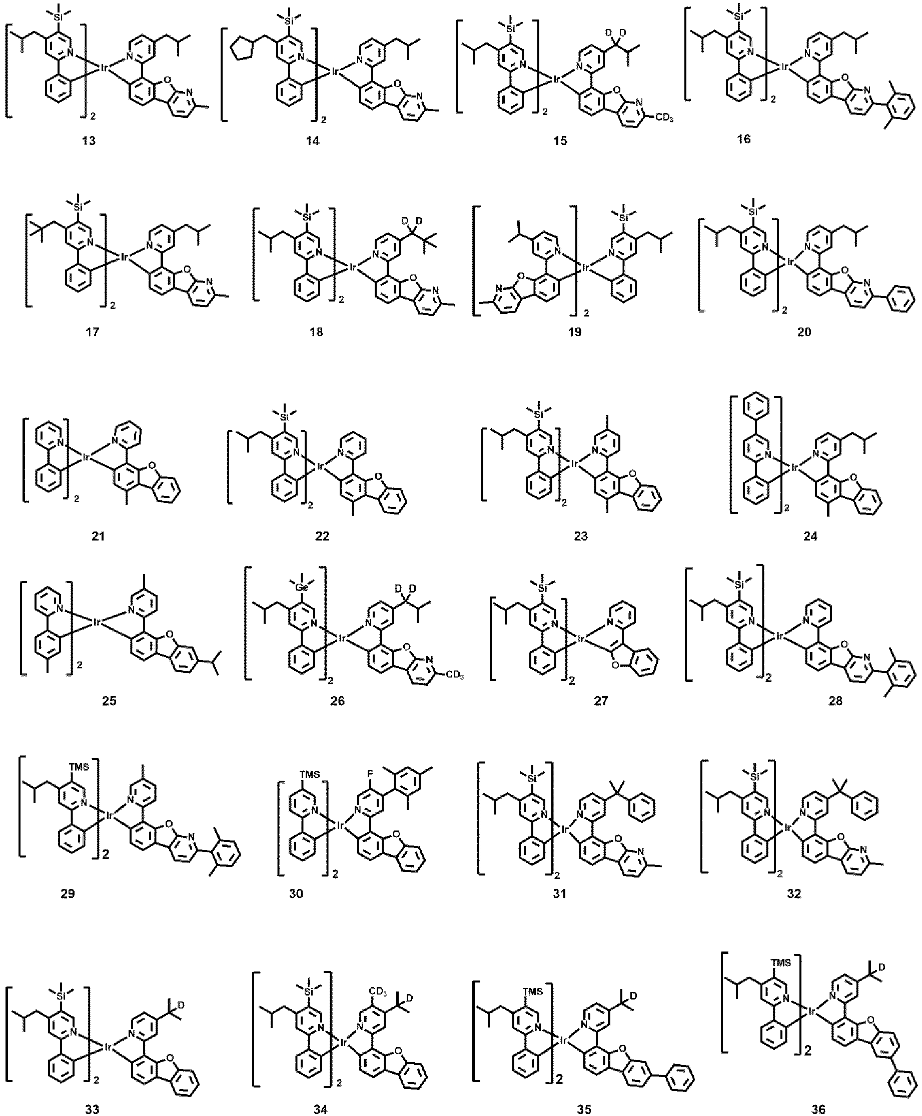

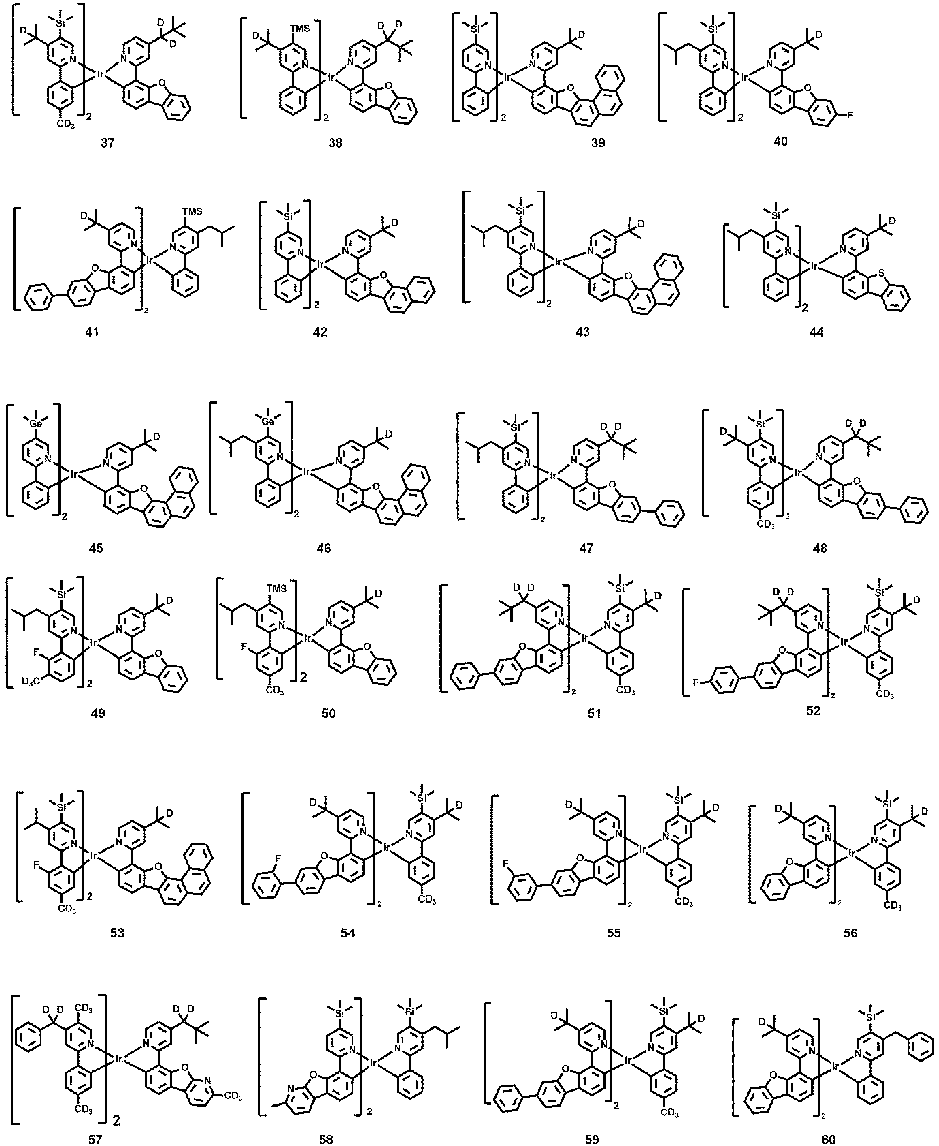

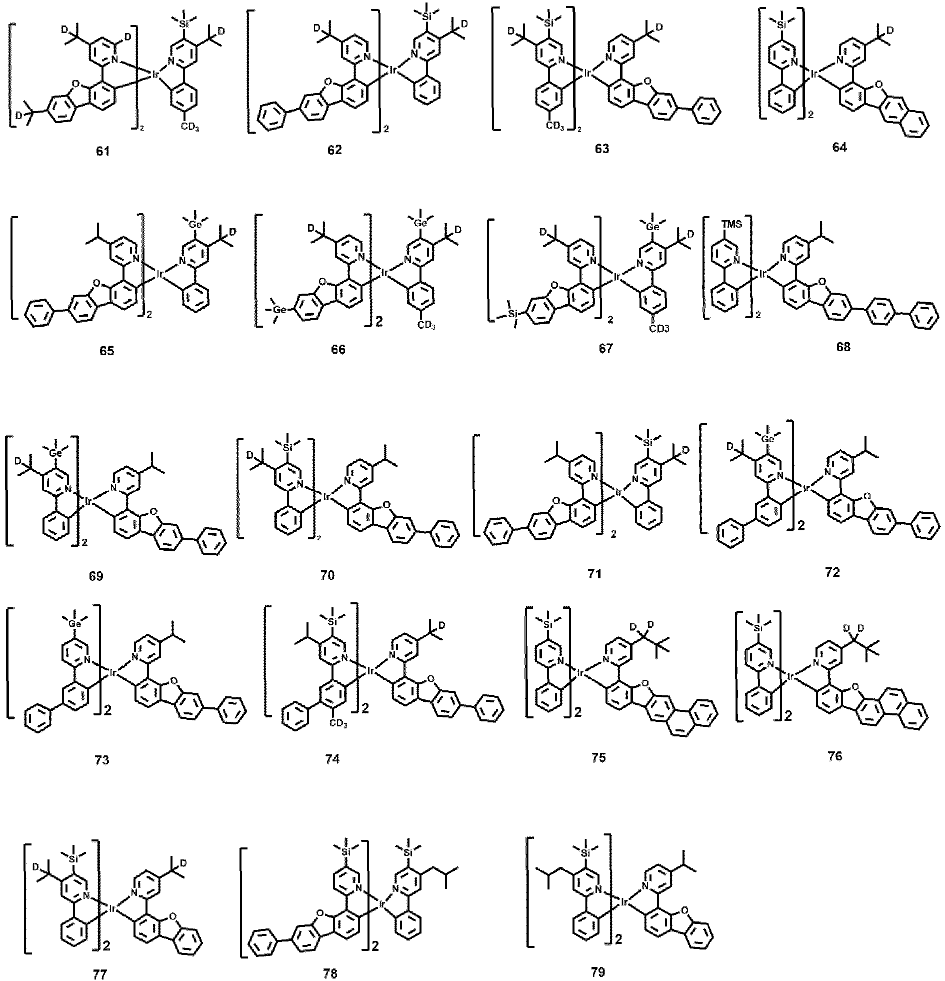

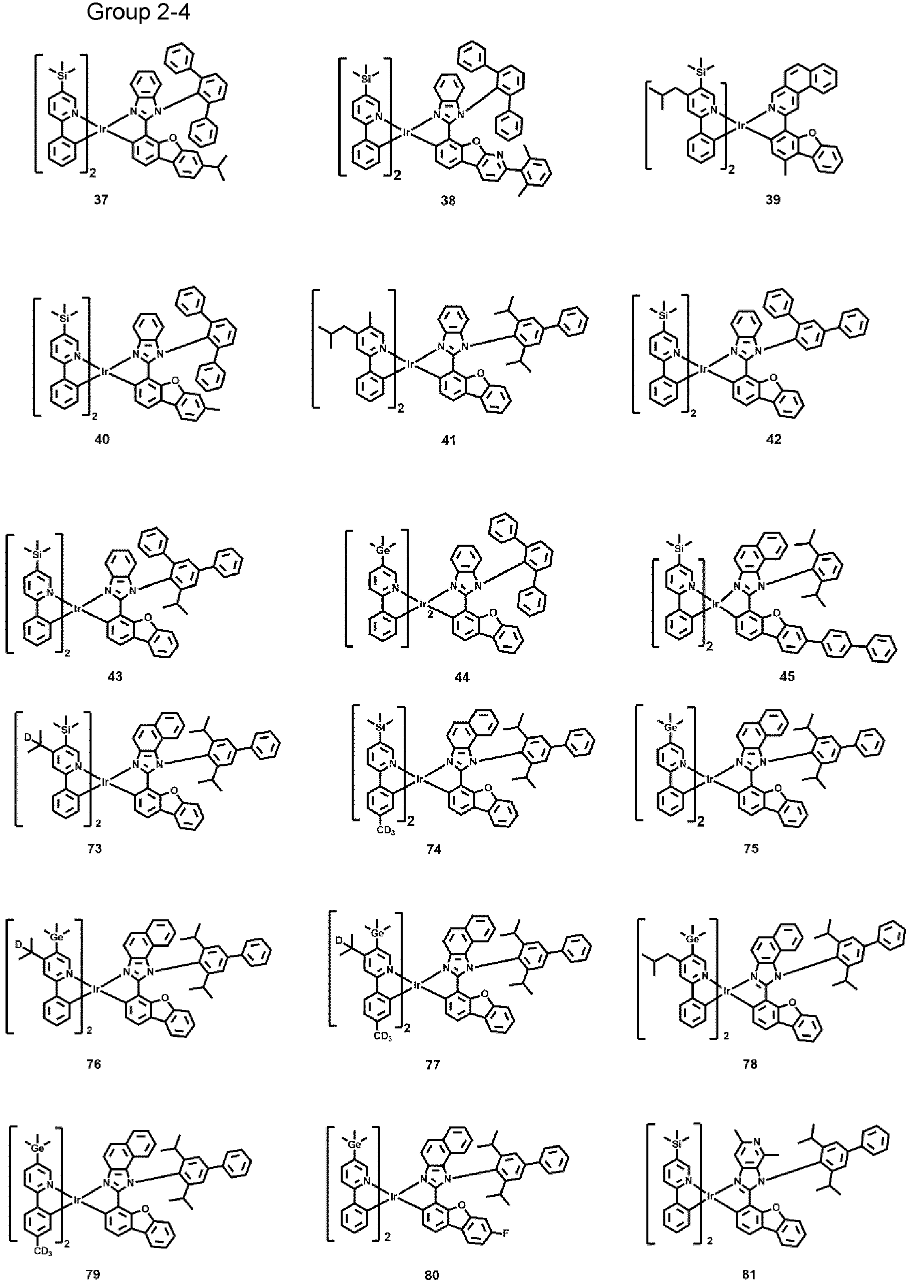

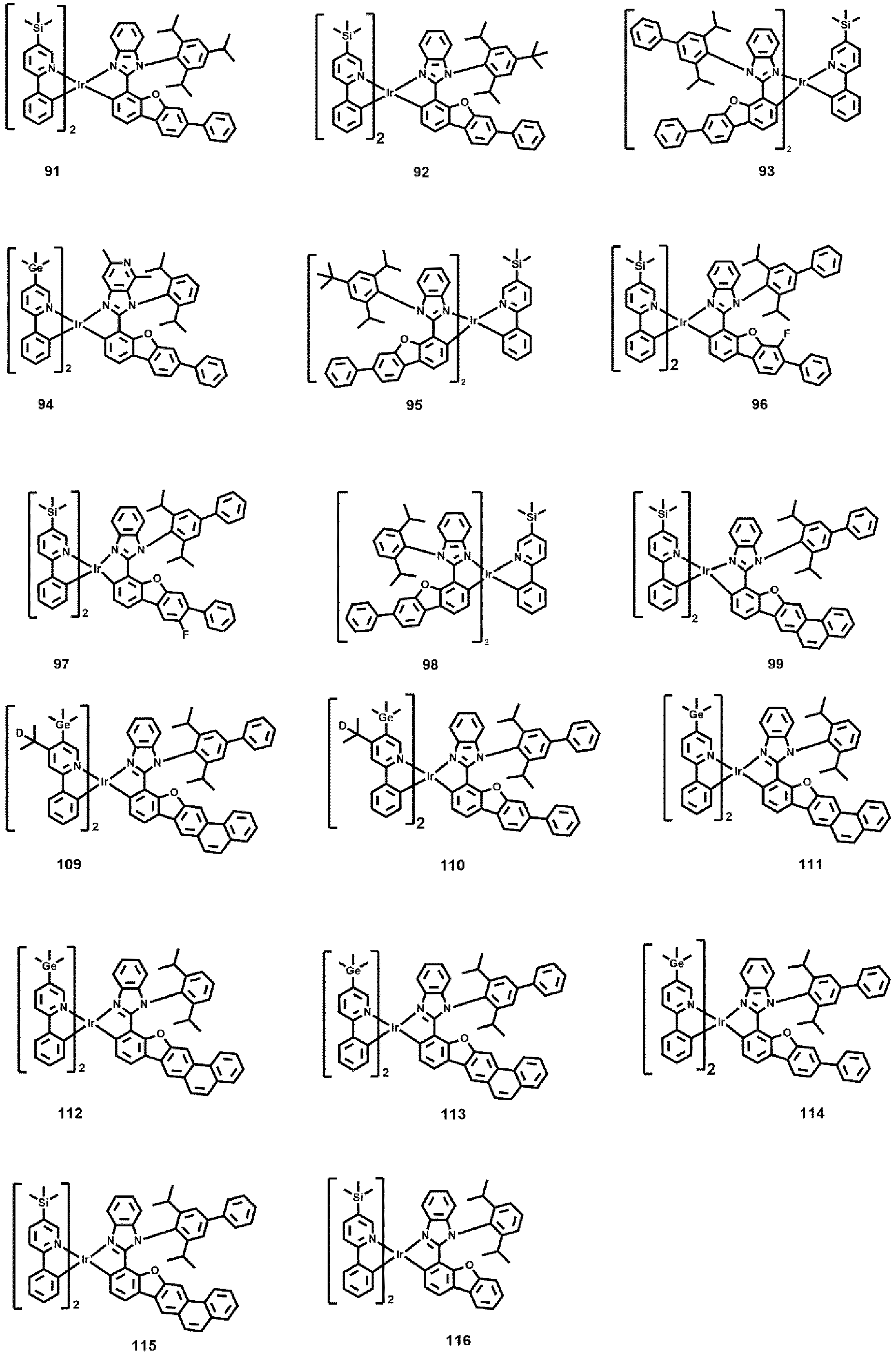

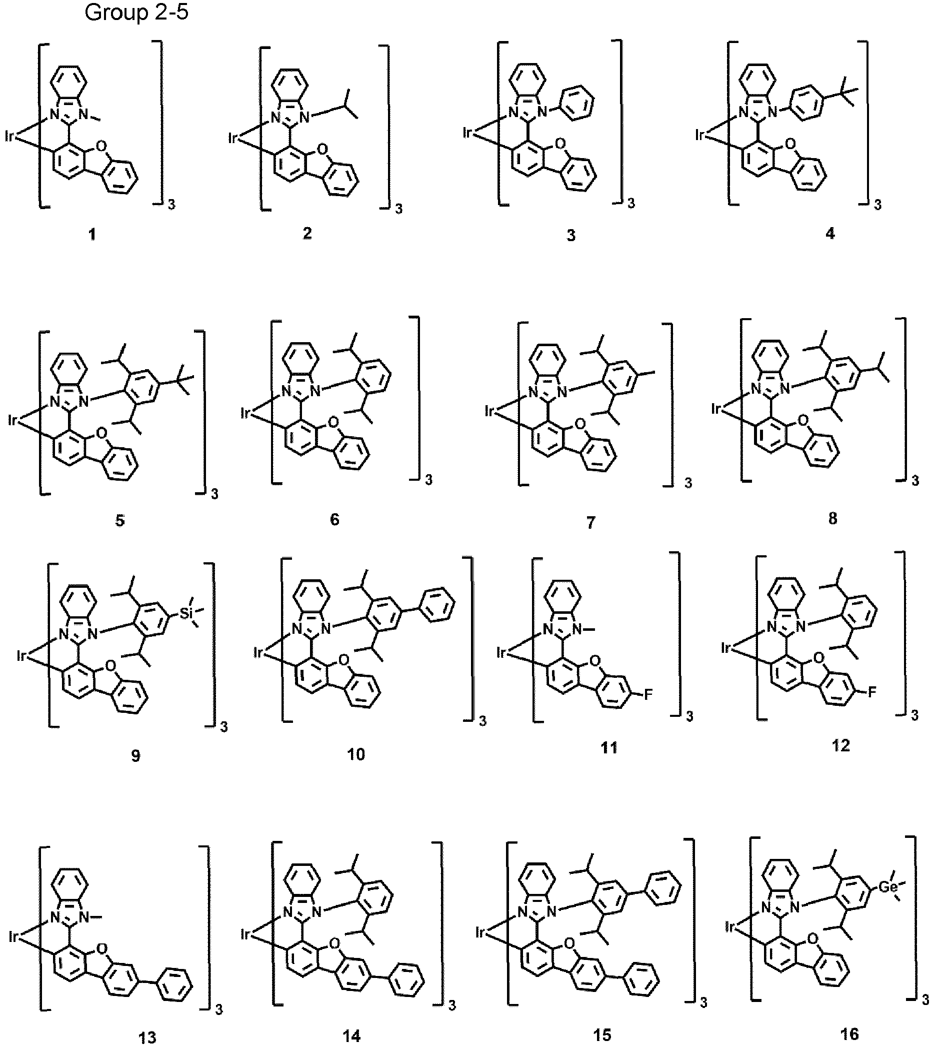

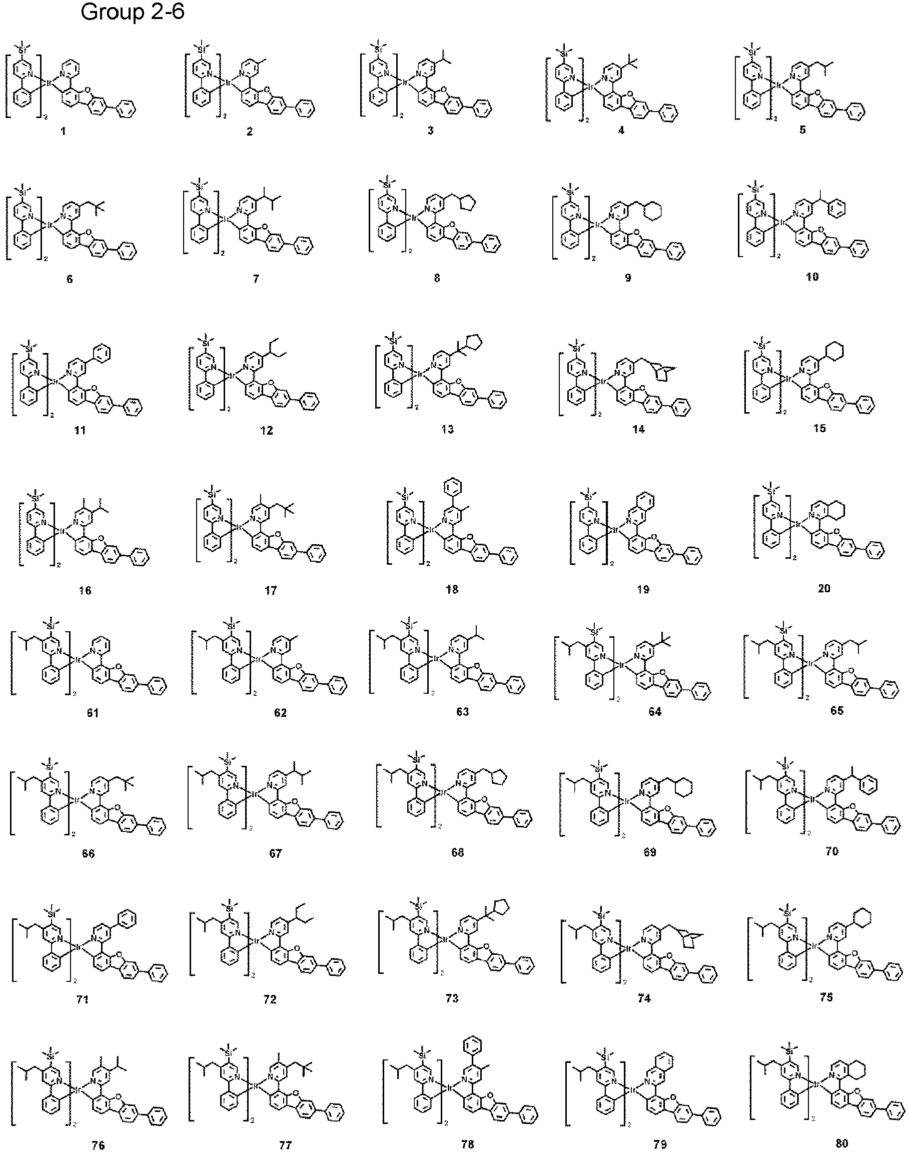

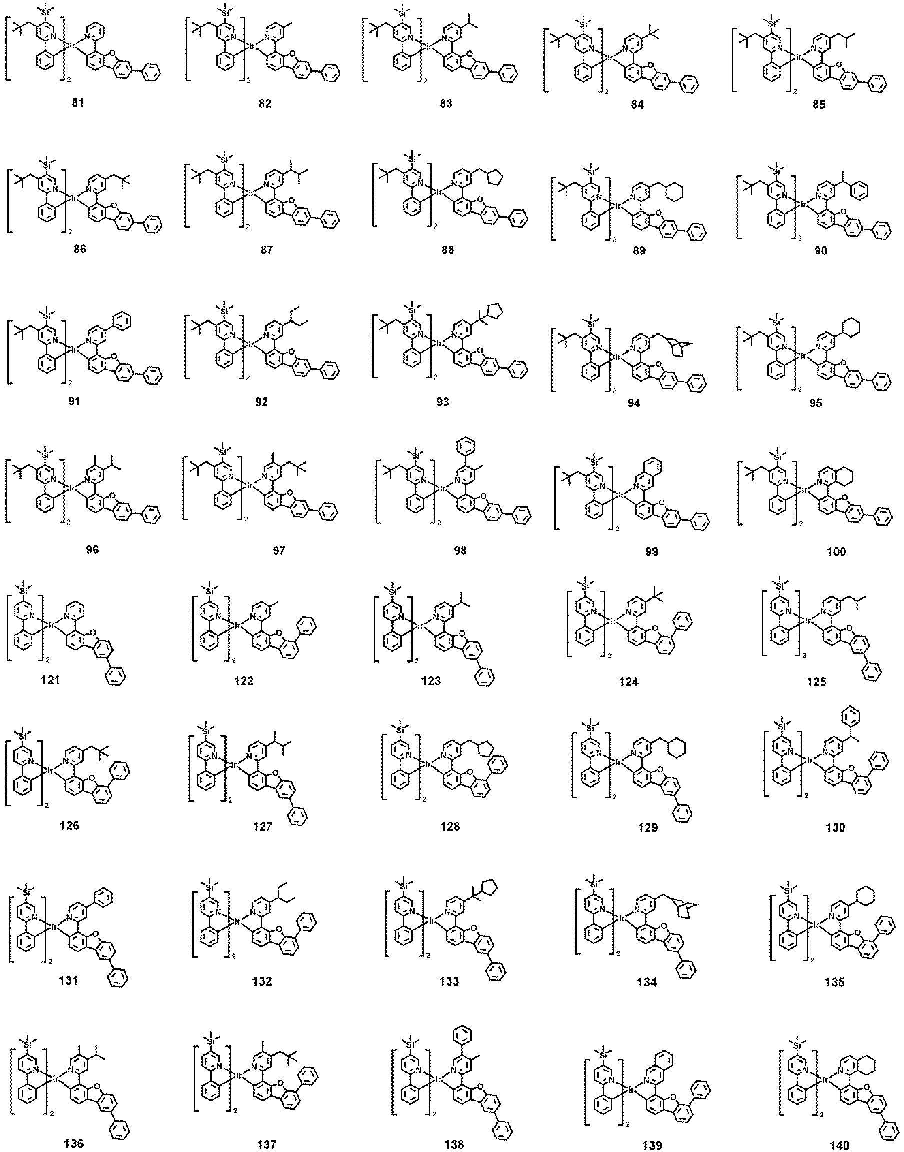

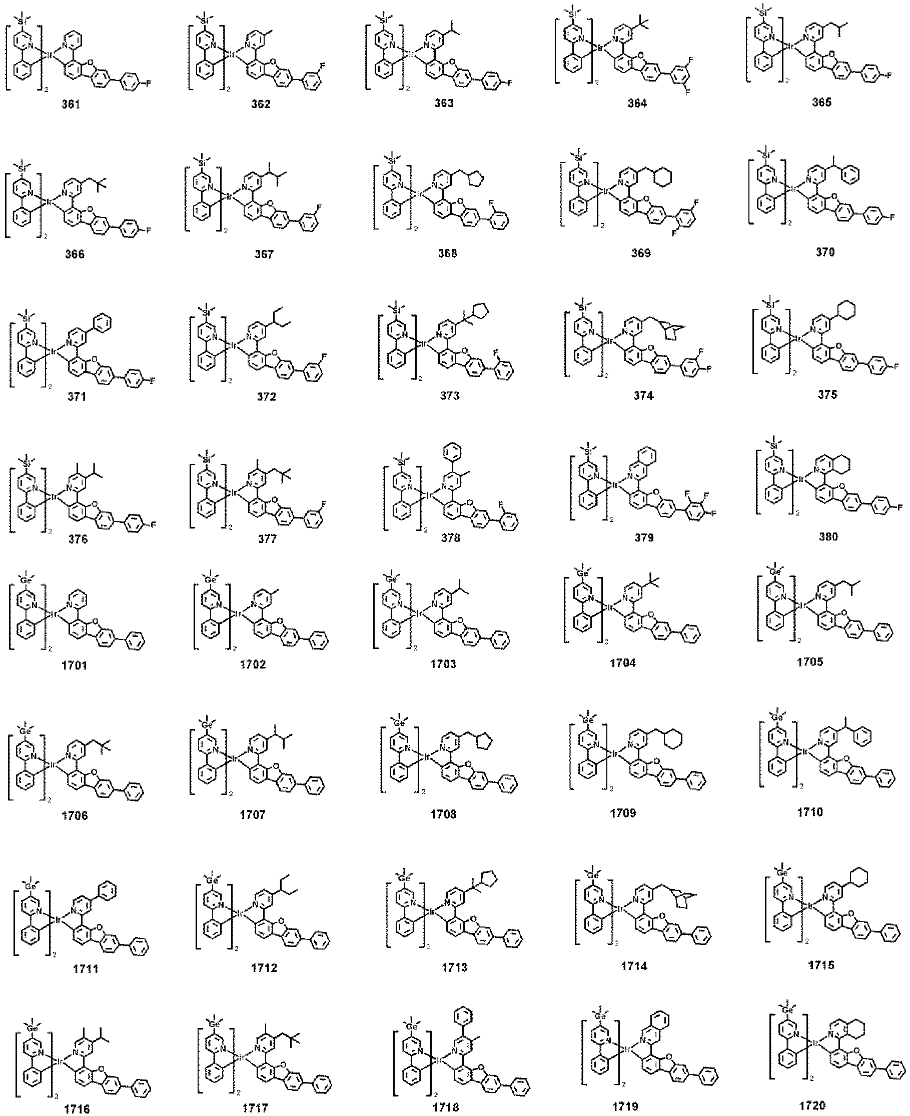

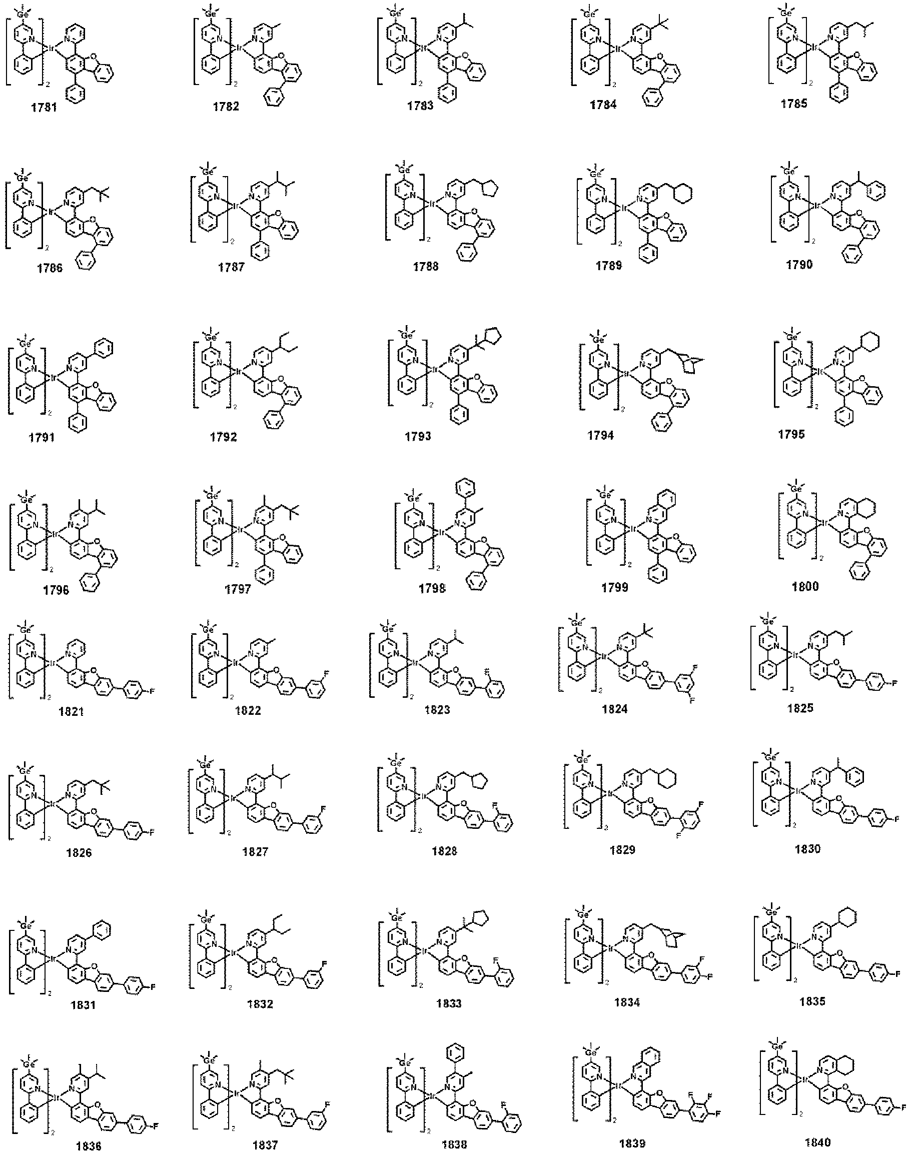

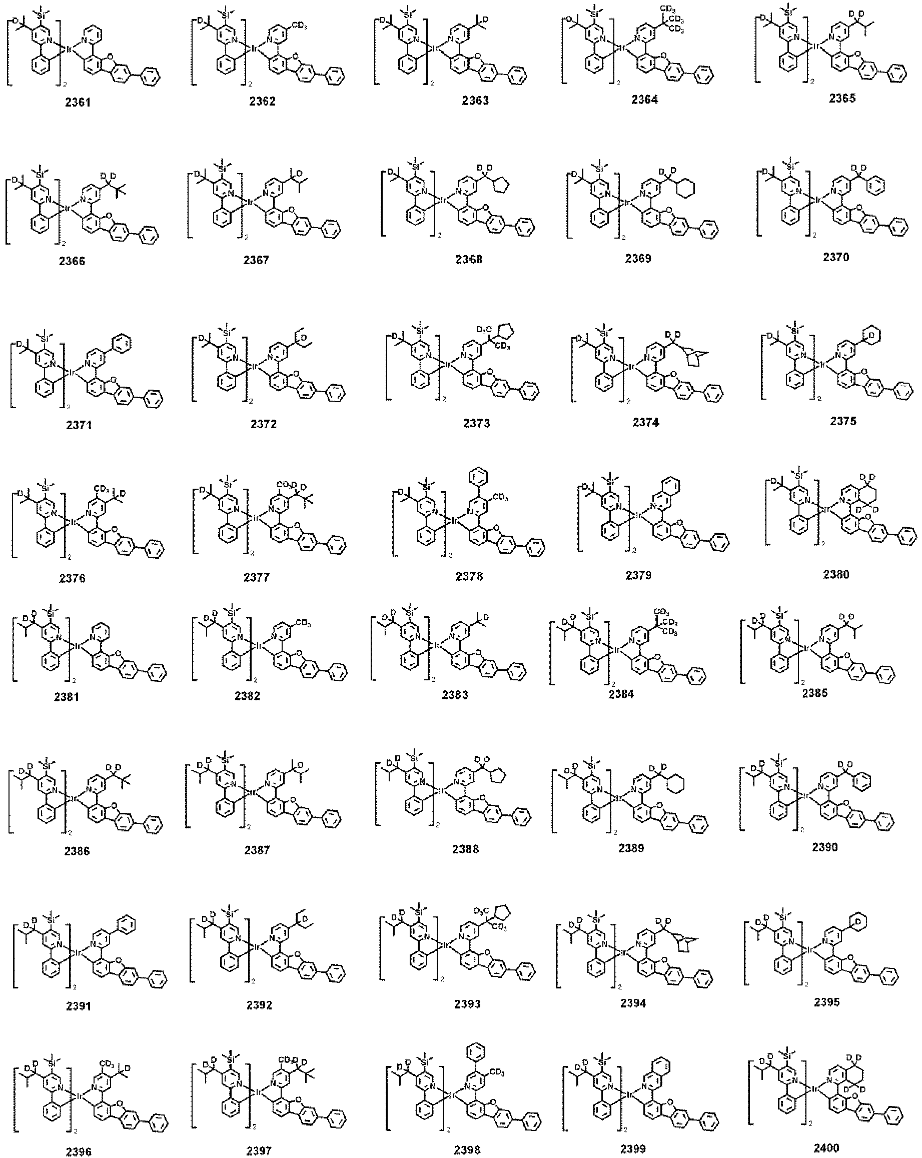

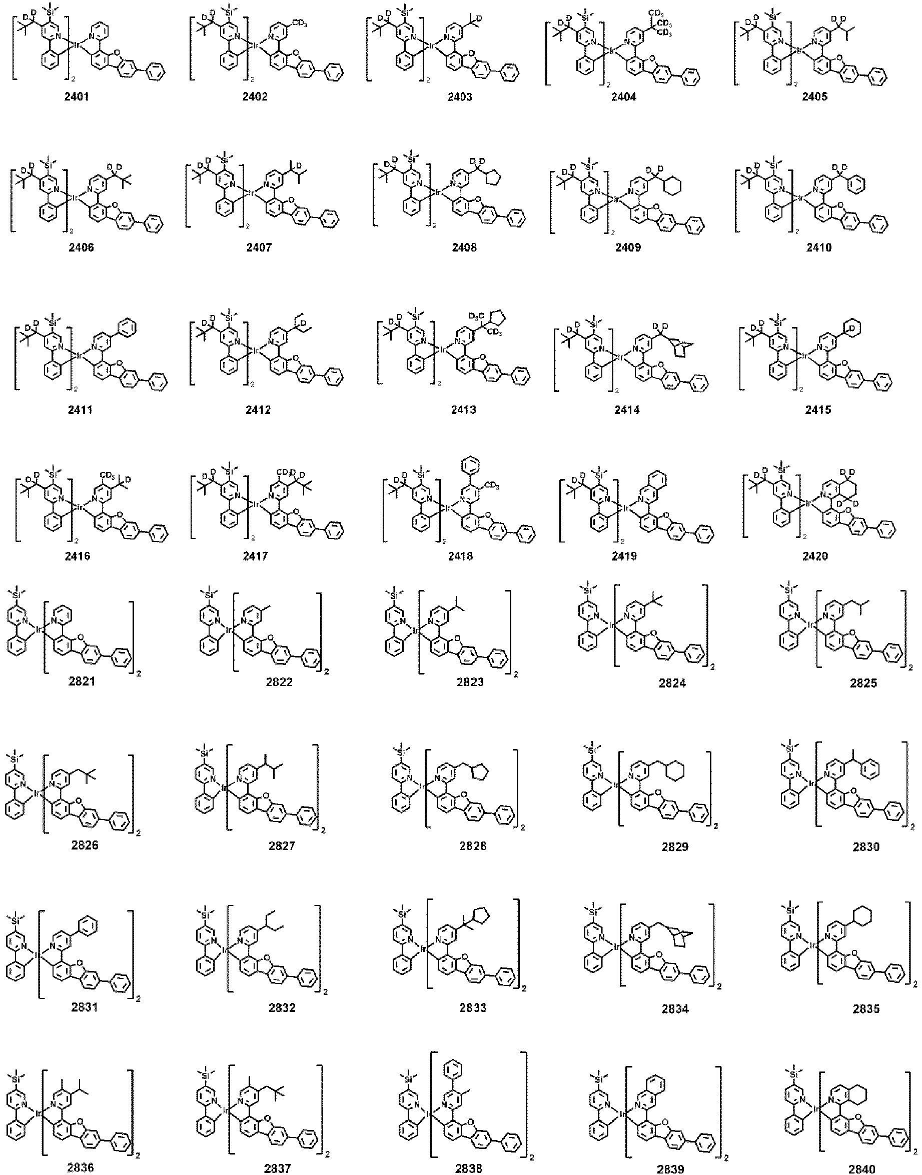

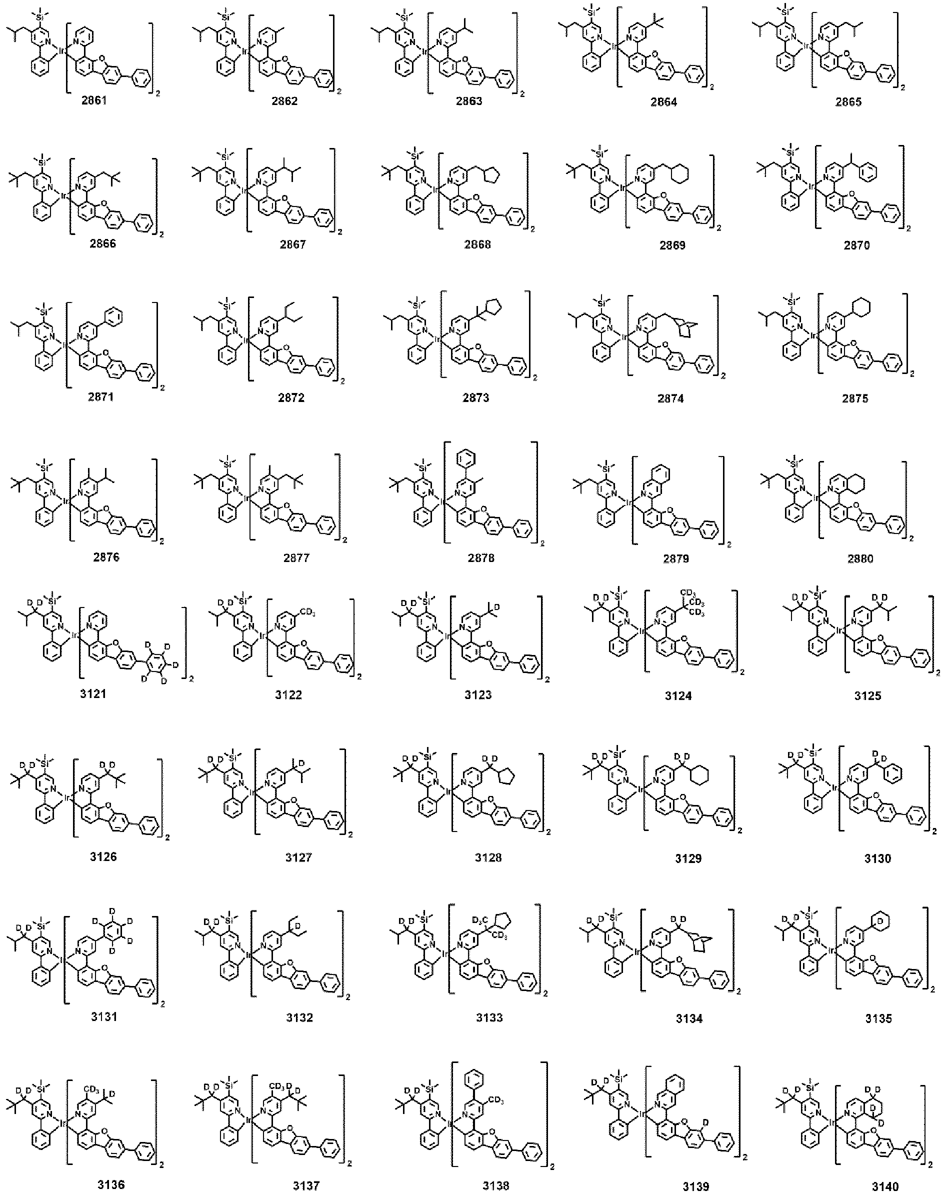

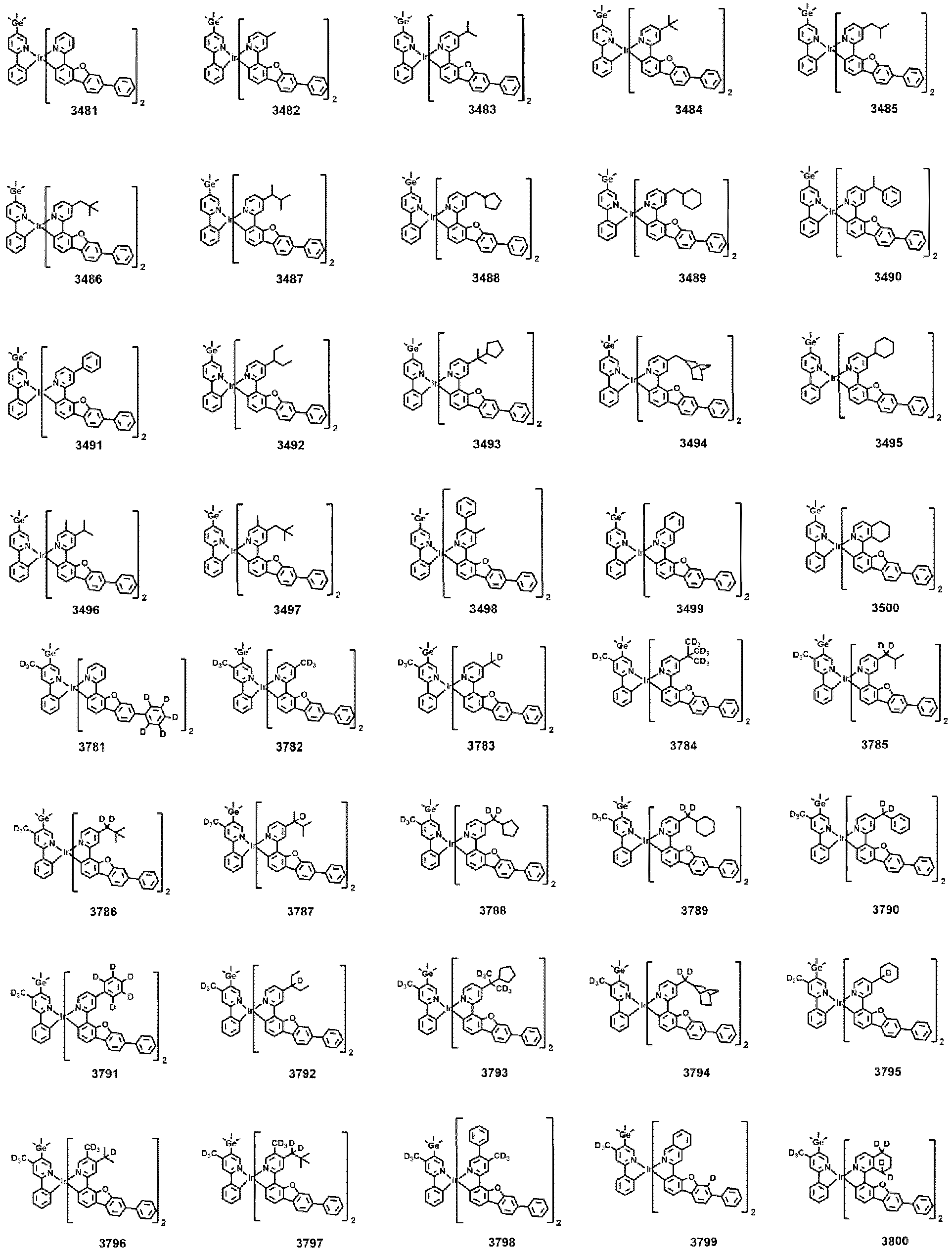

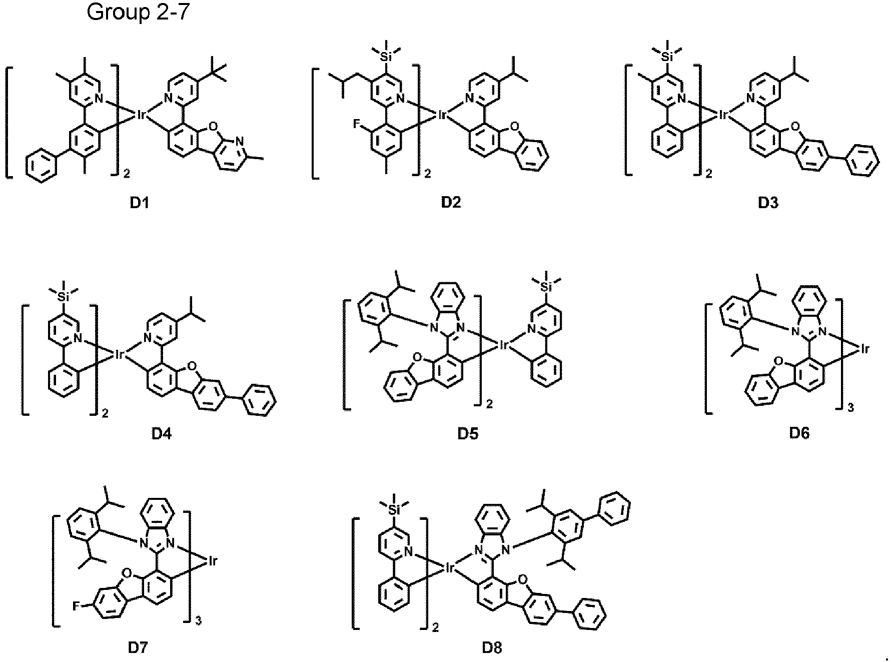

In the present specification, OMe is a methoxy group, TMS is a trimethylsilyl group, and TMG is a trimethylgermyl group.

The first host and the second host may each include a hole-transporting compound, an electron-transporting compound, a bipolar compound, or any combination thereof. Each of the first host and the second host may not include a transition metal.

In an embodiment, the first host and the second host may each include a hole-transporting compound and an electron-transporting compound, and the hole-transporting compound and the electron-transporting compound may be different from each other.

In an embodiment, the hole-transporting compound may include at least one π-electron rich C₃-C₆₀ cyclic group, and may not include an electron-transporting group. Examples of the electron-transporting group may include a cyano group, a fluoro group, a π-electron deficient nitrogen-containing cyclic group, a phosphine oxide group, and a sulfoxide group.

The "π-electron deficient nitrogen-containing cyclic group" as used herein may be a C₁-C₆₀ heterocyclic group which has at least one *-N=*' moiety as a ring-forming moiety. Examples of the π-electron deficient nitrogen-containing cyclic group may include a triazine group and an imidazole group.

The "π-electron rich C₃-C₆₀ cyclic group" may be a C₃-C₆₀ cyclic group that does not include a *-N=*' moiety as a ring-forming moiety. Examples of the π-electron rich C₃-C₆₀ cyclic group may include a benzene group, a naphthalene group, a triphenylene group, a dibenzofuran group, a dibenzothiophene group, a carbazole group, an indolodibenzofuran group, an indolodibenzothiophene group, an indolocarbazole group, a naphthobenzofuran group, a naphthobenzothiophene group, a benzocarbazole group, a phenanthrenobenzofuran group, a phenanthrenobenzothiophene group, a naphthocarbazole group, a dinaphthofuran group, a dinaphthothiophene group, and a dibenzocarbazole group.

For example, the hole-transporting compound may include two or more carbazole groups.

In an embodiment, the electron-transporting compound may be a compound including at least one electron-transporting group. The electron-transporting group may be a cyano group, a fluoro group, a π-electron deficient nitrogen-containing C₁-C₆₀ cyclic group, a phosphine oxide group, a sulfoxide group, or a combination thereof. In an embodiment, the electron-transporting compound may include a triazine group.

For example, the electron-transporting compound may include at least one electron-transporting group (for example, a triazine group) and at least one π-electron rich C₃-C₆₀ cyclic group (for example, a benzene group, a naphthalene group, a triphenylene group, a dibenzofuran group, a dibenzothiophene group, a carbazole group, an indolodibenzofuran group, an indolodibenzothiophene group, an indolocarbazole group, a naphthobenzofuran group, a naphthobenzothiophene group, a benzocarbazole group, a phenanthrenobenzofuran group, a phenanthrenobenzothiophene group, a naphthocarbazole group, a dinaphthofuran group, a dinaphthothiophene group, a dibenzocarbazole group, or any combination thereof).

In an embodiment, the hole-transporting compound may be a compound represented by Formula 6: 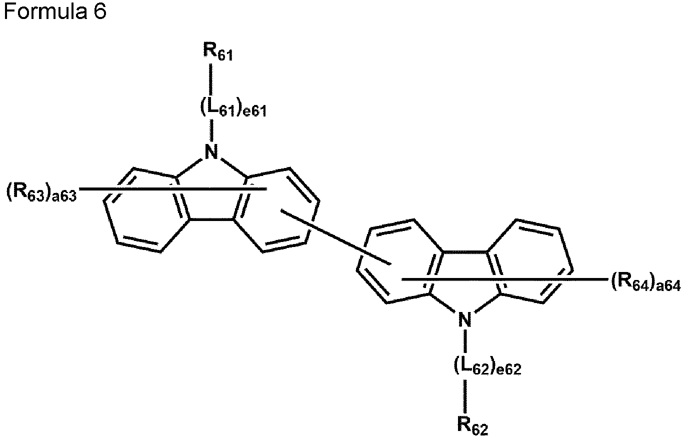 wherein, in Formula 6,
L₆₁ and L₆₂ may each independently be a π-electron rich C₃-C₆₀ cyclic group that is unsubstituted or substituted with deuterium, a C₁-C₂₀ alkyl group, a deuterated C₁-C₂₀ alkyl group, a phenyl group, a deuterated phenyl group, a (C₁-C₂₀ alkyl)phenyl group, a biphenyl group, a deuterated biphenyl group, a (C₁-C₂₀ alkyl)biphenyl group, -Si(Q₃₃)(Q₃₄)(Q₃₅), or any combination thereof,
e61 and e62 may each independently be an integer from 1 to 6,
R₆₁ to R₆₄ may each independently be:
   hydrogen, deuterium, a C₁-C₂₀ alkyl group, or a deuterated C₁-C₂₀ alkyl group;
   a π-electron rich C₃-C₆₀ cyclic group that is unsubstituted or substituted with deuterium, a C₁-C₂₀ alkyl group, a deuterated C₁-C₂₀ alkyl group, a phenyl group, a deuterated a phenyl group, a (C₁-C₂₀ alkyl)phenyl group, a biphenyl group, a deuterated biphenyl group, a (C₁-C₂₀ alkyl)biphenyl group, -Si(Q₃₃)(Q₃₄)(Q₃₅), or any combination thereof; or
      -Si(Q₃)(Q₄)(Q₅), and
      a63 and a64 may each independently be an integer from 0 to 7.
      Q₃ to Q₅ and Q₃₃ to Q₃₅ may respectively be the same as those described in the present specification.

In an embodiment, the hole-transporting compound may be a compound represented by Formula 6-1, 6-2, or 6-3: 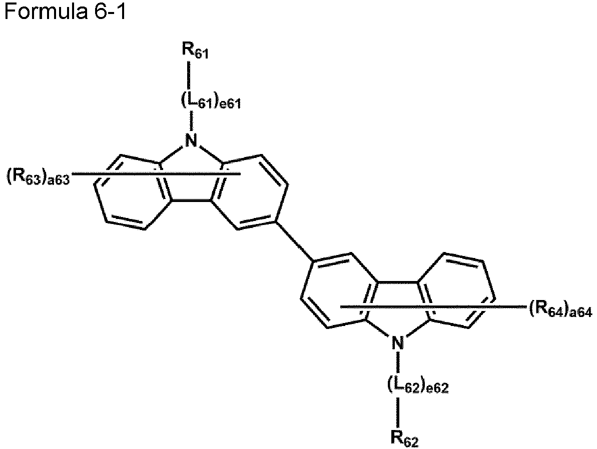 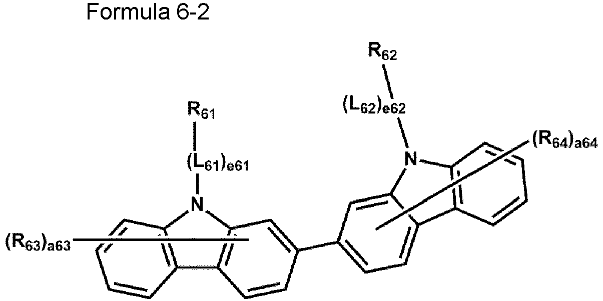 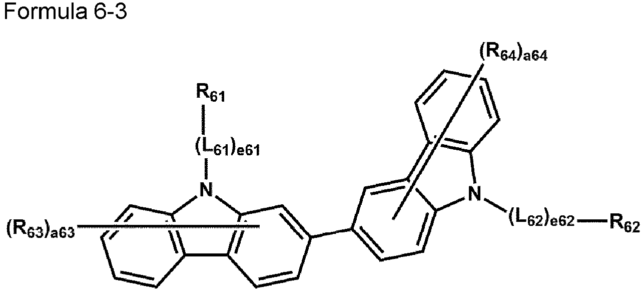 wherein, in Formulae 6-1 to 6-3, L₆₁, L₆₂, R₆₁ to R₆₄, e61, e62, a63, and a64 may respectively be the same as those described in the present specification.

In an embodiment, the hole-transporting compound may be one of Compounds H-HT1 to H-HT5:

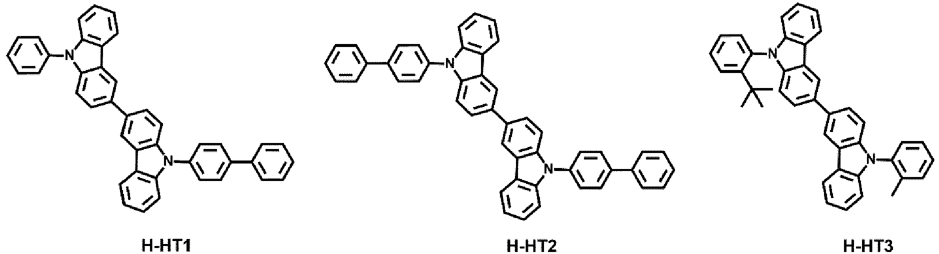

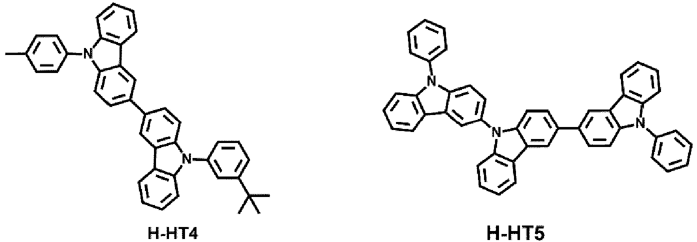

In an embodiment, the electron-transporting compound may be a compound represented by Formula 7: 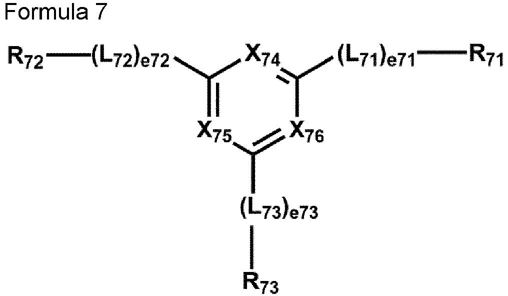 wherein, in Formula 7,
X₇₄ may be C(R₇₄) or N, X₇₅ may be C(R₇₅) or N, X₇₆ may be C(R₇₆) or N, and at least one of X₇₄ to X₇₆ may be N,
L₇₁ to L₇₃ may each independently be a C₅-C₃₀ carbocyclic group or a C₁-C₃₀ heterocyclic group, each unsubstituted or substituted with deuterium, -F, a cyano group, a C₁-C₂₀ alkyl group, a deuterated C₁-C₂₀ alkyl group, a fluorinated C₁-C₂₀ alkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, -Si(Q₃₃)(Q₃₄)(Q₃₅), or any combination thereof,
e71 to e73 may each independently be an integer from 1 to 10, and
R₇₁ to R₇₆ may each independently be:
hydrogen, deuterium, -F, or a cyano group;
a C₁-C₂₀ alkyl group that is unsubstituted or substituted with deuterium, -F, a cyano group, or any combination thereof;
a C₅-C₃₀ carbocyclic group or a C₁-C₃₀ heterocyclic group, each unsubstituted or substituted with deuterium, -F, a cyano group, a C₁-C₂₀ alkyl group, a deuterated C₁-C₂₀ alkyl group, a fluorinated C₁-C₂₀ alkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, -Si(Q₃₃)(Q₃₄)(Q₃₅), or any combination thereof; or
-Si(Q₃)(Q₄)(Q₅).
Q₃ to Q₅ and Q₃₃ to Q₃₅ may respectively be the same as those described in the present specification.

In an embodiment, X₇₄ to X₇₆ in Formula 7 may each be N.

In an embodiment, L₇₁ to L₇₃ in Formula 7 may each independently be a benzene group, a naphthalene group, a triphenylene group, a dibenzofuran group, a dibenzothiophene group, a carbazole group, an indolodibenzofuran group, an indolodibenzothiophene group, an indolocarbazole group, a naphthobenzofuran group, a naphthobenzothiophene group, a benzocarbazole group, a phenanthrenobenzofuran group, a phenanthrenobenzothiophene group, a naphthocarbazole group, a dinaphthofuran group, a dinaphthothiophene group, or dibenzocarbazole group, each unsubstituted or substituted with deuterium, -F, a cyano group, a C₁-C₂₀ alkyl group, a deuterated C₁-C₂₀ alkyl group, a fluorinated C₁-C₂₀ alkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, -Si(Q₃₃)(Q₃₄)(Q₃₅), or any combination thereof.

In an embodiment, in Formula 7, at least one of e71 L₇₁, at least one of e72 L₇₂, at least one of e73 L₇₃, or any combination thereof may each independently be a dibenzofuran group, a dibenzothiophene group, a carbazole group, an indolodibenzofuran group, an indolodibenzothiophene group, an indolocarbazole group, a naphthobenzofuran group, a naphthobenzothiophene group, a benzocarbazole group, a phenanthrenobenzofuran group, a phenanthrenobenzothiophene group, a naphthocarbazole group, a dinaphthofuran group, a dinaphthothiophene group, or dibenzocarbazole group, each unsubstituted or substituted with deuterium, -F, a cyano group, a C₁-C₂₀ alkyl group, a deuterated C₁-C₂₀ alkyl group, a fluorinated C₁-C₂₀ alkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, -Si(Q₃₃)(Q₃₄)(Q₃₅) or any combination thereof.

In an embodiment, in Formula 7, at least one of e71 L₇₁, at least one of e72 L₇₂, at least one of e73 L₇₃, or any combination thereof may include a carbazole group, an indolocarbazole group, a benzocarbazole group, a naphthocarbazole group, or a dibenzocarbazole group, and a nitrogen atom of a pyrrole group in the carbazole group, the indolocarbazole group, the benzocarbazole group, the naphthocarbazole group, or the dibenzocarbazole group may be connected to a carbon atom of a 6-membered ring including X₇₄ to X₇₆ in Formula 7 with a single bond or neighboring L₇₁, L₇₂, and/or L₇₃ therebetween.

In an embodiment, e71 to e73 in Formula 7 indicate numbers of L₇₁ to L₇₃, respectively, and may each independently be, for example, 1, 2, 3, 4, or 5.

In an embodiment, R₇₁ to R₇₆ in Formula 7 may each independently be:
hydrogen, deuterium, -F, or a cyano group;
a C₁-C₂₀ alkyl group that is unsubstituted or substituted with deuterium, -F, a cyano group, or any combination thereof;
a benzene group, a naphthalene group, a triphenylene group, a dibenzofuran group, a dibenzothiophene group, a carbazole group, an indolodibenzofuran group, an indolodibenzothiophene group, an indolocarbazole group, a naphthobenzofuran group, a naphthobenzothiophene group, a benzocarbazole group, a phenanthrenobenzofuran group, a phenanthrenobenzothiophene group, a naphthocarbazole group, a dinaphthofuran group, a dinaphthothiophene group, or a dibenzocarbazole group, each unsubstituted or substituted with deuterium, -F, a cyano group, a C₁-C₂₀ alkyl group, a deuterated C₁-C₂₀ alkyl group, a fluorinated C₁-C₂₀ alkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, -Si(Q₃₃)(Q₃₄)(Q₃₅), or any combination thereof; or
-Si(Q₃)(Q₄)(Q₅).

In an embodiment, the electron-transporting compound may be one of Compounds H-ET1 to H-ET6:

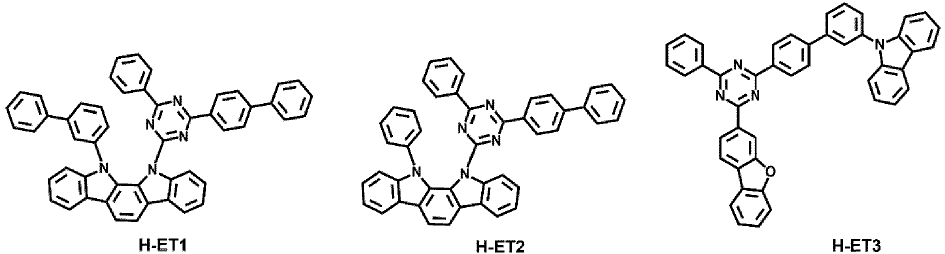

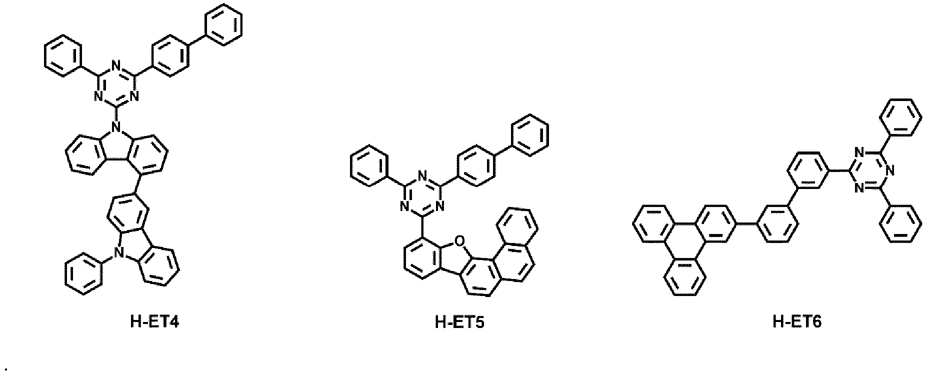

In an embodiment, each of the first emission layer and the second emission layer may not include compounds of Group A:

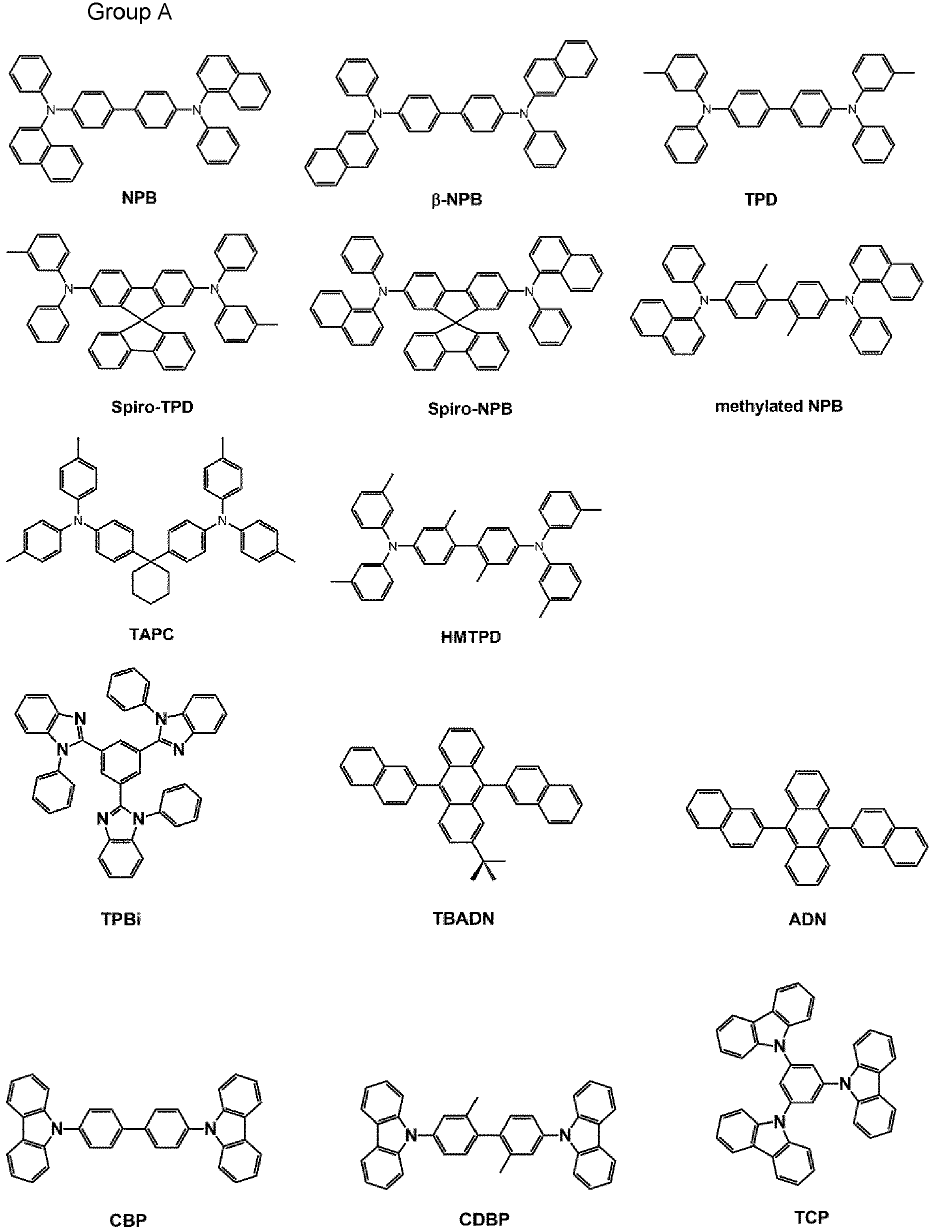

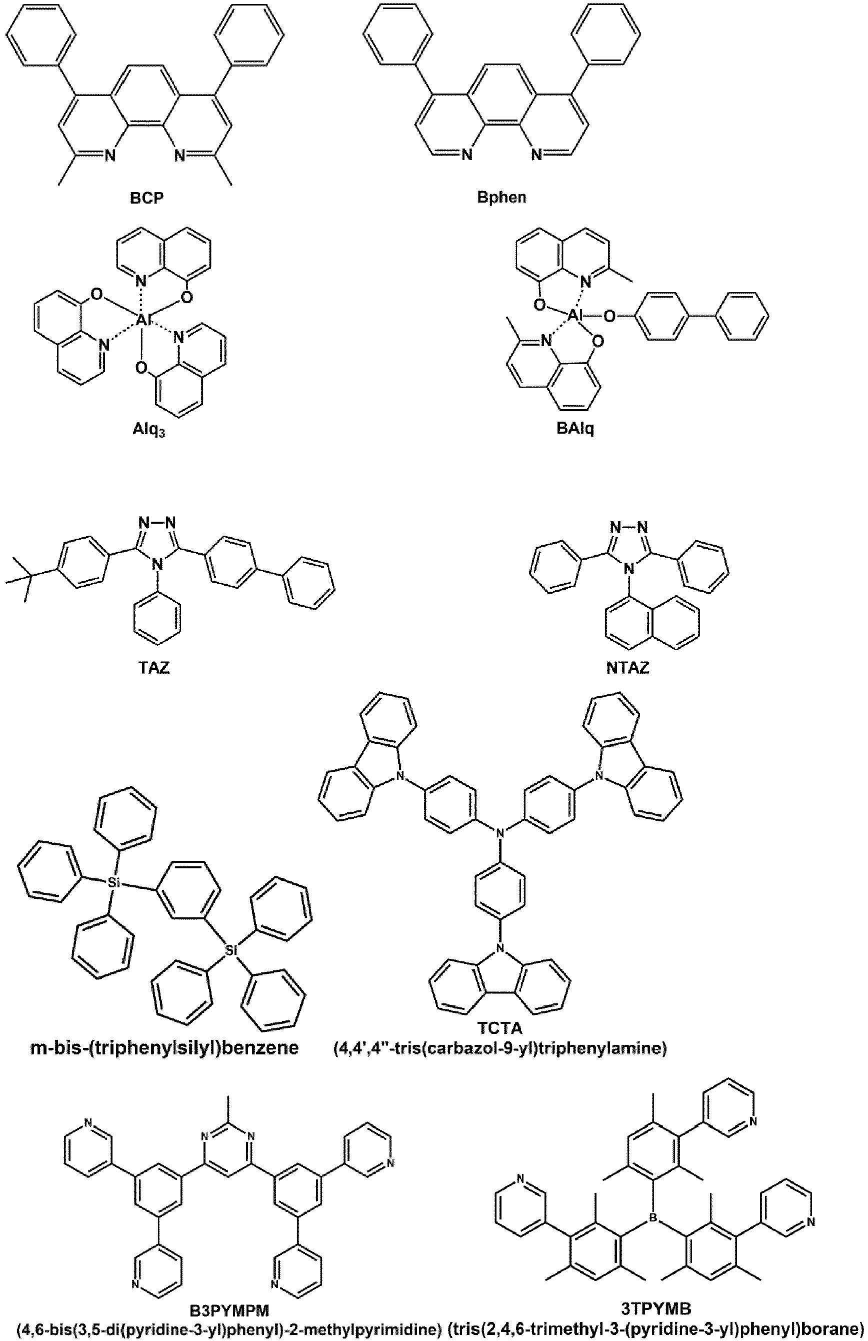

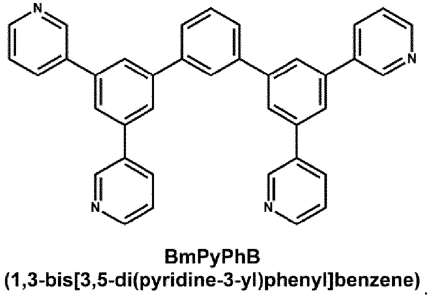

In an embodiment, the interlayer of the light-emitting device may further include a hole transport region arranged between the first electrode and the emission layer and an electron transport region arranged between the emission layer and the second electrode.

The hole transport region may include a hole injection layer, a hole transport layer, an electron blocking layer, a buffer layer, or any combination thereof, and the electron transport region may include a hole blocking layer, an electron transport layer, an electron injection layer, or any combination thereof.

The term "interlayer" as used herein refers to a single layer and/or a plurality of layers arranged between the first electrode and the second electrode of the light-emitting device. The term "interlayer" may include an organometallic compound and an organometallic complex including a metal.

Meanwhile, the interlayer of the light-emitting device may include:
m light-emitting units including at least one emission layer; and
m-1 charge generation layers arranged between two adjacent light-emitting units among the m light-emitting units.
m may be an integer of 2 or more.

In other words, the light-emitting device may be a tandem light-emitting device.

For example, m may be 2, 3, 4, 5, 6, 7, 8, 9, or 10. In an embodiment, m may be 2, 3, 4, 5, or 6.

In an embodiment, i) a first light-emitting unit among the m light-emitting units may include the first emission layer, and a second light-emitting unit among the m light-emitting units may include the second emission layer, or ii) one light-emitting unit among the m light-emitting units may include both the first emission layer and the second emission layer. The first emission layer and the second emission layer may respectively be the same as those described in the present specification.

In an embodiment, a first light-emitting unit among the m light-emitting units may include the first emission layer, a second light-emitting unit among the m light-emitting units may include the second emission layer, and each of the first light-emitting unit and the second light-emitting unit may emit green light.

In an embodiment, a first light-emitting unit among the m light-emitting units may include the first emission layer, a second light-emitting unit among the m light-emitting units may include the second emission layer, and the first light-emitting unit may be arranged between the second light-emitting unit and the second electrode.

In an embodiment, a first light-emitting unit among the m light-emitting units may include the first emission layer, a second light-emitting unit among the m light-emitting units may include the second emission layer, and the second light-emitting unit may be arranged between the first light-emitting unit and the second electrode.

In an embodiment, one light-emitting unit among the m light-emitting units may include both the first emission layer and the second emission layer, and the one light-emitting unit including both the first emission layer and the second emission layer may emit green light. In this regard, the first emission layer may be arranged between the second emission layer and the second electrode. In an embodiment, the second emission layer may be arranged between the first emission layer and the second electrode.

In an embodiment, at least one light-emitting unit among the m light-emitting units may emit blue light.

According to one or more embodiments, the light-emitting device may be included in an electronic apparatus. Thus, an electronic apparatus including the light-emitting device is provided. The electronic apparatus may include, for example, a display, an illumination, a sensor, and the like.

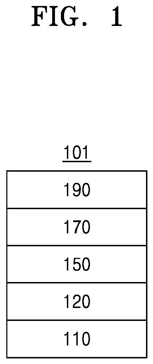

FIG. 1 schematically illustrates a cross-sectional view of an organic light-emitting device 101, which is a light-emitting device according to an embodiment. Hereinafter, a structure of an organic light-emitting device according to an embodiment and a method of manufacturing an organic light-emitting device according to an embodiment will be described in connection with FIG. 1.

The organic light-emitting device 101 of FIG. 1 includes a first electrode 110, a second electrode 190, and an interlayer (not shown) arranged between the first electrode 110 and the second electrode 190, wherein the interlayer includes a hole transport region 120, an emission layer 150, and an electron transport region 170.

A substrate may be additionally arranged under the first electrode 110 or above the second electrode 190. For use as the substrate, any substrate that is used in organic light-emitting devices available in the art may be used, and the substrate may be a glass substrate or a transparent plastic substrate, each having excellent mechanical strength, thermal stability, transparency, surface smoothness, ease of handling, and water resistance.

The first electrode 110 may be formed by providing, on the substrate, a material for forming the first electrode 110, by using a deposition or sputtering method. The first electrode 110 may be an anode. The material for forming the first electrode 110 may include materials with a high work function to facilitate hole injection. The first electrode 110 may be a reflective electrode. The material for forming the first electrode 110 may be indium tin oxide (ITO), indium zinc oxide (IZO), tin oxide (SnO₂), or zinc oxide (ZnO). In an embodiment, the material for forming the first electrode 110 may be metal, such as magnesium (Mg), aluminum (Al), silver (Ag), aluminum-lithium (Al-Li), calcium (Ca), magnesium-indium (Mg-In), or magnesium-silver (Mg-Ag).

The first electrode 110 may have a single-layered structure or a multilayer structure including two or more layers. For example, the first electrode 110 may have a three-layered structure of ITO/Ag/ITO.

The hole transport region 120 may be arranged between the first electrode 110 and the emission layer 150.

The hole transport region 120 may include a hole injection layer, a hole transport layer, an electron blocking layer, a buffer layer, or any combination thereof.

The hole transport region 120 may include only a hole injection layer or only a hole transport layer. In an embodiment, the hole transport region 120 may have a hole injection layer/hole transport layer structure or a hole injection layer/hole transport layer/electron blocking layer structure, which are sequentially stacked in this stated order from the first electrode 110.

When the hole transport region 120 includes a hole injection layer, the hole injection layer (HIL) may be formed on the first electrode 110 by using various methods, such as, a vacuum deposition method, a spin coating method, a casting method, a Langmuir-Blodgett (LB) method, and/or an ink-jet printing method.

When a hole injection layer is formed by vacuum deposition, the deposition conditions may vary depending on a material that is used to form the hole injection layer, and the structure and thermal characteristics of the hole injection layer. For example, the deposition conditions may include a deposition temperature of about 100 °C to about 500 °C, a vacuum pressure of about 10⁻⁸ torr to about 10⁻³ torr, and a deposition rate of about 0.01 Å/sec to about 100 Å/sec.

When the hole injection layer is formed by spin coating, the coating conditions may vary depending on a material for forming the hole injection layer, and the structure and thermal characteristics of the hole injection layer. For example, the coating conditions may include a coating speed of about 2,000 rpm to about 5,000 rpm and a heat treatment temperature of about 80 °C to about 200 °C for removing a solvent after coating.

Conditions for forming a hole transport layer and an electron blocking layer may be understood by referring to conditions for forming the hole injection layer.

The hole transport region 120 may include, for example, m-MTDATA, TDATA, 2-TNATA, NPB, β-NPB, TPD, Spiro-TPD, Spiro-NPB, methylated NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), a compound represented by Formula 201, a compound represented by Formula 202, or any combination thereof: 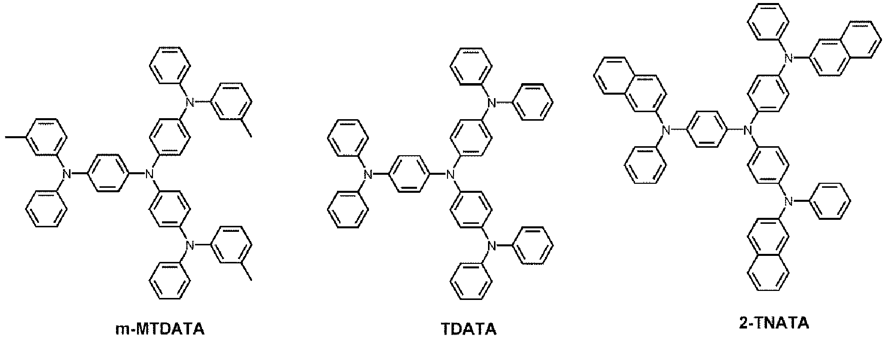 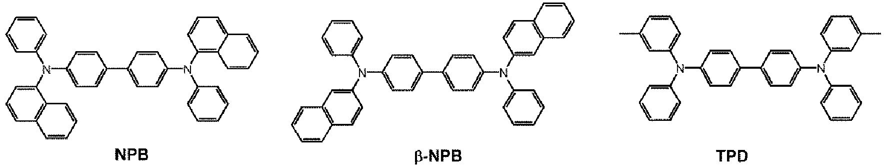 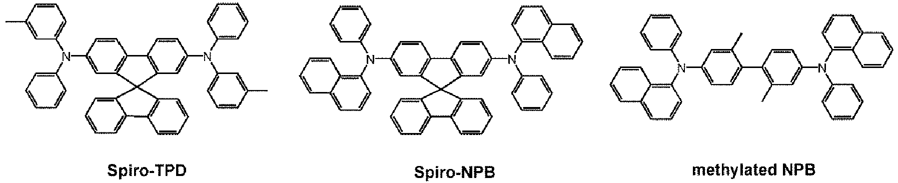 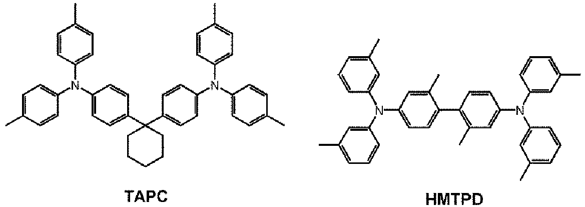 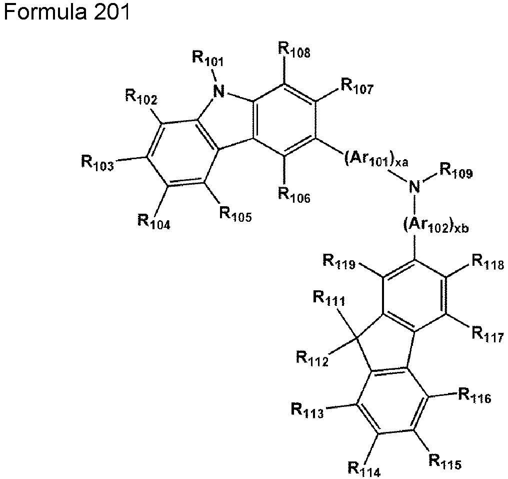 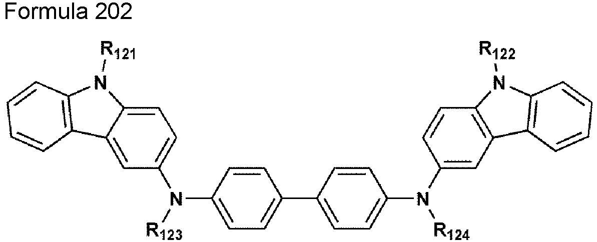
wherein, in Formula 201, Ar₁₀₁ and Ar₁₀₂ may each independently be a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group, each unsubstituted or substituted with deuterium, -F, -Cl, -Br, -I, a hydroxyl group, a cyano group, a nitro group, an amino group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₃-C₁₀ cycloalkenyl group, a C₁-C₁₀ heterocycloalkyl group, a C₁-C₁₀ heterocycloalkenyl group, a C₆-C₆₀ aryl group, a C₆-C₆₀ aryloxy group, a C₆-C₆₀ arythio group, a C₁-C₆₀ heteroaryl group, a monovalent non-aromatic condensed polycyclic group, a monovalent non-aromatic condensed heteropolycyclic group, or any combination thereof.
xa and xb in Formula 201 may each independently be an integer from 0 to 5, or 0, 1, or 2. For example, xa may be 1, and xb may be 0.
R₁₀₁ to R₁₀₈, R₁₁₁ to R₁₁₉, and R₁₂₁ to R₁₂₄ in Formulae 201 and 202 may each independently be:
   hydrogen, deuterium, -F, -Cl, -Br, -I, a hydroxyl group, a cyano group, a nitro group, an amino group, a C₁-C₁₀ alkyl group (for example, a methyl group, an ethyl group, a propyl group, a butyl group, a pentyl group, or a hexyl group), or a C₁-C₁₀ alkoxy group (for example, a methoxy group, an ethoxy group, a propoxy group, a butoxy group, or a pentoxy group);
   a C₁-C₁₀ alkyl group or a C₁-C₁₀ alkoxy group, each unsubstituted or substituted with deuterium, -F, -Cl, -Br, -I, a hydroxyl group, a cyano group, a nitro group, an amino group, or any combination thereof; or
   a phenyl group, a naphthyl group, an anthracenyl group, a fluorenyl group, or a pyrenyl group, each unsubstituted or substituted with deuterium, -F, -Cl, -Br, -I, a hydroxyl group, a cyano group, a nitro group, an amino group, a C₁-C₁₀ alkyl group, a C₁-C₁₀ alkoxy group, or any combination thereof.

In Formula 201, R₁₀₉ may be a phenyl group, a naphthyl group, an anthracenyl group, or a pyridinyl group, each unsubstituted or substituted with deuterium, -F, -Cl, -Br, -I, a hydroxyl group, a cyano group, a nitro group, an amino group, a C₁-C₂₀ alkyl group, a C₁-C₂₀ alkoxy group, a phenyl group, a naphthyl group, an anthracenyl group, a pyridinyl group, or any combination thereof.

In an embodiment, the compound represented by Formula 201 may be represented by Formula 201A: 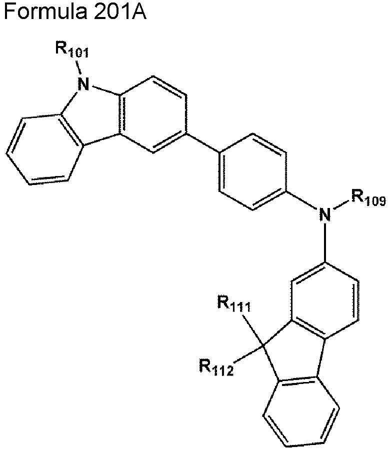 wherein, in Formula 201A, R₁₀₁, R₁₁₁, R₁₁₂, and R₁₀₉ may respectively be the same as those described above.
For example, the hole transport region 120 may include one of Compounds HT1 to HT20 or any combination thereof:

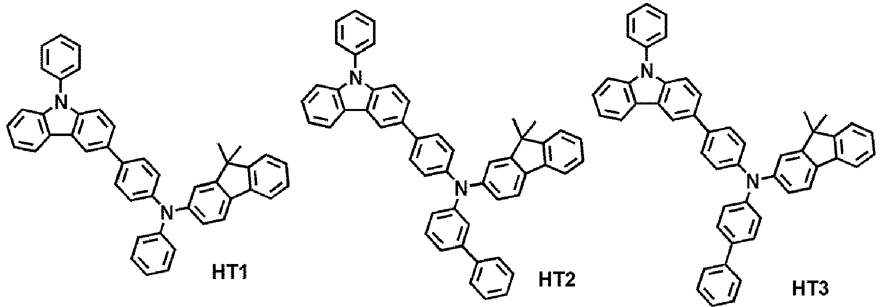

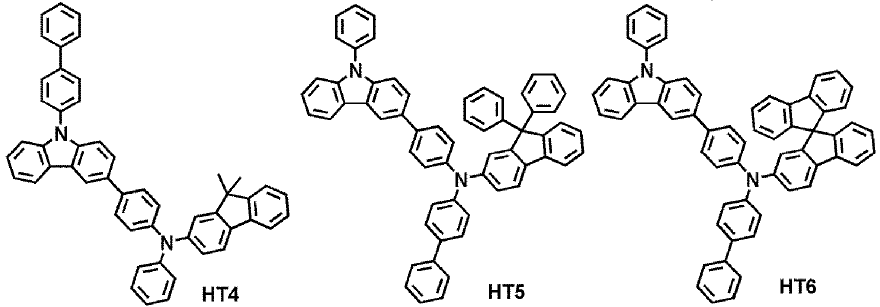

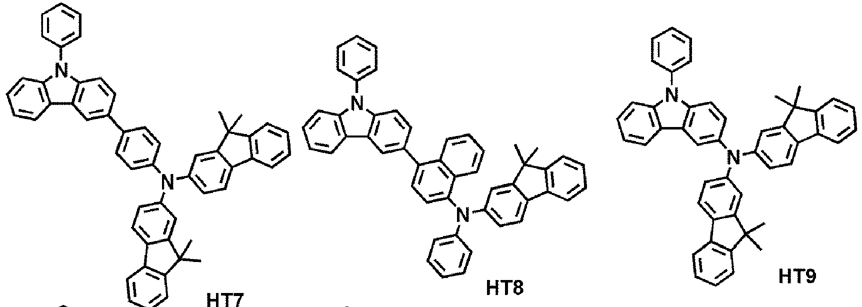

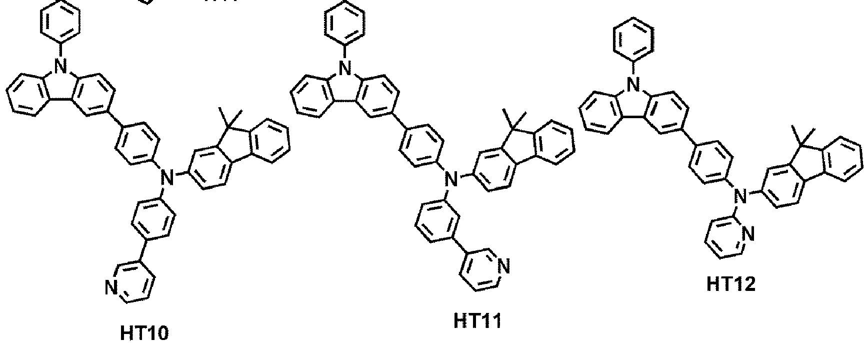

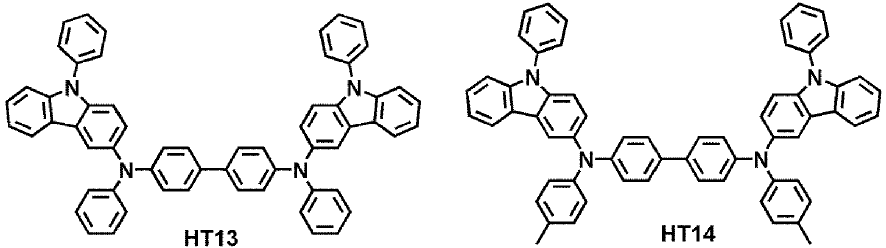

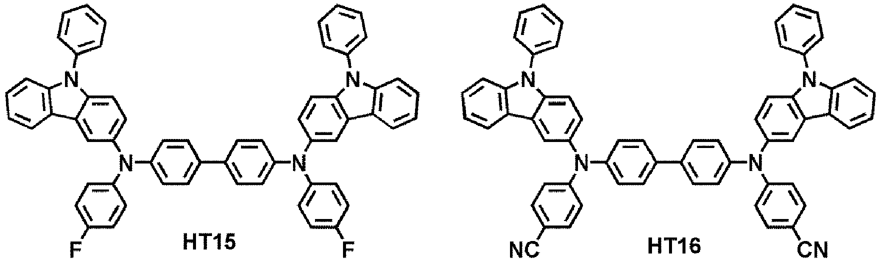

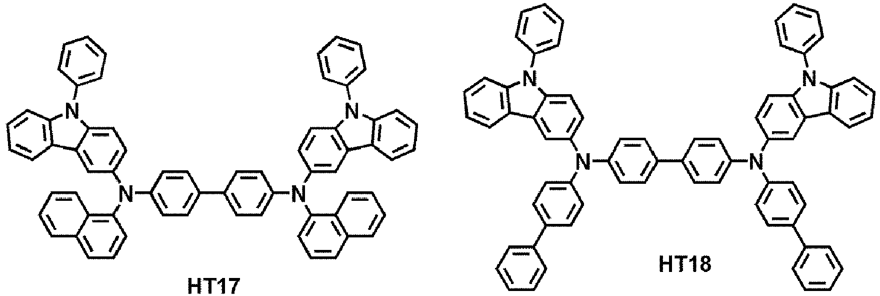

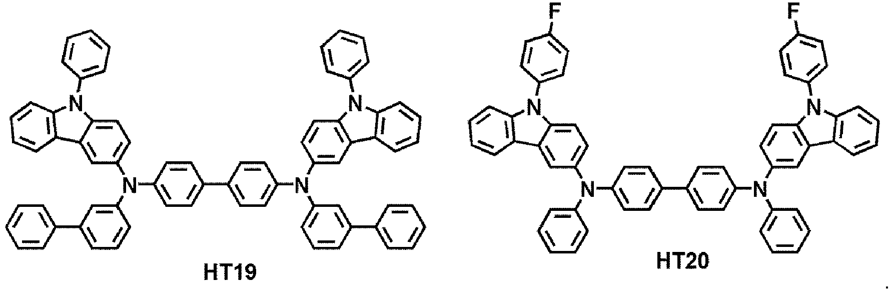

A thickness of the hole transport region 120 may be about 100 Å to about 10,000 Å, for example, about 100 Å to about 1,000 Å. When the hole transport region 120 includes a hole injection layer, a hole transport layer, an electron blocking layer, or a combination thereof, a thickness of the hole injection layer may be about 100 Å to about 10,000 Å, for example, about 100 Å to about 1,000 Å, and a thickness of the hole transport layer may be about 50 Å to about 2,000 Å, for example, about 100 Å to about 1,500 Å. When the thicknesses of the hole transport region 120, the hole injection layer, and the hole transport layer are within these ranges as described above, satisfactory hole transporting characteristics may be obtained without a substantial increase in driving voltage.

In addition to the above-described materials, the hole transport region 120 may further include a charge-generation material to improve conductivity. The charge-generation material may be homogeneously or non-homogeneously dispersed in the hole transport region.

The charge-generation material may be, for example, a p-dopant. The p-dopant may be a quinone derivative, a metal oxide, a cyano group-containing compound, or any combination thereof. For example, the p-dopant may be: a quinone derivative such as tetracyanoquinonedimethane (TCNQ), 2,3,5,6-tetrafluoro-tetracyano-1,4-benzoquinonedimethane (F4-TCNQ), or F6-TCNNQ; metal oxide, such as tungsten oxide and molybdenum oxide; a cyano group-containing compound, such as Compound HT-D1; or any combination thereof.

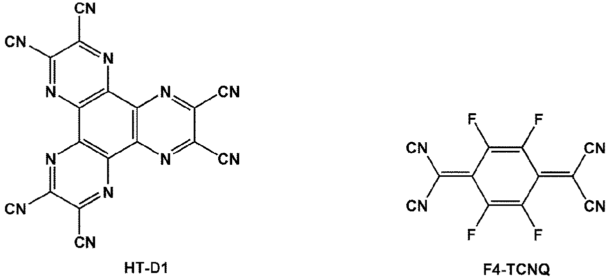

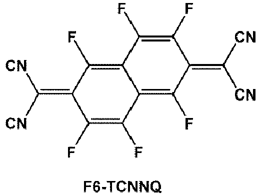

The hole transport region 120 may further include a buffer layer.

The buffer layer may compensate for an optical resonance distance according to a wavelength of light emitted from the emission layer, and thus, efficiency may be increased.

Meanwhile, when the hole transport region 120 includes an electron blocking layer, the material for the electron blocking layer may include a material that may be used in the hole transport region 120 as described above, a host material, or any combination thereof. For example, when a hole transport region includes an electron blocking layer, mCP or Compound HT(1) may be used as a material for the electron blocking layer.

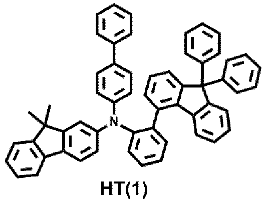

The emission layer 150 may be formed on the hole transport region 120 by using, for example, a vacuum deposition method, a spin coating method, a casting method, an LB method, and/or an ink-jet printing method. When the emission layer 150 is formed by vacuum deposition or spin coating, the deposition or coating conditions may be similar to those applied in forming the hole injection layer although the deposition or coating conditions may vary depending on a compound that is used to form the emission layer.

The emission layer 150 may include a first emission layer and a second emission layer as described in the present specification. The first emission layer and the second emission layer may respectively be the same as those described in the present specification.

A thickness of the emission layer 150 may be about 100 Å to about 1,000 Å, for example, about 200 Å to about 600 Å. When the thickness of the emission layer 150 is within the range as described above, excellent light-emission characteristics may be obtained without a substantial increase in driving voltage.

A thickness ratio of the first emission layer to the second emission layer may be 8:2 to 2:8, 7:3 to 3:7, or 6:4 to 4:6.

When the light-emitting device is a full-color light-emitting device, the emission layer 150 may be patterned into a red emission layer, a green emission layer, and/or a blue emission layer.

Next, the electron transport region 170 may be arranged on the emission layer 150.

The electron transport region 170 may include a hole blocking layer, an electron transport layer, an electron injection layer, or any combination thereof.

For example, the electron transport region 170 may have a hole blocking layer/electron transport layer/electron injection layer structure, a hole blocking layer/electron transport layer structure, or an electron transport layer/electron injection layer structure. The electron transport layer may have a single-layered structure or a multilayer structure including two or more different materials.

The conditions for the forming the hole blocking layer, the electron transport layer, and the electron injection layer in the electron transport region 170 are the same as the conditions for the forming the hole injection layer.

When the electron transport region 170 includes a hole blocking layer, the hole blocking layer may include, for example, BCP, Bphen, BAIq, or any combination thereof:

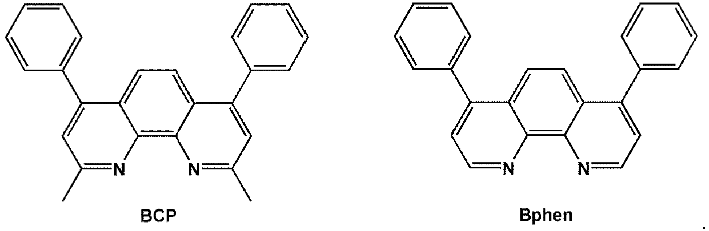

In an embodiment, the hole blocking layer may include any host material, a material for an electron transport layer, a material for an electron injection layer, or a combination thereof, which will be described later.

A thickness of the hole blocking layer may be about 20 Å to about 1,000 Å, for example, about 30 Å to about 600 Å. When the thickness of the hole blocking layer is within the range as described above, excellent hole blocking characteristics may be obtained without a substantial increase in driving voltage.

The electron transport layer may include BCP, Bphen, TPBi, Alq₃, BAlq, TAZ, NTAZ, or any combination thereof:

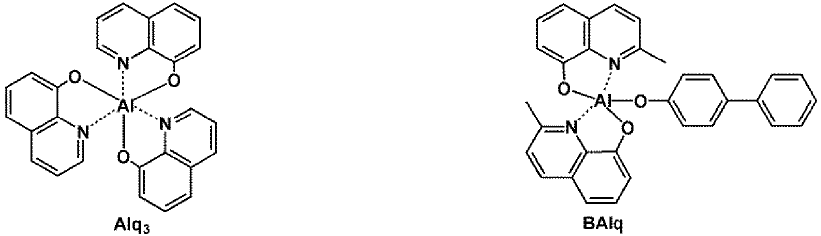

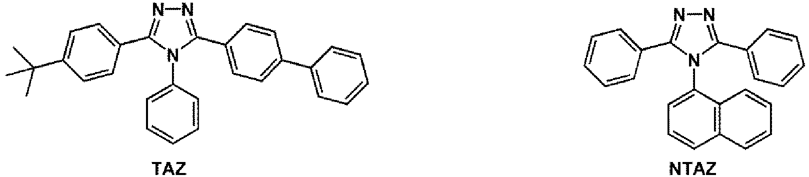

In an embodiment, the electron transport layer may include one of Compounds ET1 to ET25 or any combination thereof:

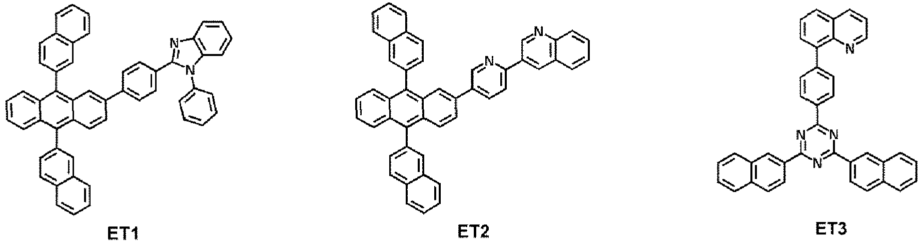

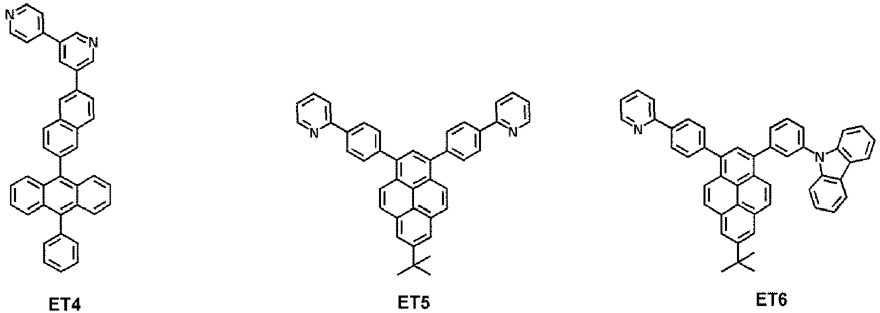

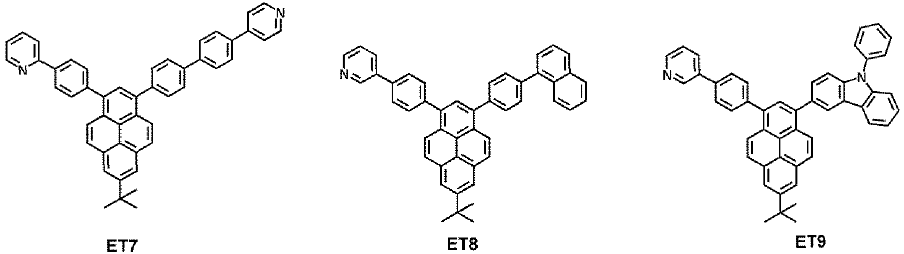

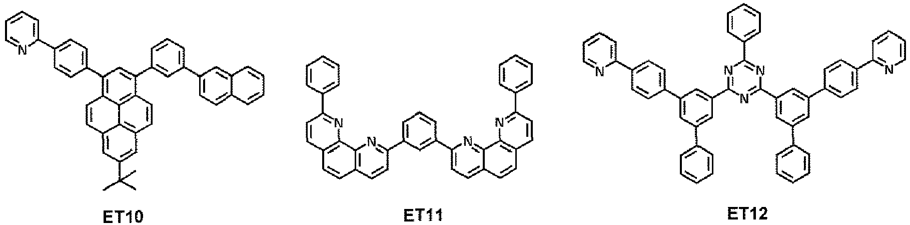

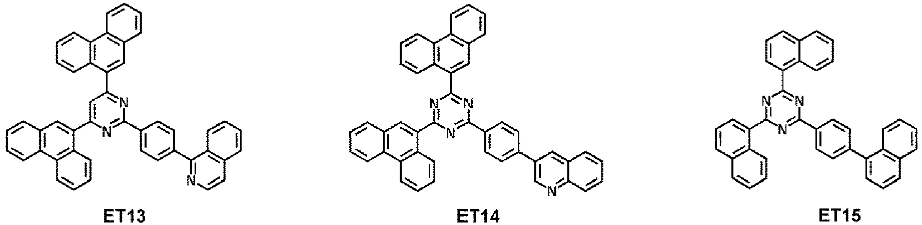

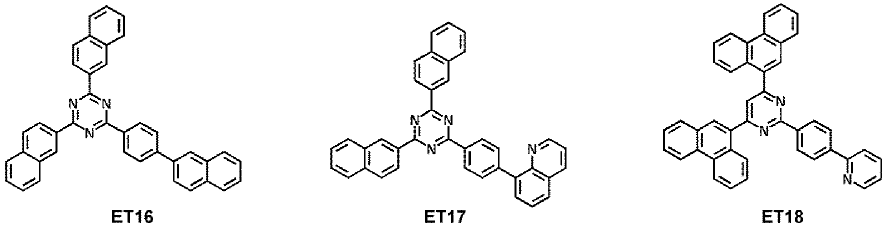

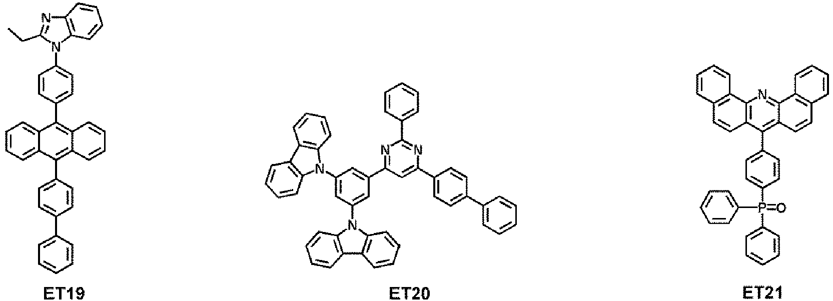

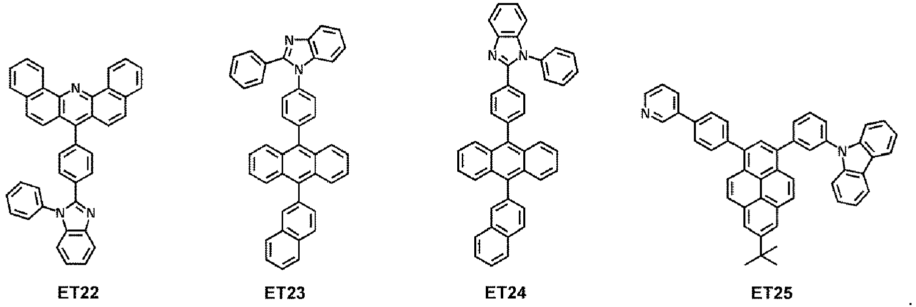

A thickness of the electron transport layer may be in a range of about 100 Å to about 1,000 Å, for example, about 150 Å to about 500 Å. When the thickness of the electron transport layer is within the range as described above, satisfactory electron transport characteristics may be obtained without a substantial increase in driving voltage.

Also, the electron transport layer may further include, in addition to the materials described above, a metal-containing material.

The metal-containing material may include a Li complex. The Li complex may include, for example, Compound ET-D1 or ET-D2.

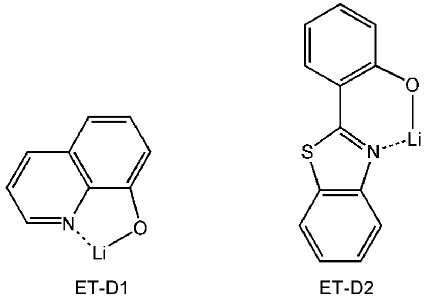

In addition, the electron transport region 170 may include an electron injection layer (EIL) that facilitates injection of electrons from the second electrode 190.

The electron injection layer may include LiF, NaCl, CsF, Li₂O, BaO, Yb, Compound ET-D1, Compound ET-D2, or any combination thereof.

A thickness of the electron injection layer may be about 1 Å to about 100 Å, for example, about 3 Å to about 90 Å. When the thickness of the electron injection layer is within the range described above, satisfactory electron injection characteristics may be obtained without a substantial increase in driving voltage.

The second electrode 190 may be arranged on the electron transport region 170. The second electrode 190 may be a cathode. A material for forming the second electrode 190 may be metal, an alloy, an electrically conductive compound, or any combination thereof, which has a relatively low work function. For example, lithium (Li), magnesium (Mg), aluminum (Al), silver (Ag), aluminum-lithium (Al-Li), calcium (Ca), magnesium-indium (Mg-In), magnesium-silver (Mg-Ag), or the like may be used as the material for forming the second electrode 190. In an embodiment, to manufacture a top-emission type light-emitting device, a transparent or semi-transparent electrode formed using ITO or IZO may be used as the second electrode 190, and various modifications may be made.

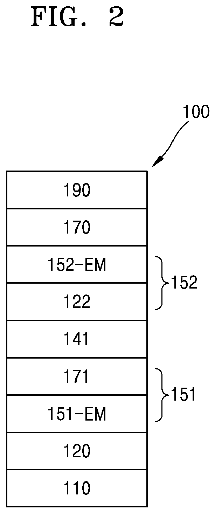

FIG. 2 is a schematic view of a light-emitting device 100 according to an embodiment.

The organic light-emitting device 100 of FIG. 2 may include a first electrode 110, a second electrode 190 facing the first electrode 110, and a first light-emitting unit 151 and a second light-emitting unit 152 which are stacked between the first electrode 110 and the second electrode 190. A charge generation layer 141 is arranged between the first light-emitting unit 151 and the second light-emitting unit 152. The charge generation layer 141 may include an n-type charge generation layer, a p-type charge generation layer, or a combination thereof. The charge generation layer 141 is a layer that generates charge and supplies the charge to neighboring light-emitting units, and any known material may be used therefor.

The first light-emitting unit 151 may include an emission layer 1 151-EM, and the second light-emitting unit 152 may include an emission layer 2 152-EM.

In an embodiment, the emission layer 1 151-EM may include the first emission layer and the second emission layer as described in the present specification.

In an embodiment, the emission layer 2 152-EM may include the first emission layer and the second emission layer as described in the present specification.

In an embodiment, the emission layer 1 151-EM may be the first emission layer as described in the present specification, and the emission layer 2 152-EM may be the second emission layer as described in the present specification.

In an embodiment, the emission layer 1 151-EM may be the second emission layer as described in the present specification, and the emission layer 2 152-EM may be the first emission layer as described in the present specification.

The first emission layer and the second emission layer may respectively be the same as those described in the present specification.

A hole transport region 120 is arranged between the first light-emitting unit 151 and the first electrode 110, and the second light-emitting unit 152 includes a second hole transport region 122 arranged on the side of the first electrode 110.

An electron transport region 170 may be arranged between the second light-emitting unit 152 and the second electrode 190, and the first light-emitting unit 151 may include a first electron transport region 171 arranged between the charge generation layer 141 and the emission layer 1 151-EM.

The first electrode 110 and the second electrode 190 illustrated in FIG. 2 may respectively be the same as the first electrode 110 and the second electrode 190 illustrated in FIG. 1, respectively.

The hole transport region 120 and the second hole transport region 122 illustrated in FIG. 2 may each be the same as described in connection with the hole transport region 120 illustrated in FIG. 1.

The electron transport region 170 and the first electron transport region 171 illustrated in FIG. 2 may each be the same as described in connection with the electron transport region 170 illustrated in FIG. 1.

Hereinbefore, an example of a tandem light-emitting device has been described with reference to FIG. 2. However, the tandem light-emitting device may include three or more light-emitting units. Various modifications may be made.

The term "C₁-C₆₀ alkyl group" as used herein refers to a linear or branched saturated aliphatic hydrocarbons monovalent group having 1 to 60 carbon atoms, and the term "C₁-C₆₀ alkylene group" as used here refers to a divalent group having the same structure as the C₁-C₆₀ alkyl group.

Examples of the C₁-C₆₀ alkyl group, the C₁-C₂₀ alkyl group, and/or the C₁-C₁₀ alkyl group may include a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, or a tert-decyl group, each unsubstituted or substituted with a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, or any combination thereof. For example, Formula 9-33 is a branched C₆ alkyl group, for example, a tert-butyl group that is substituted with two methyl groups.

The term "C₁-C₆₀ alkoxy group" used herein refers to a monovalent group represented by -OA₁₀₁ (wherein A₁₀₁ is the C₁-C₆₀ alkyl group), and examples thereof are a methoxy group, an ethoxy group, a propoxy group, a butoxy group, or a pentoxy group.

The term "C₁-C₆₀ alkylthio group" as used herein refers to a monovalent group represented by -SA₁₀₁ (wherein A₁₀₁ is the C₁-C₆₀ alkyl group).

The term "C₂-C₆₀ alkenyl group" as used herein has a structure including at least one carbon-carbon double bond in the middle or at the terminus of the C₂-C₆₀ alkyl group, and examples thereof include an ethenyl group, a propenyl group, and a butenyl group. The term "C₂-C₆₀ alkenylene group" as used herein refers to a divalent group having the same structure as the C₂-C₆₀ alkenyl group.

The term "C₂-C₆₀ alkynyl group" as used herein has a structure including at least one carbon-carbon triple bond in the middle or at the terminus of the C₂-C₆₀ alkyl group, and examples thereof include an ethynyl group and a propynyl group. The term "C₂-C₆₀ alkynylene group" as used herein refers to a divalent group having the same structure as the C₂-C₆₀ alkynyl group.

The term "C₃-C₁₀ cycloalkyl group" as used herein refers to a monovalent saturated hydrocarbon cyclic group having 3 to 10 carbon atoms, and the C₃-C₁₀ cycloalkylene group is a divalent group having the same structure as the C₃-C₁₀ cycloalkyl group.

Examples of the C₃-C₁₀ cycloalkyl group are a cyclopropyl group, a cyclobutyl group, a cyclopentyl group, a cyclohexyl group, a cycloheptyl group, a cyclooctyl group, an adamantanyl group, a norbornanyl group (or a bicyclo[2.2.1]heptyl group), a bicyclo[1.1.1]pentyl group, a bicyclo[2.1.1]hexyl group, and a bicyclo[2.2.2]octyl group.

The term "C₁-C₁₀ heterocycloalkyl group" as used herein refers to a monovalent saturated cyclic group that includes at least one hetero atom selected from N, O, P, Si, S, Se, Ge, and B as a ring-forming atom and 1 to 10 carbon atoms, and the term "C₁-C₁₀ heterocycloalkylene group" as used herein refers to a divalent group having the same structure as the C₁-C₁₀ heterocycloalkyl group.

Examples of the C₁-C₁₀ heterocycloalkyl group may include a silolanyl group, a silinanyl group, a tetrahydrofuranyl group, a tetrahydro-2H-pyranyl group, and a tetrahydrothiophenyl group.

The term "C₃-C₁₀ cycloalkenyl group" as used herein refers to a monovalent monocyclic group that has 3 to 10 carbon atoms, at least one carbon-carbon double bond in the ring thereof, and no aromaticity, and examples thereof include a cyclopentenyl group, a cyclohexenyl group, and a cycloheptenyl group. The term "C₃-C₁₀ cycloalkenylene group" as used herein refers to a divalent group having the same structure as the C₃-C₁₀ cycloalkenyl group.

The term "C₁-C₁₀ heterocycloalkenyl group" as used herein refers to a monovalent monocyclic group that has at least one hetero atom selected from N, O, P, Si, S, Se, Ge, and B as a ring-forming atom, 1 to 10 carbon atoms, and at least one double bond in its ring. Examples of the C₁-C₁₀ heterocycloalkenyl group include a 2,3-dihydrofuranyl group and a 2,3-dihydrothiophenyl group. The term "C₁-C₁₀ heterocycloalkenylene group" as used herein refers to a divalent group having the same structure as the C₁-C₁₀ heterocycloalkenyl group.

The term "C₆-C₆₀ aryl group" as used herein refers to a monovalent group having a carbocyclic aromatic system having 6 to 60 carbon atoms, and the term "C₆-C₆₀ arylene group" as used herein refers to a divalent group having a carbocyclic aromatic system having 6 to 60 carbon atoms. Examples of the C₆-C₆₀ aryl group include a phenyl group, a naphthyl group, an anthracenyl group, a phenanthrenyl group, a pyrenyl group, and a chrysenyl group. When the C₆-C₆₀ aryl group and the C₆-C₆₀ arylene group each include two or more rings, the two or more rings may be fused to each other.

The "C₇-C₆₀ alkylaryl group" as used herein refers to a C₆-C₆₀ aryl group that is substituted with at least one C₁-C₆₀ alkyl group.

The term "C₁-C₆₀ heteroaryl group" as used herein refers to a monovalent group having a cyclic aromatic system having at least one hetero atom selected from N, O, P, Si, S, Se, Ge, and B as a ring-forming atom and 1 to 60 carbon atoms, and the term "C₁-C₆₀ heteroarylene group" as used herein refers to a divalent group having a cyclic aromatic system having at least one hetero atom selected from N, O, P, Si, S, Se, Ge, and B as a ring-forming atom and 1 to 60 carbon atoms. Examples of the C₁-C₆₀ heteroaryl group include a pyridinyl group, a pyrimidinyl group, a pyrazinyl group, a pyridazinyl group, a triazinyl group, a quinolinyl group, and an isoquinolinyl group. When the C₁-C₆₀ heteroaryl group and the C₁-C₆₀ heteroarylene group each include two or more rings, the two or more rings may be fused to each other.

The "C₂-C₆₀ alkylheteroaryl group" as used herein refers to a C₁-C₆₀ heteroaryl group that is substituted with at least one C₁-C₆₀ alkyl group.

The term "C₆-C₆₀ aryloxy group" as used herein indicates -OA₁₀₂ (wherein A₁₀₂ indicates the C₆-C₆₀ aryl group), the C₆-C₆₀ arylthio group indicates -SA₁₀₃ (wherein A₁₀₃ indicates the C₆-C₆₀ aryl group), and the C₁-C₆₀ alkylthio group indicates -SA₁₀₄ (wherein A₁₀₄ indicates the C₁-C₆₀ alkyl group).

The term "monovalent non-aromatic condensed polycyclic group" as used herein refers to a monovalent group (for example, having 8 to 60 carbon atoms) having two or more rings condensed to each other, only carbon atoms as ring-forming atoms, and no aromaticity in its molecular structure when considered as a whole. Examples of the monovalent non-aromatic condensed polycyclic group include a fluorenyl group. The term "divalent non-aromatic condensed polycyclic group" as used herein refers to a divalent group having the same structure as a monovalent non-aromatic condensed polycyclic group.

The term "monovalent non-aromatic condensed heteropolycyclic group" as used herein refers to a monovalent group having two or more rings condensed to each other, at least one hetero atom selected from N, O, P, Si, S, Se, Ge, and B, other than carbon atoms (for example, having 1 to 60 carbon atoms), as a ring-forming atom, and no aromaticity in its molecular structure when considered as a whole. The monovalent non-aromatic condensed heteropolycyclic group includes a carbazolyl group. The term "divalent non-aromatic condensed heteropolycyclic group" as used herein refers to a divalent group having the same structure as a monovalent non-aromatic condensed heteropolycyclic group.

The term "C₅-C₃₀ carbocyclic group" as used herein refers to a saturated or unsaturated cyclic group having, as a ring-forming atom, 5 to 30 carbon atoms only. The C₅-C₃₀ carbocyclic group may be a monocyclic group or a polycyclic group. Examples of the "C₅-C₃₀ carbocyclic group (that is unsubstituted or substituted with at least one R₁₀ₐ)" used herein are an adamantane group, a norbornene group, a bicyclo[1.1.1]pentane group, a bicyclo[2.1.1]hexane group, a bicyclo[2.2.1]heptane group (norbornane group), a bicyclo[2.2.2]octane group, a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, and a fluorene group, (each unsubstituted or substituted with at least one R₁₀ₐ).

The term "C₁-C₃₀ heterocyclic group" as used herein refers to a saturated or unsaturated cyclic group having, as a ring-forming atom, at least one heteroatom selected from N, O, P, Si, S, Se, Ge, and B other than 1 to 30 carbon atoms. The C₁-C₃₀ heterocyclic group may be a monocyclic group or a polycyclic group. The "C₁-C₃₀ heterocyclic group (unsubstituted or substituted with at least one R₁₀ₐ)" may be, for example, a thiophene group, a furan group, a pyrrole group, a silole group, borole group, a phosphole group, a selenophene group, a germole group, a benzothiophene group, a benzofuran group, an indole group, a benzosilole group, a benzoborole group, a benzophosphole group, a benzoselenophene group, a benzogermole group, a dibenzothiophene group, a dibenzofuran group, a carbazole group, a dibenzosilole group, a dibenzoborole group, a dibenzophosphole group, a dibenzoselenophene group, a dibenzogermole group, a dibenzothiophene 5-oxide group, a 9H-fluoren-9-one group, a dibenzothiophene 5,5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group (each unsubstituted or substituted with at least one R₁₀ₐ).

Examples of the "C₅-C₃₀ carbocyclic group" and "C₁-C₃₀ heterocyclic group" as used herein are i) a first ring, ii) a second ring, iii) a condensed ring in which two or more first rings are condensed with each other, iv) a condensed ring in which two or more second rings are condensed with each other, or v) a condensed ring in which at least one first ring is condensed with at least one second ring,
wherein the first ring may be a cyclopentane group, a cyclopentene group, a furan group, a thiophene group, a pyrrole group, a silole group, a borole group, a phosphole group, a germole group, a selenophene group, an oxazole group, an oxadiazole group, an oxatriazole group, a thiazole group, a thiadiazole group, a thiatriazole group, a pyrazole group, an imidazole group, a triazole group, a tetrazole group, or an azasilole group, and
the second ring may be an adamantane group, a norbornane group, a norbornene group, a cyclohexane group, a cyclohexene group, a benzene group, a pyridine group, a pyrimidine group, a pyrazine group, a pyridazine group, or a triazine group.

The terms "fluorinated C₁-C₆₀ alkyl group (or a fluorinated C₁-C₂₀ alkyl group or the like)", "fluorinated C₃-C₁₀ cycloalkyl group", "fluorinated C₁-C₁₀ heterocycloalkyl group", and "fluorinated phenyl group" respectively indicate a C₁-C₆₀ alkyl group (or a C₁-C₂₀ alkyl group or the like), a C₃-C₁₀ cycloalkyl group, a C₁-C₁₀ heterocycloalkyl group, and a phenyl group, each substituted with at least one fluoro group (-F). For example, the term "fluorinated C₁ alkyl group (that is, a fluorinated methyl group)" includes -CF₃, -CF₂H, and -CFH₂. The "fluorinated C₁-C₆₀ alkyl group (or, a fluorinated C₁-C₂₀ alkyl group, or the like)", "fluorinated C₃-C₁₀ cycloalkyl group", "fluorinated C₁-C₁₀ heterocycloalkyl group", or "fluorinated phenyl group" may be i) a fully fluorinated C₁-C₆₀ alkyl group (or, a fully fluorinated C₁-C₂₀ alkyl group, or the like), a fully fluorinated C₃-C₁₀ cycloalkyl group, a fully fluorinated C₁-C₁₀ heterocycloalkyl group, or a fully fluorinated phenyl group, wherein, in each group, all hydrogen included therein is substituted with a fluoro group, or ii) a partially fluorinated C₁-C₆₀ alkyl group (or, a partially fluorinated C₁-C₂₀ alkyl group, or the like), a partially fluorinated C₃-C₁₀ cycloalkyl group, a partially fluorinated C₁-C₁₀ heterocycloalkyl group, or partially fluorinated phenyl group, wherein, in each group, all hydrogen included therein is not substituted with a fluoro group.

The terms "deuterated C₁-C₆₀ alkyl group (or a deuterated C₁-C₂₀ alkyl group or the like)", "deuterated C₃-C₁₀ cycloalkyl group", "deuterated C₁-C₁₀ heterocycloalkyl group", and "deuterated phenyl group" respectively indicate a C₁-C₆₀ alkyl group (or a C₁-C₂₀ alkyl group or the like), a C₃-C₁₀ cycloalkyl group, a C₁-C₁₀ heterocycloalkyl group, and a phenyl group, each substituted with at least one deuterium. For example, the "deuterated C₁ alkyl group (that is, the deuterated methyl group)" may include -CD₃, -CD₂H, and -CDH₂, and examples of the "deuterated C₃-C₁₀ cycloalkyl group" are, for example, Formula 10-501 and the like. The "deuterated C₁-C₆₀ alkyl group (or, the deuterated C₁-C₂₀ alkyl group or the like)", "deuterated C₃-C₁₀ cycloalkyl group", "deuterated C₁-C₁₀ heterocycloalkyl group", or "deuterated phenyl group" may be i) a fully deuterated C₁-C₆₀ alkyl group (or, a fully deuterated C₁-C₂₀ alkyl group or the like), a fully deuterated C₃-C₁₀ cycloalkyl group, a fully deuterated C₁-C₁₀ heterocycloalkyl group, or a fully deuterated phenyl group, in which, in each group, all hydrogen included therein is substituted with deuterium, or ii) a partially deuterated C₁-C₆₀ alkyl group (or, a partially deuterated C₁-C₂₀ alkyl group or the like), a partially deuterated C₃-C₁₀ cycloalkyl group, a partially deuterated C₁-C₁₀ heterocycloalkyl group, or a partially deuterated phenyl group, in which, in each group, all hydrogen included therein is not substituted with deuterium.

The term "(C₁-C₂₀ alkyl) 'X' group" as used herein refers to an 'X' group that is substituted with at least one C₁-C₂₀ alkyl group. For example, the term "(C₁-C₂₀ alkyl)C₃-C₁₀ cycloalkyl group" as used herein refers to a C₃-C₁₀ cycloalkyl group that is substituted with at least one C₁-C₂₀ alkyl group, and the term "(C₁-C₂₀ alkyl)phenyl group" as used herein refers to a phenyl group that is substituted with at least one C₁-C₂₀ alkyl group. Examples of a (C₁ alkyl)phenyl group include a toluyl group.

The terms "an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, and an azadibenzothiophene 5,5-dioxide group" respectively refer to heterocyclic groups having the same backbones as "an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluoren-9-one group, and a dibenzothiophene 5,5-dioxide group," in which, in each group, at least one carbon atom selected from ring-forming carbon atoms is substituted with nitrogen.

At least one substituent of the substituted C₅-C₃₀ carbocyclic group, the substituted C₁-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkylaryl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted monovalent non-aromatic condensed polycyclic group, and the substituted monovalent non-aromatic condensed heteropolycyclic group may be:
deuterium, -F, -Cl, -Br, -I, -CD₃, -CD₂H, -CDH₂, -CF₃, -CF₂H, -CFH₂, a hydroxyl group, a cyano group, a nitro group, a C₁-C₆₀ alkyl group, a C₂-C₆₀ alkenyl group, a C₂-C₆₀ alkynyl group, or a C₁-C₆₀ alkoxy group;
a C₁-C₆₀ alkyl group, a C₂-C₆₀ alkenyl group, a C₂-C₆₀ alkynyl group, or a C₁-C₆₀ alkoxy group, each substituted with deuterium, -F, -Cl, -Br, -I, -CD₃, -CD₂H, -CDH₂, -CF₃, -CF₂H, -CFH₂, a hydroxyl group, a cyano group, a nitro group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, - N(Q₁₁)(Q₁₂), -Si(Q₁₃)(Q₁₄)(Q₁₅), -Ge(Q₁₃)(Q₁₄)(Q₁₅), -B(Q₁₆)(Q₁₇), -P(=O)(Q₁₈)(Q₁₉), - P(Q₁₈)(Q₁₉), or any combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, or a monovalent non-aromatic condensed heteropolycyclic group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅), -Ge(Q₂₃)(Q₂₄)(Q₂₅), - B(Q₂₆)(Q₂₇), -P(=O)(Q₂₈)(Q₂₉), -P(Q₂₈)(Q₂₉), or any combination thereof;
-N(Q₃₁)(Q₃₂), -Si(Q₃₃)(Q₃₄)(Q₃₅), -Ge(Q₃₃)(Q₃₄)(Q₃₅), -B(Q₃₆)(Q₃₇), - P(=O)(Q₃₈)(Q₃₉), or -P(Q₃₈)(Q₃₉); or any combination thereof.
Q₁ to Q₉, Q₁₁ to Q₁₉, Q₂₁ to Q₂₉, and Q₃₁ to Q₃₉ may each independently be: hydrogen; deuterium; -F; -Cl; -Br; -I; a hydroxyl group; a cyano group; a nitro group; or a C₁-C₆₀ alkyl group, a C₂-C₆₀ alkenyl group, a C₂-C₆₀ alkynyl group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₁-C₆₀ heteroaryl group, a monovalent non-aromatic condensed polycyclic group, or a monovalent non-aromatic condensed heteropolycyclic group, each unsubstituted or substituted with deuterium, a C₁-C₆₀ alkyl group, a C₆-C₆₀ aryl group, or any combination thereof.

For example, Q₁ to Q₉, Q₁₁ to Q₁₉, Q₂₁ to Q₂₉, and Q₃₁ to Q₃₉ described herein may each independently be:
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, or -CD₂CDH₂; or
an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with deuterium, a C₁-C₁₀ alkyl group, a phenyl group, or any combination thereof.

Hereinafter, a light-emitting device according to an embodiment is described in detail with reference to Examples. However, the disclosure is not limited to the following Examples.

### Evaluation Example 1

DFT calculation using a Gaussian 16 program was performed by optimizing a molecular structure of each of Compounds Ir-1-(H) and Pt-1-(L) by using B3LYP/LanL2DZ function with respect to a metal included in each of Compounds Ir-1-(H) and Pt-1-(L) and using B3LYP/6-31G(D,P) function with respect to an organic ligand included in each of Compounds Ir-1-(H) and Pt-1-(L), to calculate a permanent dipole moment, singlet energy, and triplet energy of each of Compounds Ir-1-(H) and Pt-1-(L), and calculate Dₛₜ of each of Compounds Ir-1-(H) and Pt-1-(L) therefrom. Results thereof are shown in Table 1. Next, DFT calculation using a Gaussian 16 program was performed by optimizing a molecular structure of each of Compounds HT-(H), ET-(H), HT-(L), and ET-(L) by using B3LYP/6-31G(D,P) function, to calculate each of a permanent dipole moment, singlet energy, and triplet energy of each of Compounds HT-(H), ET-(H), HT-(L), and ET-(L), and calculate Dₛₜ of each of Compounds HT-(H), ET-(H), HT-(L), and ET-(L). Results thereof are shown in Table 1 along with the permanent dipole moment.

**Table 1**

| Compound | Permanent dipole moment (debye) | Dₛₜ (eV) |
|---|---|---|
| Ir-1-(H) (Compound 99 of Group 2-4) | 5.8425 | 0.383 |
| Pt-1-(L) (Compound 24 of Group 1-2) | 1.76 | 0.132 |
| HT-(H) (Compound H-HT1) | 0.8147 | 0.539 |
| ET-(H) (Compound H-ET1) | 2.2049 | 0.0607 |
| HT-(L) (Compound H-HT5) | 2.523 | 0.42 |
| ET-(L) (Compound H-ET6) | 0.251 | 0.781 |

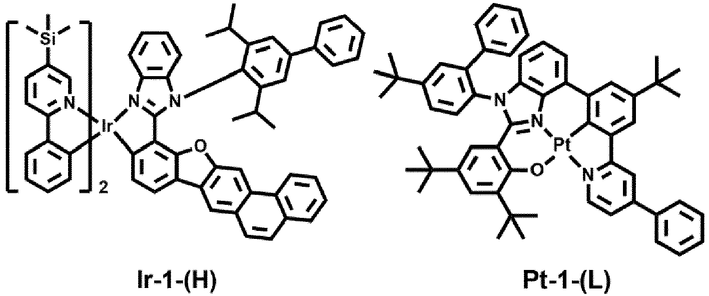

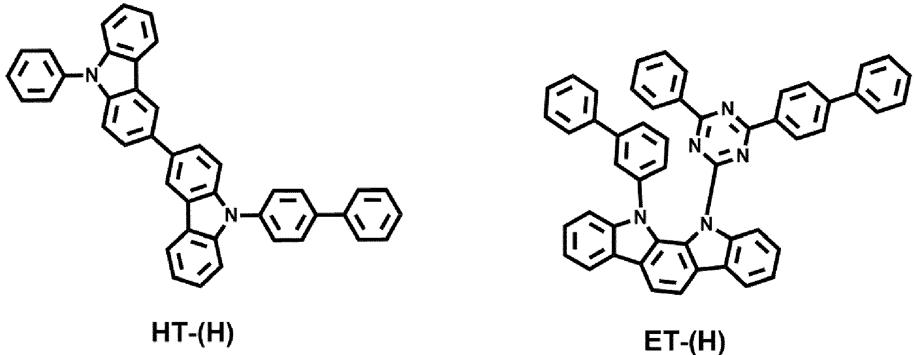

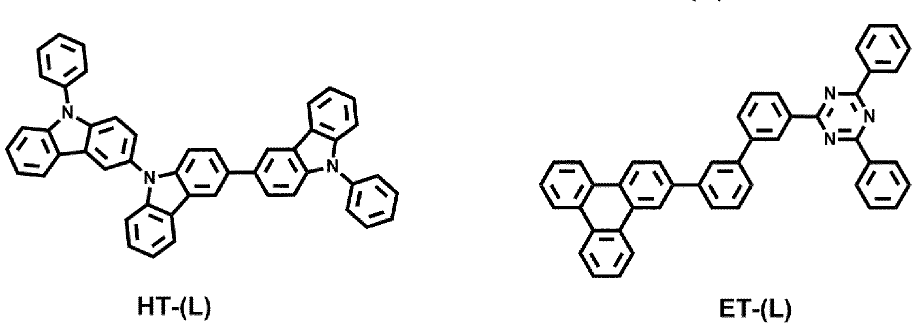

### Evaluation Example 2

Compounds shown in Table 2 were vacuum-codeposited on a quartz substrate at a vacuum degree of 10⁻⁷ torr in a weight ratio shown in Table 2 to prepare Films Ir-1-(H) and Pt-1-(L), each having a thickness of 40 nm.

Next, a photoluminescence spectrum of each of Films Ir-1-(H) and Pt-1-(L) was measured by using a Quantaurus-QY Absolute PL quantum yield spectrometer of Hamamatsu Inc. (equipped with a xenon light source, a monochromator, a photonic multichannel analyzer, and an integrating sphere, and using PLQY measurement software (Hamamatsu Photonics, Ltd., Shizuoka, Japan)). During the measurement, an excitation wavelength was scanned from 320 nm to 380 nm at 10 nm intervals, and a spectrum measured at the excitation wavelength of 320 nm was taken. From the photoluminescence spectrum of each of Films Ir-1-(H) and Pt-1-(L) evaluated therefrom, a full width at half maximum and maximum emission peak wavelength of each of Compounds Ir-1-(H) and Pt-1-(L) were evaluated and results thereof are shown in Table 2.

**Table 2**

| Film No. | Film composition (weight ratio) | FWHM (nm) | Maximum emission peak wavelength (nm) |
|---|---|---|---|
| Ir-1-(H) | HT-(L) : ET-(L) : Ir-1-(H) (47.5 : 47.5 : 5) | 29 | 529 |
| Pt-1-(L) | HT-(H) : ET-(H) : Pt-1-(L) (45 : 45 : 10) | 64 | 527 |

### Manufacture of OLED 1

As an anode, a glass substrate with ITO/Ag/ITO deposited thereon to a thickness of 70/1,000/70 Å was cut to a size of 50 mm x 50 mm x 0.5 mm, sonicated with isopropyl alcohol and pure water each for 5 minutes, and then cleaned by irradiation of ultraviolet rays and exposure of ozone thereto for 30 minutes. Then, the resultant glass substrate was loaded onto a vacuum deposition apparatus.

HT3 and F6-TCNNQ were co-deposited on the anode in a weight ratio of 98:2 to form a hole injection layer (HIL) having a thickness of 10 nm, HT3 was deposited on the hole injection layer to form a hole transport layer (HTL) having a thickness of 140 nm, and HT(1) was vacuum-deposited on the hole transport layer to form an electron blocking layer (EBL) having a thickness of 30 nm.

Next, dopant (Ir-1-(H)) and hosts (HT-(L) and ET-(L)) were co-deposited on the electron blocking layer to form an emission layer-A (EML-A) having a thickness of 11 nm. A weight of the dopant in EML-A was 7 wt% based on 100 wt% of EML-A, and a weight ratio of HT-(L) and ET-(L) in EML-A was 5 : 5. PDM(Host(L)) in Tables 3 and 4 was calculated as "PDM(Host(L)) = (2.523 debye x 0.5) + (0.251 debye x 0.5) = 1.387 debye".

Next, dopant (Pt-1-(L)) and hosts (HT-(H) and ET-(H)) were co-deposited on the EML-A to form an emission layer-B (EML-B) having a thickness of 27 nm. A weight of the dopant in EML-B was 15 wt% based on 100 wt% of EML-B, and a weight ratio of HT-(H) and ET-(H) in EML-2 was 5 : 5. PDM(Host(H)) in Tables 3 and 4 was calculated as "PDM(Host(H)) = (0.8147 debye x 0.5) + (2.2049 debye x 0.5) = 1.5098 debye".

Next, ET3 was vacuum-deposited on EML-B to form a hole blocking layer (HBL) having a thickness of 5 nm, ET3 and ET-D1 were co-deposited on the hole blocking layer in a volume ratio of 50:50 to form an electron transport layer (ETL) having a thickness of 31 nm, Mg and Ag were co-deposited on the electron transport layer in a weight ratio of 10:90 to form a cathode having a thickness of 12 nm, and HT3 was deposited thereon to form a capping layer (CPL) having a thickness of 83 nm, thereby completing the manufacture of a top-emission type light-emitting device.

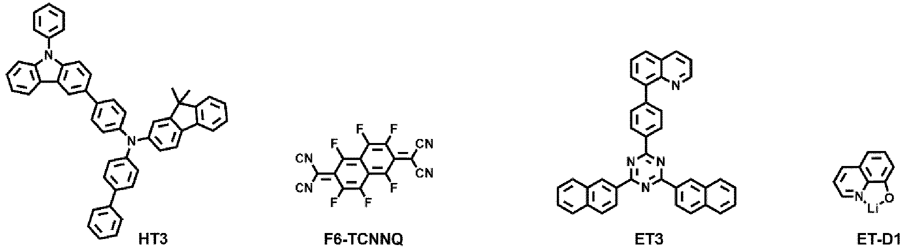

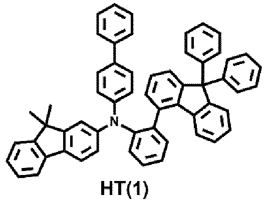

### Manufacture of OLED 2

OLED 2 was manufactured in the same manner as used to manufacture OLED 1, except that i) when EML-A was formed, Pt-1-(L) was used instead of Ir-1-(H) as a dopant, and an amount of the dopant in EML-A was changed to 15 wt% based on 100 wt% of EML-A, and ii) when EML-B was formed, Ir-1-(H) was used instead of Pt-1-(L) as a dopant, and an amount of the dopant in EML-B was changed to 7 wt% based on 100 wt% of EML-B.

### Manufacture of OLED 3

OLED 3 was manufactured in the same manner as used to manufacture OLED 1, except that i) when EML-A was formed, HT-(H) and ET-(H) (in a weight ratio of 5:5) were used instead of HT-(L) and ET-(L) as hosts, and ii) when EML-B was formed, HT-(L) and ET-(L) (in a weight ratio of 5:5) were used instead of HT-(H) and ET-(H) as hosts.

### Manufacture of OLED 4

OLED 4 was manufactured in the same manner as used to manufacture OLED 3, except that i) when EML-A was formed, Pt-1-(L) was used instead of Ir-1-(H) as a dopant, and an amount of the dopant in EML-A was changed to 15 wt% based on 100 wt% of EML-A, and ii) when EML-B was formed, Ir-1-(H) was used instead of Pt-1-(L) as a dopant, and an amount of the dopant in EML-B was changed to 7 wt% based on 100 wt% of EML-B.

Compositions of layers of each of OLEDs 1 to 4 are as the same as described in Tables 3 and 4.

**Table 3**

| | | OLED 1 (Example) | OLED 2 (Comparative Example) |
|---|---|---|---|
| CPL (83 nm) | | HT3 | HT3 |
| Cathode (12 nm) | | Mg: Ag | Mg : Ag |
| ETL (31 nm) | | ET3 : ET-D1 | ET3 : ET-D1 |
| HBL (5 nm) | | ET3 | ET3 |
| EML-B (27 nm) | Dopant | Pt-1-(L) (15 wt%) | Ir-1-(H) (7 wt%) |
| | | PDM(Pt-1-(L)) = 1.76 debye | PDM(Ir-1-(H)) = 5.8425 debye |
| | Host | HT-(H) : ET-(H) | HT-(H) : ET-(H) |
| | | PDM(Host(H)) = 1.5098 debye | PDM(Host(H)) = 1.5098 debye |
| EML-A (11 nm) | Dopant | Ir-1-(H) (7 wt%) | Pt-1-(L) (15 wt%) |
| | | PDM(Ir-1-(H)) = 5.8425 debye | PDM(Pt-1-(L)) = 1.76 debye |
| | Host | HT-(L) : ET-(L) | HT-(L) : ET-(L) |
| | | PDM(Host(L)) = 1.38735 debye | PDM(Host(L)) = 1.387 debye |
| EBL (30 nm) | | HT(1) | HT(1) |
| HTL (140 nm) | | HT3 | HT3 |
| HIL (10 nm) | | HT3 : F6-TCNNQ | HT3 : F6-TCNNQ |
| Anode | | ITO/Ag/ITO | ITO/Ag/ITO |

**Table 4**

| | | OLED 3 (Comparative Example) | OLED 4 (Example) |
|---|---|---|---|
| CPL (83 nm) | | HT3 | HT3 |
| Cathode (12 nm) | | Mg: Ag | Mg : Ag |
| ETL (31 nm) | | ET3 : ET-D1 | ET3 : ET-D1 |
| HBL (5 nm) | | ET3 | ET3 |
| EML-B (27 nm) | Dopant | Pt-1-(L) (15 wt%) | Ir-1-(H) (7 wt%) |
| | | PDM(Pt-1-(L)) = 1.76 debye | PDM(Ir-1-(H)) = 5.8425 debye |
| | Host | HT-(L) : ET-(L) | HT-(L) : ET-(L) |
| | | PDM(Host(L)) = 1.387 debye | PDM(Host(L)) = 1.387 debye |
| EML-A (11 nm) | Dopant | Ir-1-(H) (7 wt%) | Pt-1-(L) (15 wt%) |
| | | PDM(Ir-1-(H)) = 5.8425 debye | PDM(Pt-1-(L)) = 1.76 debye |
| | Host | HT-(H) : ET-(H) | HT-(H) : ET-(H) |
| | | PDM(Host(H)) = 1.5098 debye | PDM(Host(H)) = 1.5098 debye |
| EBL (30 nm) | | HT(1) | HT(1) |
| HTL (140 nm) | | HT3 | HT3 |
| HIL (10 nm) | | HT3 : F6-TCNNQ | HT3 : F6-TCNNQ |
| Anode | | ITO/Ag/ITO | ITO/Ag/ITO |

### Evaluation Example 3

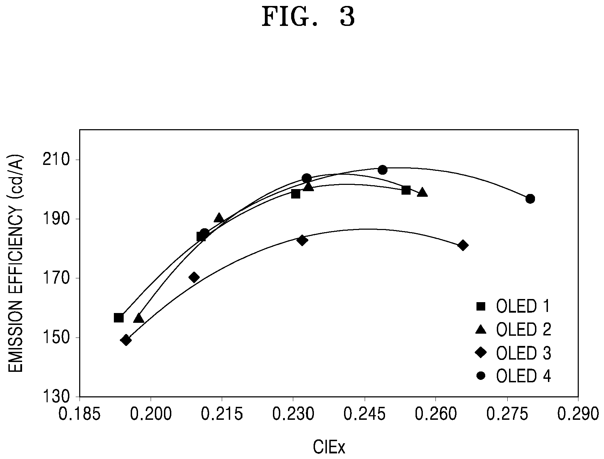

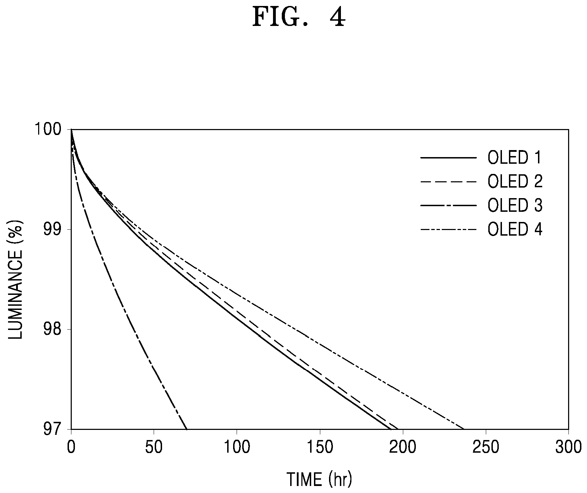

Driving voltage(V), luminescence efficiency (at CIEx = 0.245) (cd/A,), power efficiency (at CIEx = 0.245)(lm/W), lifespan (T₉₇ at 15,000 nit) (hr), roll-off ratio (%), turn-on time (*µ*s), turn-off time (*µ*s), and lateral luminance ratio (%) of each of OLED 1 (Example), OLED 2 (Comparative Example), OLED 3 (Comparative Example), and OLED 4 (Example) were evaluated, and results thereof are shown in Table 5. Numbers in parentheses in Table 5 represent relative values. The x color coordinate-luminescence efficiency graph and the time-luminance graph of each of OLEDs 1 to 4 are shown in FIGS. 3 and 4, respectively. A current voltmeter (Keithley 2400) and a luminance meter (Tocon SR3) were used as evaluation devices.

The lifespan (T₉₇) (at 15,000 nit) was obtained by evaluating the time taken for the luminance to reach 97 % relative to the initial luminance of 100 %.

The roll-off ratio was calculated by the following Equation 20: 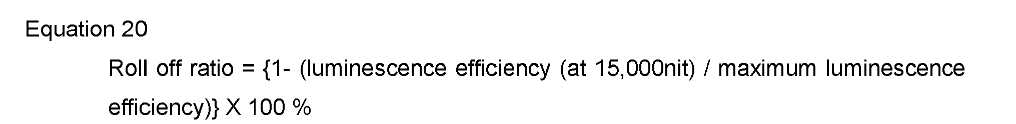 Roll off ratio = {1- (luminescence efficiency (at 15,000nit) / maximum luminescence efficiency)} X 100 % Equation 20

The turn-on time was obtained by evaluating the time taken for the luminance to reach 90 % of the maximum luminance after the application of a current pulse of 50 Hz frequency at 1 mA/cm², and the turn-off time was obtained by evaluating the time taken for the luminance to reach 10 % of the maximum luminance after the current pulse was blocked.

The lateral luminance ratio (at CIEx = 0.25) was obtained by evaluating a ratio of the front luminance value to the 45° lateral luminance value.

**Table 5**

| | Driving voltage (V) | Luminescence efficiency (cd/A) | Power efficiency (lm/W) | Lifespan (T₉₇) (hr) | Roll-off ratio (%) | Turn-on time (*µ*s) | Turn-off time (*µ*s) | Lateral luminance ratio (%) |
|---|---|---|---|---|---|---|---|---|
| OLED 1 (Example) | 3.58 | 201.5 (100 %) | 56.3 (100 %) | 192 (100 %) | 9 | 244 | 108 | 42 |
| OLED 2 (Comparative Example) | 3.47 | 204.3 (101 %) | 58.8 (104 %) | 197 (103 %) | 6 | 288 | 108 | 40 |
| OLED 3 (Comparative Example) | 3.62 | 186.5 (93 %) | 51.4 (91 %) | 69 (36 %) | 14 | 248 | 124 | 42 |
| OLED 4 (Example) | 3.38 | 206.6 (103 %) | 61.2 (109 %) | 237 (123 %) | 5 | 248 | 96 | 42 |

Referring to Table 5,
1) OLED 1 (Example) had i) the same level of the luminescence efficiency, power efficiency, lifespan, and turn-off time characteristics as those of OLED 2 (Comparative Example), but had better turn-on time and lateral luminance ratio characteristics than those of OLED 2 (Comparative Example), and ii) had the same level of the turn-on time and lateral luminance ratio characteristics as those of OLED 3 (Comparative Example), but had better luminescence efficiency, power efficiency, lifespan, roll-off ratio, and turn-off time characteristics than those of OLED 3 (Comparative Example),
2) OLED 4 (Example) had i) the better driving voltage, luminescence efficiency, power efficiency, lifespan, roll-off ratio, turn-on time, turn-off time, and lateral luminance ratio characteristics than those of OLED 2 (Comparative Example) and ii) had the same level of the turn-on time and lateral luminance ratio characteristics as those of OLED 3 (Comparative Example), but had better driving voltage, luminescence efficiency, power efficiency, lifespan, roll-off ratio, and turn-off time characteristics than those of OLED 3 (Comparative Example).

Therefore, it could be confirmed that both OLED 1 (Example) and OLED 4 (Example) were high-quality light-emitting devices having overall improved characteristics in terms of the driving voltage, luminescence efficiency, power efficiency, lifespan, roll-off ratio, turn-on time, turn-off time, and lateral luminance ratio.

The light-emitting device have excellent characteristics in terms of luminescence efficiency, power efficiency, lifespan, roll-off ratio, and/or lateral luminance ratio and have excellent low-gradation emission characteristics at the same time, and thus, a high-quality electronic apparatus may be manufactured by using the light-emitting device.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A light-emitting device (100, 101) comprising:
a first electrode (110);
a second electrode (190) facing the first electrode (110); and
an interlayer (150) arranged between the first electrode (110) and the second electrode (190),
wherein the interlayer (150) comprises a first emission layer (151-EM) and a second emission layer (152-EM),
the first emission layer (151-EM) comprises a first host and a first dopant capable of emitting a first light having a first photoluminescence spectrum,
the first host comprises m1 hosts, where m1 is an integer of 1 or more, and when m1 is 2 or more, the two or more hosts present in the first emission layer (151-EM) are each different from the other,
the second emission layer (152-EM) comprises a second host and a second dopant capable of emitting a second light having a second photoluminescence spectrum,
the second host comprises m2 hosts, where m2 is an integer of 1 or more, and when m2 is 2 or more, the two or more hosts present in the second emission layer (152-EM) are each different from the other,
the first dopant comprises a first transition metal, and the second dopant comprises a second transition metal,
wherein the first dopant and the second dopant are different from each other, and
**characterized in that**
Expression 1 and Expression 2 are satisfied: $PDM \left(D1\right) < PDM \left(D2\right)$ Expression 1 $PDM \left(H1\right) > PDM \left(H2\right)$ Expression 2
wherein, in Expressions 1 and 2,
PDM(D1) is a permanent dipole moment of the first dopant and has a unit of debye,
PDM(D2) is a permanent dipole moment of the second dopant and has a unit of debye,
PDM(H1) is ${\sum }_{x = 1}^{m 1} PDM \left(Hx\right) ⋅ W \left(Hx\right)$ which is a permanent dipole moment average value of the m1 hosts present in the first host, and has a unit of debye, wherein i) x is a variable of 1 to m1, ii) PDM(Hx) is a permanent dipole moment of an x^{th} host in the first emission layer and has a unit of debye, and iii) W(Hx) is a weight fraction of the x^{th} host relative to a total weight of the first host, and is calculated as (a weight of the x^{th} host in the first emission layer / a total weight of the first host),
PDM(H2) is ${\sum }_{y = 1}^{m 2} PDM \left(Hy\right) ⋅ W \left(Hy\right)$ which is a permanent dipole moment average value of the m2 hosts present in the second host, and has a unit of debye, wherein i) y is a variable of 1 to m2, ii) PDM(Hy) is a permanent dipole moment of an y^{th} host in the second emission layer and has a unit of debye, and iii) W(Hy) is a weight fraction of the y^{th} host relative to a total weight of the second host, and is calculated as (a weight of the y^{th} host in the second emission layer / a total weight of the second host), and
each of PDM(D1), PDM(D2), PDM(Hx), and PDM(Hy) is calculated based on density functional theory (DFT).

2. The light-emitting device of claim 1, wherein |PDM(D1) - PDM(D2)| is 1.0 debye to 9.0 debye; and/or
wherein |PDM(H1) - PDM(H2)| is 0.01 debye to 3.99 debye.

3. The light-emitting device of claims 1 or 2, wherein Expression 3 is further satisfied: $FWHM \left(D1\right) > FWHM \left(D2\right)$ Expression 3 wherein, in Expression 3,
FWHM(D1) is a full width at half maximum at the maximum emission peak wavelength of the first photoluminescence spectrum of the first dopant and has a unit of nanometers,
FWHM(D2) is a full width at half maximum at the maximum emission peak wavelength of the second photoluminescence spectrum of the second dopant and has a unit of nanometers,
the first photoluminescence spectrum is evaluated relative to a first film including the first dopant, and
the second photoluminescence spectrum is evaluated relative to a second film including the second dopant.

4. The light-emitting device of any of claims 1-3, wherein Expression 4 is further satisfied: ${D}_{st} \left(D1\right) < {D}_{st} \left(D2\right)$ Expression 4 wherein, in Expression 4,
Dₛₜ(D1) is |S₁(D1) - T₁(D1)|,
Dₛₜ(D2) is |S₁(D2) - T₁(D2)|,
S₁(D1) is singlet energy of the first dopant and has a unit of eV,
T₁(D1) is triplet energy of the first dopant and has a unit of eV,
S₁(D2) is singlet energy of the second dopant and has a unit of eV,
T₁(D2) is triplet energy of the second dopant and has a unit of eV, and
each of S₁(D1), T₁(D1), S₁(D2), and T₁(D2) is calculated based on DFT.

5. The light-emitting device of any of claims 1-4, wherein |λmax(1) - λmax(2)| is 0 nm to 30 nm,
Amax(1) is a maximum emission peak wavelength of the first photoluminescence spectrum and has a unit of nanometers, and
Amax(2) is a maximum emission peak wavelength of the second photoluminescence spectrum and has a unit of nanometers.

6. The light-emitting device of any of claims 1-5, wherein
i) each of Amax(1) and Amax(2) is 510 nm to 540 nm; or
ii) each of Amax(1) and Amax(2) is 540 nm to 570 nm,
Amax(1) is a maximum emission peak wavelength of the first photoluminescence spectrum and has a unit of nm, and
Amax(2) is a maximum emission peak wavelength of the second photoluminescence spectrum and has a unit of nm.

7. The light-emitting device of any of claims 1-6, wherein
i) Amax(1) is 510 nm to 540 nm, and Amax(2) is 540 nm to 570 nm; or
ii) Amax(1) is 540 nm to 570 nm, and Amax(2) is 510 nm to 540 nm,
Amax(1) is a maximum emission peak wavelength of the first photoluminescence spectrum and has a unit of nm, and
Amax(2) is a maximum emission peak wavelength of the second photoluminescence spectrum and has a unit of nm.

8. The light-emitting device of any of claims 1-7, wherein the first light and the second light is green light; and/or
wherein the first emission layer and the second emission layer emit green light; and/or
wherein a surface of the first emission layer and a surface of the second emission layer are in direct contact.

9. The light-emitting device of any of claims 1-8, wherein the first emission layer (151-EM) is arranged between the second emission layer (152-EM) and the second electrode (190), or
wherein the second emission layer (152-EM) is arranged between the first emission layer (151-EM) and the second electrode (190).

10. The light-emitting device of any of claims 1-9, wherein the first transition metal is platinum, and the second transition metal is iridium.

11. The light-emitting device of any of claims 1-10, wherein the interlayer comprises:
m light-emitting units, each comprising at least one emission layer; and
m-1 charge generation layers arranged between two adjacent light-emitting units among the m light-emitting units,
m is an integer of 2 or more,
i) a first light-emitting unit among the m light-emitting units comprises the first emission layer (151-EM), and a second light-emitting unit among the m light-emitting units comprises the second emission layer (152-EM), or
ii) one light-emitting unit among the m light-emitting units comprises both the first emission layer (151-EM) and the second emission layer (152-EM).

12. The light-emitting device of claim 11, wherein one light-emitting unit among the m light-emitting units comprises both the first emission layer (151-EM) and the second emission layer (152-EM), and
the one light-emitting unit comprising both the first emission layer (151-EM) and the second emission layer (152-EM) emits green light.

13. The light-emitting device of claim 12, wherein the first emission layer (151-EM) is arranged between the second emission layer (152-EM) and the second electrode (190); or
wherein the second emission layer (152-EM) is arranged between the first emission layer (151-EM) and the second electrode (190).

14. The light-emitting device of any of claims 11-13, wherein at least one light-emitting unit among the m light-emitting units emits blue light.

15. An electronic apparatus comprising the light-emitting device of any of claims 1-14.

## Patentansprüche

1. Lichtemittierende Vorrichtung (100, 101), umfassend:
eine erste Elektrode (110);
eine zweite Elektrode (190), die der ersten Elektrode (110) zugewandt ist; und
eine Zwischenschicht (150), die zwischen der ersten Elektrode (110) und der zweiten Elektrode (190) angeordnet ist,
wobei die Zwischenschicht (150) eine erste Emissionsschicht (151-EM) und eine zweite Emissionsschicht (152-EM) umfasst,
die erste Emissionsschicht (151-EM) einen ersten Wirt und einen ersten Dotierstoff umfasst, der in der Lage ist, ein erstes Licht mit einem ersten Photolumineszenzspektrum zu emittieren,
der erste Wirt m1 Wirte umfasst, wobei m1 eine ganze Zahl von 1 oder mehr ist und, wenn m1 2 oder mehr ist, sich die zwei oder mehr Wirte, die in der ersten Emissionsschicht(151-EM) vorhanden sind, jeweils vom anderen unterscheiden,
die zweite Emissionsschicht (152-EM) einen zweiten Wirt und einen zweiten Dotierstoff umfasst, der in der Lage ist, ein zweites Licht mit einem zweiten Photolumineszenzspektrum zu emittieren,
der zweite Wirt m2 Wirte umfasst, wobei m2 eine ganze Zahl von 1 oder mehr ist und, wenn m2 2 oder mehr ist, sich die zwei oder mehr Wirte, die in der zweiten Emissionsschicht(152-EM) vorhanden sind, jeweils vom anderen unterscheiden,
der erste Dotierstoff ein erstes Übergangsmetall umfasst und der zweite Dotierstoff ein zweites Übergangsmetall umfasst,
wobei sich der erste Dotierstoff und der zweite Dotierstoff voneinander unterscheiden und
**dadurch gekennzeichnet, dass**
Ausdruck 1 und Ausdruck 2 erfüllt sind: $PDM \left(D1\right) < PDM \left(D2\right)$ Ausdruck 1 $PDM \left(H1\right) > PDM \left(H2\right) ,$ Ausdruck 2
wobei in den Ausdrücken 1 und 2
PDM(D1) ein permanentes Dipolmoment des ersten Dotierstoffs ist und eine Einheit von Debye aufweist,
PDM(D2) ein permanentes Dipolmoment des zweiten Dotierstoffs ist und eine Einheit von Debye aufweist,
PDM(H1) ${\sum }_{x = 1}^{m 1} PDM \left(Hx\right) ⋅ W \left(Hx\right)$ ist, welches ein permanenter Dipolmomentmittelwert der m1 Wirte ist, die in dem ersten Wirt vorhanden sind, und eine Einheit von Debye aufweist, wobei i) x eine Variable von 1 bis m1 ist, ii) PDM(Hx) ein permanenter Dipolmoment eines x. Wirtes in der ersten Emissionsschicht ist und eine Einheit von Debye aufweist und iii) W(Hx) ein Gewichtsanteil des x. Wirtes relativ zu einem Gesamtgewicht des ersten Wirtes ist und als (ein Gewicht des x. Wirtes in der ersten Emissionsschicht / ein Gesamtgewicht des ersten Wirtes) berechnet wird,
PDM(H2) ${\sum }_{y = 1}^{m 2} PDM \left(Hy\right) ⋅ W \left(Hy\right)$ ist, welches ein permanenter Dipolmomentmittelwert der m2 Wirte ist, die in dem zweiten Wirt vorhanden sind, und eine Einheit von Debye aufweist, wobei i) y eine Variable von 1 bis m2 ist, ii) PDM(Hy) ein permanenter Dipolmoment eines y. Wirtes in der zweiten Emissionsschicht ist und eine Einheit von Debye aufweist und iii) W(Hy) ein Gewichtsanteil des y. Wirtes relativ zu einem Gesamtgewicht des zweiten Wirtes ist und als (ein Gewicht des y. Wirtes in der zweiten Emissionsschicht / ein Gesamtgewicht des zweiten Wirtes) berechnet wird, und
jedes von PDM(D1), PDM(D2), PDM(Hx) und PDM(Hy) basierend auf der Dichtefunktionaltheorie (DFT) berechnet wird.

2. Lichtemittierende Vorrichtung nach Anspruch 1, wobei |PDM(D1) - PDM(D2)| 1,0 Debye bis 9,0 Debye ist; und/oder
wobei |PDM(H1) - PDM(H2)| 0,01 Debye bis 3,99 Debye ist.

3. Lichtemittierende Vorrichtung nach Anspruch 1 oder 2, wobei ferner Ausdruck 3 erfüllt ist: $FWHM \left(D1\right) > FWHM \left(D2\right) ,$ Ausdruck 3 wobei in Ausdruck 3
FWHM(D1) eine Halbwertsbreite bei der maximalen Emissionsspitzenwellenlänge des ersten Photolumineszenzspektrums des ersten Dotierstoffs ist und eine Einheit von Nanometern aufweist,
FWHM(D2) eine Halbwertsbreite bei der maximalen Emissionsspitzenwellenlänge des zweiten Photolumineszenzspektrums des zweiten Dotierstoffs ist und eine Einheit von Nanometern aufweist,
das erste Photolumineszenzspektrum relativ zu einem ersten Film bewertet wird, der den ersten Dotierstoff enthält, und
das zweite Photolumineszenzspektrum relativ zu einem zweiten Film bewertet wird, der den zweiten Dotierstoff enthält.

4. Lichtemittierende Vorrichtung nach einem der Ansprüche 1-3, wobei ferner Ausdruck 4 erfüllt ist: ${D}_{st} \left(D1\right) < {D}_{st} \left(D2\right) ,$ Ausdruck 4 wobei in Ausdruck 4
Dₛₜ(D1) |S₁(D1) - T₁(D1)| ist,
Dₛₜ(D2) |S₁(D2) - T₁(D2)| ist,
S₁(D1) Singulett-Energie des ersten Dotierstoffs ist und eine Einheit von eV aufweist,
T₁(D1) Triplett-Energie des ersten Dotierstoffs ist und eine Einheit von eV aufweist,
S₁(D2) Singulett-Energie des zweiten Dotierstoffs ist und eine Einheit von eV aufweist,
T₁(D2) Triplett-Energie des zweiten Dotierstoffs ist und eine Einheit von eV aufweist und
jedes von S₁(D1), T₁(D1), S₁(D2) und T₁(D2) basierend auf DFT berechnet wird.

5. Lichtemittierende Vorrichtung nach einem der Ansprüche 1-4, wobei |λmax(1) - λmax(2)| 0 nm bis 30 nm ist,
λmax(1) eine maximale Emissionsspitzenwellenlänge des ersten Photolumineszenzspektrums ist und eine Einheit von Nanometern aufweist und
λmax(2) eine maximale Emissionsspitzenwellenlänge des zweiten Photolumineszenzspektrums ist und eine Einheit von Nanometern aufweist.

6. Lichtemittierende Vorrichtung nach einem der Ansprüche 1-5, wobei
i) jedes von λmax(1) und λmax(2) 510 nm bis 540 nm ist; oder
ii) jedes von λmax(1) und λmax(2) 540 nm bis 570 nm ist,
λmax(1) eine maximale Emissionsspitzenwellenlänge des ersten Photolumineszenzspektrums ist und eine Einheit von nm aufweist und
λmax(2) eine maximale Emissionsspitzenwellenlänge des zweiten Photolumineszenzspektrums ist und eine Einheit von nm aufweist.

7. Lichtemittierende Vorrichtung nach einem der Ansprüche 1-6, wobei
i) λmax(1) 510 nm bis 540 nm ist und λmax(2) 540 nm bis 570 nm ist; oder
ii) λmax(1) 540 nm bis 570 nm ist und λmax(2) 510 nm bis 540 nm ist,
λmax(1) eine maximale Emissionsspitzenwellenlänge des ersten Photolumineszenzspektrums ist und eine Einheit von nm aufweist und
λmax(2) eine maximale Emissionsspitzenwellenlänge des zweiten Photolumineszenzspektrums ist und eine Einheit von nm aufweist.

8. Lichtemittierende Vorrichtung nach einem der Ansprüche 1-7, wobei das erste Licht und das zweite Licht grünes Licht ist; und/oder
wobei die erste Emissionsschicht und die zweite Emissionsschicht grünes Licht emittieren; und/oder
wobei eine Oberfläche der ersten Emissionsschicht und eine Oberfläche der zweiten Emissionsschicht in direktem Kontakt stehen.

9. Lichtemittierende Vorrichtung nach einem der Ansprüche 1-8, wobei die erste Emissionsschicht (151-EM) zwischen der zweiten Emissionsschicht (152-EM) und der zweiten Elektrode (190) angeordnet ist oder
wobei die zweite Emissionsschicht (152-EM) zwischen der ersten Emissionsschicht (151-EM) und der zweiten Elektrode (190) angeordnet ist.

10. Lichtemittierende Vorrichtung nach einem der Ansprüche 1-9, wobei das erste Übergangsmetall Platin ist und das zweite Übergangsmetall Iridium ist.

11. Lichtemittierende Vorrichtung nach einem der Ansprüche 1-10, wobei die Zwischenschicht Folgendes umfasst:
m lichtemittierende Einheiten, die jeweils mindestens eine Emissionsschicht umfassen; und
m-1 Ladungserzeugungsschichten, die zwischen zwei benachbarten lichtemittierenden Einheiten unter den m lichtemittierenden Einheiten angeordnet sind,
wobei m eine ganze Zahl von 2 oder mehr ist,
i) eine erste lichtemittierende Einheit unter den m lichtemittierenden Einheiten die erste Emissionsschicht (151-EM) umfasst
und eine zweite lichtemittierende Einheit unter den m lichtemittierenden Einheiten die zweite Emissionsschicht (152-EM) umfasst oder
ii) eine lichtemittierende Einheit unter den m lichtemittierenden Einheiten sowohl die erste Emissionsschicht (151-EM) als auch die zweite Emissionsschicht (152-EM) umfasst.

12. Lichtemittierende Vorrichtung nach Anspruch 11, wobei eine lichtemittierende Einheit unter den m lichtemittierenden Einheiten sowohl die erste Emissionsschicht (151-EM) als auch die zweite Emissionsschicht (152-EM) umfasst und
die eine lichtemittierende Einheit, die sowohl die erste Emissionsschicht (151-EM) als auch die zweite Emissionsschicht (152-EM) umfasst, grünes Licht emittiert.

13. Lichtemittierende Vorrichtung nach Anspruch 12, wobei die erste Emissionsschicht (151-EM) zwischen der zweiten Emissionsschicht (152-EM) und der zweiten Elektrode (190) angeordnet ist; oder
wobei die zweite Emissionsschicht (152-EM) zwischen der ersten Emissionsschicht (151-EM) und der zweiten Elektrode (190) angeordnet ist.

14. Lichtemittierende Vorrichtung nach einem der Ansprüche 11-13, wobei mindestens eine lichtemittierende Einheit unter den m lichtemittierenden Einheiten blaues Licht emittiert.

15. Elektronische Einrichtung, umfassend die lichtemittierende Vorrichtung nach einem der Ansprüche 1-14.

## Revendications

1. Dispositif électroluminescent (100, 101), comprenant :
une première électrode (110) ;
une seconde électrode (190) faisant face à la première électrode (110) ; et
une couche intermédiaire (150) agencée entre la première électrode (110) et la seconde électrode (190),
dans lequel la couche intermédiaire (150) comprend une première couche d'émission (151-EM) et une seconde couche d'émission (152-EM),
la première couche d'émission (151-EM) comprend un premier hôte et un premier dopant capable d'émettre une première lumière présentant un premier spectre de photoluminescence,
le premier hôte comprend m1 hôtes, où m1 est un entier supérieur ou égal à 1, et lorsque m1 est supérieur ou égal à 2, les deux hôtes ou plus présents dans la première couche d'émission (151-EM) sont chacun différents les uns des autres,
la seconde couche d'émission (152-EM) comprend un second hôte et un second dopant capable d'émettre une seconde lumière présentant un second spectre de photoluminescence,
le second hôte comprend m2 hôtes, où m2 est un entier supérieur ou égal à 1, et lorsque m2 est supérieur ou égal à 2, les deux hôtes ou plus présents dans la seconde couche d'émission (152-EM) sont chacun différents les uns des autres,
le premier dopant comprend un premier métal de transition, et le second dopant comprend un second métal de transition,
dans lequel le premier dopant et le second dopant sont différents l'un de l'autre, et
**caractérisé en ce que**
l'Expression 1 et l'Expression 2 sont satisfaites : $PDM \left(D1\right) < PDM \left(D2\right)$ Expression 1 $PDM \left(H1\right) > PDM \left(H2\right)$ Expression 2
dans lequel, dans les Expressions 1 et 2,
PDM(D1) est un moment dipolaire permanent du premier dopant et est exprimé en debye,
PDM(D2) est un moment dipolaire permanent du second dopant et est exprimé en debye,
PDM(H1) est ${\sum }_{x = 1}^{m 1} PDM \left(Hx\right) ⋅ W \left(Hx\right)$ qui est une valeur moyenne du moment dipolaire permanent des m1 hôtes présents dans le premier hôte, et est exprimée en debye, où i) x est une variable de 1 à m1, ii) PDM(Hx) est un moment dipolaire permanent d'un x^{ième} hôte dans la première couche d'émission et est exprimé en debye, et iii) W(Hx) est une fraction pondérale du x^{ième} hôte par rapport à un poids total du premier hôte, et est calculée comme (un poids du x^{ième} hôte dans la première couche d'émission/un poids total du premier hôte),
PDM(H2) est ${\sum }_{y = 1}^{m 2} PDM \left(Hy\right) ⋅ W \left(Hy\right)$ qui est une valeur moyenne du moment dipolaire permanent des m2 hôtes présents dans le second hôte, et est exprimée en debye, où i) y est une variable de 1 à m2, ii) PDM(Hy) est un moment dipolaire permanent d'un y^{ième} hôte dans la seconde couche d'émission et est exprimé en debye, et iii) W(Hy) est une fraction pondérale du y^{ième} hôte par rapport à un poids total du second hôte, et est calculée comme (un poids du y^{ième} hôte dans la seconde couche d'émission/un poids total du second hôte), et
chacun de PDM(D1), PDM(D2), PDM(Hx) et PDM(Hy) est calculé sur la base de la théorie de la fonctionnelle de la densité (DFT).

2. Dispositif électroluminescent de la revendication 1, dans lequel |PDM(D1) - PDM(D2)| est de 1,0 debye à 9,0 debye ; et/ou
dans lequel |PDM(H1) - PDM(H2)| est de 0,01 debye à 3,99 debye.

3. Dispositif électroluminescent des revendications 1 ou 2, dans lequel l'Expression 3 est en outre satisfaite : $FWHM \left(D1\right) > FWHM \left(D2\right)$ Expression 3 dans lequel, dans l'Expression 3,
FWHM(D1) est une largeur à mi-hauteur à la longueur d'onde du pic d'émission maximal du premier spectre de photoluminescence du premier dopant et est exprimée en nanomètres,
FWHM(D2) est une largeur à mi-hauteur à la longueur d'onde du pic d'émission maximal du second spectre de photoluminescence du second dopant et est exprimée en nanomètres,
le premier spectre de photoluminescence est évalué par rapport à un premier film comprenant le premier dopant, et
le second spectre de photoluminescence est évalué par rapport à un second film comprenant le second dopant.

4. Dispositif électroluminescent de l'une quelconque des revendications 1 ou 3, dans lequel l'Expression 4 est en outre satisfaite : ${D}_{st} \left(D1\right) < {D}_{st} \left(D2\right)$ Expression 4 dans lequel, dans l'Expression 4,
Dₛₜ(D1) est |S₁(D1) - T₁(D1)|
Dₛₜ(D2) est |S₁(D2) - T₁(D2)|
S₁(D1) est l'énergie de singulet du premier dopant et est exprimée en eV,
T₁(D1) est l'énergie de triplet du premier dopant et est exprimée en eV,
S₁(D2) est l'énergie de singulet du second dopant et est exprimée en eV,
T₁(D2) est l'énergie de triplet du second dopant et est exprimée en eV, et
chacune de S₁(D1), T₁(D1), S₁(D2) et T₁(D2) est calculée sur la base de la DFT.

5. Dispositif électroluminescent de l'une quelconque des revendications 1 à 4, dans lequel |λmax(1) - λmax(2)| est de 0 nm à 30 nm,
λmax(1) est une longueur d'onde du pic d'émission maximal du premier spectre de photoluminescence et est exprimée en nanomètres, et
λmax(2) est une longueur d'onde du pic d'émission maximal du second spectre de photoluminescence et est exprimée en nanomètres.

6. Dispositif électroluminescent de l'une quelconque des revendications 1 à 5, dans lequel
i) chacune de λmax(1) et λmax(2) est de 510 nm à 540 nm ; ou
ii) chacune de λmax(1) et λmax(2) est de 540 nm à 570 nm,
λmax(1) est une longueur d'onde du pic d'émission maximal du premier spectre de photoluminescence et est exprimée en nm, et
λmax(2) est une longueur d'onde du pic d'émission maximal du second spectre de photoluminescence et est exprimée en nm.

7. Dispositif électroluminescent de l'une quelconque des revendications 1 à 6, dans lequel
i) λmax(1) est de 510 nm à 540 nm, et λmax(2) est de 540 nm à 570 nm ; ou
ii) λmax(1) est de 540 nm à 570 nm et λmax(2) est de 510 nm à 540 nm,
λmax(1) est une longueur d'onde du pic d'émission maximal du premier spectre de photoluminescence et est exprimée en nm, et
λmax(2) est une longueur d'onde du pic d'émission maximal du second spectre de photoluminescence et est exprimée en nm.

8. Dispositif électroluminescent de l'une quelconque des revendications 1 à 7, dans lequel la première lumière et la seconde lumière sont une lumière verte ; et/ou
dans lequel la première couche d'émission et la seconde couche d'émission émettent une lumière verte ; et/ou
dans lequel une surface de la première couche d'émission et une surface de la seconde couche d'émission sont en contact direct.

9. Dispositif électroluminescent de l'une quelconque des revendications 1 à 8, dans lequel la première couche d'émission (151-EM) est agencée entre la seconde couche d'émission (152-EM) et la seconde électrode (190), ou
dans lequel la seconde couche d'émission (152-EM) est agencée entre la première couche d'émission (151-EM) et la seconde électrode (190).

10. Dispositif électroluminescent de l'une quelconque des revendications 1 à 9, dans lequel le premier métal de transition est le platine, et le second métal de transition est l'iridium.

11. Dispositif électroluminescent de l'une quelconque des revendications 1 à 10, dans lequel la couche intermédiaire comprend :
m unités électroluminescentes, chacune comprenant au moins une couche d'émission ; et
m-1 couches de génération de charge agencées entre deux unités électroluminescentes adjacentes parmi les m unités électroluminescentes,
m est un entier supérieur ou égal à 2,
i) une première unité électroluminescente parmi les m unités électroluminescentes comprend la première couche d'émission (151-EM), et une seconde unité électroluminescente parmi les m unités électroluminescentes comprend la seconde couche d'émission (152-EM), ou
ii) une unité électroluminescente parmi les m unités électroluminescentes comprend à la fois la première couche d'émission (151-EM) et la seconde couche d'émission (152-EM).

12. Dispositif électroluminescent de la revendication 11, dans lequel une unité électroluminescente parmi les m unités électroluminescentes comprend à la fois la première couche d'émission (151-EM) et la seconde couche d'émission (152-EM), et
l'unité électroluminescente comprenant à la fois la première couche d'émission (151-EM) et la seconde couche d'émission (152-EM) émet une lumière verte.

13. Dispositif électroluminescent de la revendication 12, dans lequel la première couche d'émission (151-EM) est agencée entre la seconde couche d'émission (152-EM) et la seconde électrode (190) ; ou
dans lequel la seconde couche d'émission (152-EM) est agencée entre la première couche d'émission (151-EM) et la seconde électrode (190).

14. Dispositif électroluminescent de l'une quelconque des revendications 11 à 13, dans lequel au moins une unité électroluminescente parmi les m unités électroluminescentes émet une lumière bleue.

15. Appareil électronique, comprenant le dispositif électroluminescent de l'une quelconque des revendications 1 à 14.
